(19) Europäisches Patentamt
European Patent Office
Office européen des brevets

(11) EP 2 009 498 B1

(12) **EUROPEAN PATENT SPECIFICATION**

(45) Date of publication and mention of the grant of the patent:
**28.03.2012 Bulletin 2012/13**

(51) Int Cl.:
*G03F 7/039* *(2006.01)* *G03F 7/004* *(2006.01)*
*G03F 7/075* *(2006.01)* *G03F 7/20* *(2006.01)*

(21) Application number: **08011701.3**

(22) Date of filing: **27.06.2008**

(54) **Pattern forming method**

Strukturbildungsverfahren

Procédé de formation d'un motif

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **29.06.2007 JP 2007172414**

(43) Date of publication of application:
**31.12.2008 Bulletin 2009/01**

(73) Proprietor: **FUJIFILM Corporation**
**Minato-ku**
**Tokyo (JP)**

(72) Inventors:
- **Tarutani, Shinji**
  **Shizuoka (JP)**
- **Tsubaki, Hideaki**
  **Shizuoka (JP)**
- **Wada, Kenji**
  **Shizuoka (JP)**

(74) Representative: **HOFFMANN EITLE**
**Patent- und Rechtsanwälte**
**Arabellastraße 4**
**81925 München (DE)**

(56) References cited:
**EP-A- 1 760 528** **EP-A- 1 795 961**
**WO-A-2008/093856** **US-A- 4 402 571**

- **JUN ZHU, PENG WU, QIANG WU, HUA DING, XIN LI, AND CHANGJIANG SUN: "A study of double exposure process design with balanced performance parameters for line/space applications" PROCEEDINGS OF SPIE, vol. 6520, 27 March 2007 (2007-03-27), pages 6520H-1-65202H-11, XP002497690**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 009 498 B1

## Description

## Background of the Invention

1. Field of the Invention

The present invention relates to a pattern forming method, particularly, a pattern forming method for use in the production process of a semiconductor such as IC, in the production of a circuit substrate of liquid crystal, thermal head or the like, and in other photofabrication processes. More specifically, the present invention relates to a method for forming a pattern through KrF or ArF exposure by using a positive resist.

2. Description of the Related Art

A chemical amplification resist composition is a pattern forming material capable of forming a pattern on a substrate by producing an acid in the exposed area upon irradiation with actinic rays or radiation such as far ultraviolet light and through a reaction using this acid as a catalyst, changing the solubility in a developer between the area irradiated with actinic rays or radiation and the non-irradiated area.
In recent years, with the progress of fine design dimension of a semiconductor device, a Technique of immersion exposure using an ArF excimer laser as the light source has been developed. Use of this technique is considered to enable the formation of a pattern for a semiconductor device up to a design dimension of 45 nm generation.
The generation next to the design dimension of 45 nm is a 32 nm generation. The pattern for a semiconductor device of 32 nm generation is difficult to form by conventional techniques, and a special pattern forming method using an ArF immersion exposure machine is being taken notice of.
Several methods have been proposed regarding this special pattern forming method, and one of these methods is a double exposure process.
The double exposure process is a method of applying exposure twice on the same photoresist film as described in Digest of Papers, Micro Process' 94, pp. 4-5, where the pattern in the exposure field is divided into two pattern groups and the exposure is preformed in twice for respective divided pattern groups.
Also, JP-A-2002-75857 (the term "JP-A" as used herein means an "unexamined published Japanese patent application") indicates that it is indispensable in this method to have, like a two-photon absorption resist, a property of the photosensitivity or solubility in a developer being changed in proportion to the square of exposure intensity, but a resist having
WO-A-2008/093856, which is prior art under Article 54(3) EPC, discloses a pattern-forming method in which a resist film is subjected to immersion double exposure and development, the resist film comprising a photo-acid generator, a resin whose alkali-solubility increases in the presence of an acid, and a hydrophobic resin.
US-A-4 402 571 discloses a method for producing a surface relief pattern on a photosensitive material comprising exposing the material in a first position to a laser interference pattern and subsequently exposing the material in a second position to a laser interference pattern, the second position being a rotation of the material or the laser interference pattern about an axis perpendicular to the material's surface from the first position.

## Summary of the Invention

An object of the present invention is to provide a pattern forming method using a positive resist composition suitable for multiple exposures, ensuring that in the multiple exposure process of performing exposure a plurality of times on the same resist film, the pattern is reduced in the film loss.
The invention is as follows.

1. A method for forming a resist pattern comprising exposing a positive resist film to actinic rays or radiation a plurality of times;
wherein the contact angle formed by a water droplet on the surface of the resist film prior to exposure is at least 75° when measured at 23°C; and
wherein the resist film comprises:

    (i) a surface layer comprising a hydrophobic resin (HR), the hydrophobic resin comprising at least one of a fluorine atom and a silicon atom, and
    (ii) at least 5 mass%, based on the total solid content of the resist film, of a compound (A) which is capable of generating an acid upon irradiation with actinic rays or radiation.

2. A method according to Claim 1, wherein the resist film further comprises a resin (B) whose solubility in an alkali developer increases under the action of an acid, the resin having a repeating unit represented by the following formula (pA) :

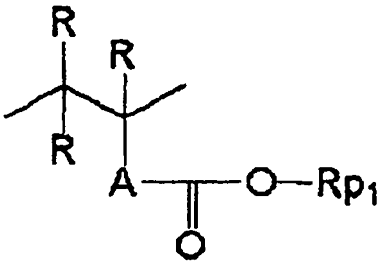

(pA)

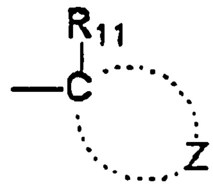

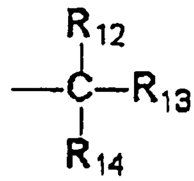

(pI) (pII)

wherein each R independently represents a hydrogen atom, a halogen atom or an alkyl group; A represents a single bond; $Rp_1$ is a group represented by formula (pI) or formula (pII); $R_{11}$ represents a methyl group, an ethyl group, an n-propyl group, an isopropyl group, an n-butyl group, an isobutyl group or a sec-butyl group; Z represents an atomic group necessary for forming a cycloalkyl group together with the carbon atom; and $R_{12}$ to $R_{14}$ each independently represents an alkyl group or a cycloalkyl group, provided that at least one of $R_{12}$ to $R_{14}$ represents a cycloalkyl group.

3. A method according to 1, wherein the resist film comprises a sulfonium salt of at least one of a fluorine-substituted alkanesulfonic acid, a fluorine-substituted benzenesulfonic acid, a fluorine-substituted imide acid and a fluorine-substituted methide acid as compound (A).

4. A method according to 2, wherein the resin (B) further contains a repeating unit having a lactone structure.

5. A method according to 2, wherein the resin (B) further contains a repeating unit having a hydroxyl group or a cyano group.

6. A method according to 2, wherein the resin (B) further contains a repeating unit having a lactone structure and a repeating unit having a hydroxyl group.

7. A method according to 1, wherein the resist film further comprises a basic compound and at least one of a fluorine-containing surfactant and a silicon-containing surfactant.

8. A method according to 7, wherein the basic compound is at least one of a compound having an imidazole structure, a diazabicyclo structure, an onium hydroxide structure, an onium carboxylate structure, a trialkylamine structure, an aniline structure or a pyridine structure; an alkylamine derivative having at least one of a hydroxyl group and an ether bond; and an aniline derivative having at least one of a hydroxyl group and an ether bond.

9. A method according to 1, wherein the hydrophobic resin (HR) has a fluorine atom-containing alkyl group, a fluorine atom-containing cycloalkyl group or a fluorine atom-containing aryl group.

10. A method according to 9, wherein the fluorine atom-containing alkyl group, the fluorine atom-containing cycloalkyl group or the fluorine atom-containing aryl group is a group represented by any one of formulae (f1) to (f3):

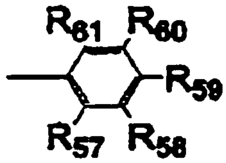

(f1)

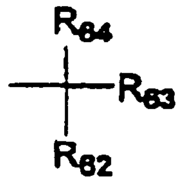

(f2)

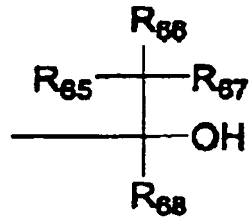

(f3)

wherein $R_{57}$ to $R_{68}$ each independently represents a hydrogen atom, a fluorine atom or an alkyl group, provided that at least one of $R_{57}$ to $R_{61}$, at least one of $R_{62}$ to $R_{64}$ and at least one of $R_{65}$ to $R_{68}$ is a fluorine atom or an alkyl group having at least one hydrogen atom being substituted by a fluorine atom.

11. A method according to 1, wherein the hydrophobic resin (HR) has an alkylsilyl structure or a cyclic siloxane structure.

12. A method according to Claim 11, wherein the alkylsilyl structure or the cyclic siloxane structure is a group represented by any one of formulae (CS-1) to (CS-3):

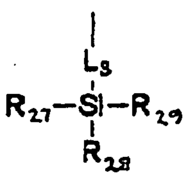

(CS-1)

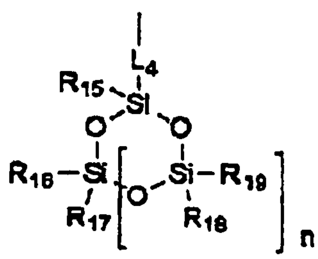

(CS-2)

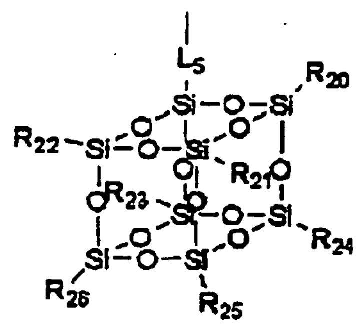

(CS-3)

wherein $R_{15}$ to $R_{29}$ each independently represents a linear or branched alkyl group or a cycloalkyl group; $L_3$ to $L_5$ each independently represents a single bond or a divalent linking group; and n represents an integer of 1 to 5.

13. A method according to 1, wherein the resist film is subjected to immersion exposure.

14. A method according to 1, wherein the resist film is subjected to double exposure.

**Brief Description of the Drawings**

Fig. 1 represents a schematic diagram showing the contact angle by a θ/2 methods; and
Fig. 2 represents a schematic view showing the state of double exposure process in the present invention.

**Detailed Description of the Invention**

The best mode for carrying out the present invention is described below.
Incidentally, in the present invention, when a group (atomic group) is denoted without specifying whether

substituted or unsubstituted, the group includes both a group having no substituent and a group having a substituent. For example, an "alkyle group" includes not only an alkyl group having no substituent (unsubstituted alkyl group) but also an alkyl group having a substituent (substituted alkyl group).

<Resist Film>

In the present invention, in order to solve the problem of film loss in a multiple exposure process of performing exposure a plurality of times on the same resist film, a resist film having a contact angle for water of 75° or more is used.

That is, when a resist composition is coated on a substrate directly or after providing an antireflection film and then dried, the contact angle for water of the resist film formed is 75° or more. The measurement temperature is 23°C.

It has been found that when the contact angle is set to 75° or more, at the time of forming a pattern by double exposure, the resist pattern can be reduced in the film loss.

The contact angle of the resist film is preferably from 75 to 100°, more preferably from 75 to 90°.

If the contact angle is too high, the developer can hardly contact with the resist film at the development and the number of pattern defects due to a development failure may increase.

As for the measuring method of the contact angle, a θ/2 method is know More specifically, a liquid droplet landed on a solid takes a rounded shape due to its own surface tension and forms a part of a sphere shown in Fig. 1. By photographing the shape at this time, the radius (r) and height (h) of the droplet are determined from right and left end points and peak position of the droplet. The values obtained are assigned in the following formula, whereby the contact angle θ can be calculated.

$$\tan \theta_1 = h/r$$

Here, when the droplet forms a part of a sphere, according to the geometric theorem,

$$\theta_1 = \theta/2.$$

At present, there is commercially available an automatic contact angle meter where the shape of a droplet formed when a liquid droplet is landed on a solid surface is photographed by a CCD camera or the like and the contact angle θ (static contact angle) is calculated by automatically analyzing the radius r and height h of the droplet through image processing.

For adjusting the contact angle of the resist film to 75° or more, a hydrophobic resin (HR) is used. The hydrophobic resin (HR) is contained in a surface layer of the resist film, whereby the contact angle can be easily made to be 75° or more.

The hydrophobic resin (HR) comprises at least one of a fluorine atom and a silicon atom.

The amount of the hydrophobic resin (HP) added may be appropriately adjusted to give a resist film having a contact angle in the range above but is preferably from 0.1 to 10 mass%, more preferably from 0.1 to 5 mass%, based on the entire solid content of the resist composition. (In this specification, mass ratio is equal to weight ratio.)

The hydrophobic resin (HR) is, unevenly distributed in the interface but unlike a surfactant need not necessarily have a hydrophilic group in the molecule and may not contribute to uniform mixing of polar/nonpolar substances.

The components which are contained in the resist composition are described below.

<(A) Compound capable of generating an acid upon irradiation with actinic rays or radiation>

The positive resist composition of the present invention contains a compound capable of generating an acid upon irradiation with actinic rays or radiation (hereinafter sometimes referred to as an "acid generator").

The acid generator which can be used may be appropriately selected from a photoinitiator for photocationic polymerization, a photoinitiator for photoradical polymerization, a photo-decoloring agent for coloring matters, a photo-discoloring agent, a compound known to generate an acid upon irradiation with actinic rays or radiation and used for microresist or the like, and a mixture thereof.

Examples thereof include a diazonium salt, a phosphonium salt, a sulfonium salt, an iodonium salt, imidosulfonate, oxime sulfonate, diazodisulfone, disulfone and o-nitrobenryl sulfonate.

Also, a compound where such a group or compound capable of generating an acid upon irradiation with actinic rays or radiation is introduced into the main or side chain of the polymer, for example, compounds described in U.S. Patent 3,849,137, German Patent 3,914,407, JP-A-63-26653, JP-A-55-164824, JP-A-62-69263, JP-A-63-146038, JF-A-63-163452, JP-A-62-153853 and JP-A-63-146029, may be used.

Furthermore, compounds capable of generating an acid by the effect of light described, for example, in U.S. Patent 3,779,778 and European Patent 126,712 may also be used.

Out of the acid generators, the compounds represented by the following formulae (ZI), (ZII) and (ZIII) are preferred.

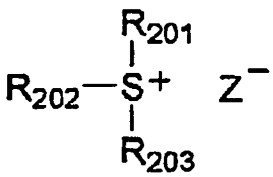

ZI

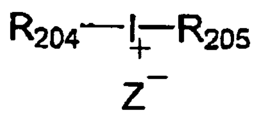

ZII

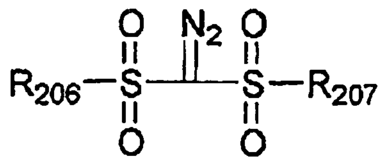

ZIII

In formula (ZI), $R_{201}$, $R_{202}$ and $R_{203}$ each independently represents an organic group.

The carbon number of the organic group as $R_{201}$, $R_{202}$ and $R_{203}$ is generally from 1 to 30, preferably from 1 to 20.

Two members out of $R_{201}$ to $R_{203}$ may combine to form a ring structure, and the ring may, contain an oxygen atom, a sulfur atom, an ester bond, an amide bond or a carbonyl group. Examples of the group formed by combining two members out of $R_{201}$ to $R_{203}$ include an alkylene group (e.g., butylene, pentylene).

$Z^-$ represents a non-nucleophilic anion.

Examples of the non-nucleophilic anion as $Z^-$ include sulfonate anion, carboxylate anion, sulfonylimide anion, bis(alkylsulfonyl)imide anion and tris(alkylsulfonyl)methyl anion.

The non-nucleophilic anion is an anion having an extremely low ability of causing a nucleophilic reaction and this anion can suppress the decomposition with aging due to an intramolecular nucleophilic reaction. By virtue of this anion, the aging stability of the resist is enhanced.

Examples of the sulfonate anion include aliphatic sulfonate anion, aromatic sulfonate anion and camphorsulfonate anion.

Examples of the carboxylate anion include aliphatic carboxylate anion, aromatic carboxylate anion and aralkylcarboxylate anion.

The aliphatic moiety in the aliphatic sulfonate anion may be an alkyl group or a cycloalkyl group but is preferably an alkyl group having a carbon number of 1 to 30 or a cycloalkyl group having a carbon number of 3 to 30, and examples thereof include a methyl group, an ethyl group, a propyl group, an isopropyl group, an n-butyl group, an isobutyl group, a sec-butyl group, a pentyl group, a neopentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, an eicosyl group, a cyclopropyl group, a cyclopentyl group, a cyclohexyl group, an adamantyl group, a norbornyl group and a boronyl group.

The aromatic group in the aromatic sulfonate anion is preferably an aryl group having a carbon number of 6 to 14, and examples thereof include a phenyl group, a tolyl group and a naphthyl group.

The alkyl group, cycloalkyl group and aryl group in the aliphatic sulfonate anion and aromatic sulfonate anion each may have a substituent. Examples of the substituent for the alkyl group, cycloalkyl group and aryl group in the aliphatic sulfonate anion and aromatic sulfonate anion include a nitro group, a halogen atom (e.g., fluorine, chlorine, bromine, iodine), a carboxyl group, a hydroxyl group, an amino group, a cyano group, an alkoxy group (preferably having a carbon number of 1 to 15), a cycloalkyl group (preferably having a carbon number of 3 to 15), an aryl group (preferably having a carbon number of 6 to 14), an alkoxycarbonyl group (preferably having a carbon number of 2 to 7), an acyl group (preferably having a carbon number of 2 to 12), an alkoxycarbonyloxy group (preferably having a carbon number of 2 to 7), an alkylthio group (preferably having a carbon number of 1 to 15), an alkylsulfonyl group (preferably having a carbon number of 1 to 15), an alkyliminosulfonyl group (preferably having a carbon number of 2 to 15), an aryloxysulfonyl group (preferably having a carbon number of 6 to 20), an alkylaryloxysulfonyl group (preferably having a carbon number of 7 to 20), a cycloalkylaryloxysulfonyl group (preferably having a carbon number of 10 to 20), an alkyloxyalkyloxy group (preferably having a carbon number of 5 to 20) and a cycloalkylakyloxyalkyloxy group (preferably having a carbon number of 8 to 20). As for the aryl group or ring structure in each group, examples of the substituent further include an alkyl group (preferably having a carbon number of 1 to 15).

Examples of the aliphatic moiety in the aliphatic carboxylate anion include the same alkyl group and cycloalkyl group as those in the aliphatic sulfonate anion.

Examples of the aromatic group in the aromatic carboxylate anion include the same aryl group as those in the aromatic sulfonate anion.

The aralkyl group in the aralkylcarboxylate anion is preferably an aralkyl group having a carbon number of 6

to 12, and examples thereof include a benzyl group, a phenethyl group, a naphthylmethyl group, a naphthylethyl group and a naphthylmethyl group.

The alkyl group, cycloalkyl group, aryl group and aralkyl group in the aliphatic carboxylate anion, aromatic carboxylate anion and aralkylcarboxylate anion each may have a substituent Examples of the substituent for the alkyl group, cycloalkyl group, aryl group and aralkyl group in the aliphatic carboxylate anion, aromatic carboxylate anion and aralkylcarboxylate anion include the same halogen atom, alkyl group, cycloalkyl group, alkoxy group and alkylthio group as those in the aromatic sulfonate anion.

Examples of the sulfonylimide anion include saccharin anion.

The alkyl group in the bis(alkylsulfonyl)imide anion and tris(alkylsulfonyl)methyl anion is preferably an alkyl group having a carbon number of 1 to 5, and examples thereof include a methyl group, an ethyl group, a propyl group, an isopropyl group, an n-butyl group, an isobutyl group, a sec-butyl group, a pentyl group and a neopentyl group. Examples of the substituent for such an alkyl group include a halogen atom, a halogen atom-substituted alkyl group, an alkoxy group, an alkylthio group, an alkyloxysulfonyl group, an aryloxysulfonyl group and a cycloalkylaryloxysulfonyl group. Among these, an alkyl group substituted by a fluorine atom is preferred.

Other examples of the non-nucleophilic anion include fluorinated phosphorus, fluorinated boron and fluorinated antimony.

The non-nucleophilic anion of $Z^-$ is preferably an aliphatic sulfonate anion with the sulfonic acid being substituted by a fluorine atom at the $\alpha$-position, an aromatic sulfonate anion substituted by a fluorine atom or a fluorine atom-containing group, a bis(alkylsulfonyl)imide anion with the alkyl group being substituted by a fluorine atom, or a tris (alkylsulfonyl)methide anion with the alkyl group being substituted by a fluorine atom. The non-nucleophilic anion is more preferably a perfluoroaliphatic sulfonate anion having a carbon number of 4 to 8, or a benzenesulfonate anion having a fluorine atom, still more preferably nonafluorobutanesulfonate anion, perfluorooctanesulfonate anion, pentafluorobenzenesulfonate anion or 3,5-bis(trifluoromethyl)bennnesulfonate anion.

Examples of the organic group as $R_{201}$, $R_{202}$ and $R_{203}$ include the corresponding groups in the compounds (ZI-1), (ZI-2) and (ZI-3) described later.

The compound may be a compound having a plurality of structures represented by formula (ZI), for example, may be a compound having a structure where at least one of $R_{201}$ to $R_{203}$ in the compound represented by formula (ZI) is bonded to at least one of $R_{201}$ to $R_{203}$ in another compound represented by formula (ZI).

The component (ZI) is more preferably a compound (ZI-1), (ZI-2) or (ZI-3) described below.

The compound (ZI-1) is an arylsulfonium compound where at least one of $R_{201}$ to $R_{203}$ in formula (ZI) is an aryl group, that is, a compound having arylsulfonium as the cation.

In the arylsulfonium compound, $R_{201}$ to $R_{203}$ all may be an aryl group or a part of $R_{201}$ to $R_{203}$ may be an aryl group with the remaining being an alkyl group or a cycloalkyl group.

Examples of the arylsulfonium compound include a triarylsulfonium compound, a diarylalkylsulfonium compound, an aryldialkylsulfonium compound, a diarylcycloalkyl-sulfonium compound and an aryldicycloalkylsulfonium compound.

The aryl group in the arylsulfonium compound is preferably a phenyl group or a naphthyl group, more preferably a phenyl group. The aryl group may be an aryl group having a heterocyclic structure containing an oxygen atom, a nitrogen atom, a sulfur atom or the like. Examples of the aryl group having a heterocyclic structure include a pyrrole residue (a group formed by removing one hydrogen atom from pyrrole), a furan residue (a group formed by removing one hydrogen atom from furan), a thiophene residue (a group formed by removing one hydrogen atom from thiophene), an indole residue (a group formed by removing one hydrogen atom from indole), a benzofuran residue (a group formed by removing one hydrogen atom from benzofuran) and a benzothiophene residue (a group formed by removing one hydrogen atom from benzothiophene). In the case where the arylsulfonium compound has two or more aryl groups, these two or more aryl groups may be the same or different.

The alkyl group or cycloalkyl group which is present, if desired, in the arylsulfonium compound is preferably a linear or branched alkyl group having a carbon number of 1 to 15 or a cycloalkyl group having a carbon number of 3 to 15, and examples thereof include a methyl group, an ethyl group, a propyl group, an n-butyl group, a sec-butyl group, a tert-butyl group, a cyclopropyl group, a cyclobutyl group and a cyclohexyl group.

The aryl group, alkyl group and cycloalkyl group of $R_{201}$ to $R_{203}$ each may have, as the substituent, an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 14), an alkoxy group (for example, an alkoxy group having a carbon number of 1 to 15), a halogen atom, a hydroxyl group or a phenylthio group. The substituent is preferably a linear or branched alkyl group having a carbon number of 1 to 12, a cycloalkyl group having a carbon number of 3 to 12, or a linear, branched or cyclic alkoxy group having a carbon number of 1 to 12, more preferably an alkyl group having a carbon number of 1 to 4, or an alkoxy group having a carbon number of I to 4. The substituent may be substituted to any one of three members $R_{201}$ to $R_{203}$ or may be substituted to all of these three members. In the case where $R_{201}$ to $R_{203}$ are an aryl group, the substituent is preferably

substituted at the p-position of the aryl group.

The compound (ZI-2) is described below.

The compound (ZI-2) is a compound where $R_{201}$ to $R_{203}$ in formula (ZI) each independently represents an aromatic ring-free organic group. The aromatic ring as used herein includes an aromatic ring containing a heteroatom.

The aromatic ring-free organic group as $R_{201}$ to $R_{203}$ has a carbon number of generally from 1 to 30, preferably from 1 to 20.

$R_{201}$ to $R_{203}$ each independently represents preferably an alkyl group, a cycloalkyl group, an allyl group or a vinyl group, more preferably a linear or branched 2-oxoalkyl group, a 2-oxocycloalkyl group or an alkoxycarbonylmethyl group, still more preferably a linear or branched 2-oxoalkyl group.

The alkyl group or cycloalkyl group of $R_{201}$ to $R_{203}$ is preferably a linear or branched alkyl group having a carbon number of 1 to 10 (e.g., methyl, ethyl, propyl, butyl, pentyl) or a cycloalkyl group having a carbon number of 3 to 10 (e.g., cyclopentyl, cyclohexyl, norbornyl). The alkyl group is more preferably a 2-oxoalkyl group or an alkoxycarbonylmethyl group. The cycloalkyl group is more preferably a 2-oxocycloalkyl group.

The 2-oxoalkyl group may be either linear or branched and is preferably a group having >C=O at the 2-position of the above-described alkyl group.

The 2-oxocycloalkyl group is preferably a group having >C=O at the 2-position of the above-described cycloalkyl group.

The alkoxy group in the alkoxycarbonylmethyl group is preferably an alkoxy group having a carbon number of 1 to 5 (e.g., methoxy, ethoxy, propoxy, butoxy, pentoxy).

$R_{201}$ to $R_{203}$ each may be further substituted by a halogen atom, an alkoxy group (for example, an alkoxy group having a carbon number of 1 to 5), a hydroxyl group, a cyano group or a nitro group.

The compound (ZI-3) is a compound represented by the following formula (ZI-3), and this is a compound having a phenacylsulfonium salt structure.

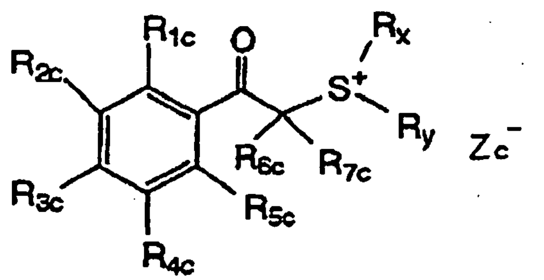

(ZI-3)

In formula (ZI-3), $R_{1c}$ to $R_{5c}$ each independently represents a hydrogen atom, an alkyl group, a cycloalkyl group, an alkoxy group or a halogen atom.

$R_{6c}$ and $R_{7c}$ each independently represents a hydrogen atom, an alkyl group or a cycloalkyl group.

$R_x$ and $R_y$ each independently represents an alkyl group, a cycloalkyl group, an allyl group or a vinyl group.

Any two or more members out of $R_{1c}$ to $R_{5c}$, a pair of $R_{6c}$ and $R_{7c}$, or a pair of $R_x$ and $R_y$ may combine with each other to form a ring structure. This ring structure may contain an oxygen atom, a sulfur atom, an ester bond or an amido bond. Examples of the group formed by combining any two or more members out of $R_{1c}$ to $R_{5c}$, a pair of $R_{6c}$ and $R_{7c}$, or a pair of $R_x$ and $R_y$ include a butylene group and a pentylene group.

$Zc^-$ represents a non-nucleophilic anion, and examples thereof are the same as those of the non-nucleophilic anion of $Z^-$ in formula (ZI).

The alkyl group as $R_{1c}$ to $R_{7c}$ may be either linear or branched and is, for example, an alkyl group having a carbon number of 1 to 20, preferably a linear or branched alkyl group having a carbon number of 1 to 12 (e.g., methyl, ethyl, linear or branched propyl, linear or branched butyl, linear or branched pentyl). The cycloalkyl group is, for example, a cycloalkyl group having a carbon number of 3 to 8 (e.g., cyclopentyl, cyclohexyl).

The alkoxy group as $R_{1c}$ to $R_{5c}$ may be linear, branched or cyclic and is, for example, an alkoxy group having a carbon number of 1 to 10, preferably a linear or branched alkoxy group having a carbon number of 1 to 5 (e.g., methoxy, ethoxy, linear or branched propoxy, linear or branched butoxy, linear or branched pentoxy), or a cyclic alkoxy group having a carbon number of 3 to 8 (e.g., cyclopentyloxy, cyclohexyloxy).

A compound where any one of $R_{1c}$ to $R_{5c}$ is a linear or branched alkyl group, a cycloalkyl group or a linear, branched or cyclic alkoxy group is preferred, and a compound where the sum of carbon numbers of $R_{1c}$ to $R_{5c}$ is from 2 to 15 is more preferred. By virtue of such a compound, the solubility in a solvent is more enhanced and production of particles during storage can be suppressed.

Examples of the alkyl group and cycloalkyl group as $R_x$ and $R_y$ are the same as those of the alkyl group and cycloalkyl group in $R_{1c}$ to $R_{7c}$. Among these, a 2-oxoalkyl group, a 2-oxocycloalkyl group and an alkoxycarbonylmethyl group are preferred.

Examples of the 2-oxoalkyl group and 2-oxocycloalkyl group include a group having >C=O at the 2-position of the alkyl group or cycloalkyl group as $R_{1c}$ to $R_{7c}$.

Examples of the alkoxy group in the alkoxycarbonylmethyl group are the same as those of the alkoxy group in $R_{1c}$ to $R_{5c}$.

$R_x$ and $R_y$ each is an alkyl or cycloalkyl group having a carbon number of preferably 4 or more, more preferably 6 or more, still more preferably 8 or more.

In formulae (ZII) and (ZIII), $R_{204}$ to $R_{207}$ each independently represents an aryl group, an alkyl group or a cycloalkyl group.

The aryl group of $R_{204}$ to $R_{207}$ is preferably a phenyl group or a naphthyl group, more preferably a phenyl group. The aryl group of $R_{204}$ and $R_{207}$ may be an aryl group having a heterocyclic structure containing an oxygen atom, a nitrogen atom, a sulfur atom or the like. Examples of the aryl group having a heterocyclic structure include a pyrrole residue (a group formed by removing one hydrogen atom from pyrrole), a furan residue (a group formed by removing one hydrogen atom from furan), a thiophene residue (a group formed by removing one hydrogen atom from thiophene), an indole residue (a group formed by removing one hydrogen atom from indole), a benzofuran residue (a group formed by removing one hydrogen atom from benzofuran) and a benzothiophene residue (a group formed by removing one hydrogen atom from benzothiophene).

The alkyl group or cycloalkyl group in $R_{204}$ to $R_{207}$ is preferably a linear or branched alkyl group having a carbon number of 1 to 10 (e.g., methyl, ethyl, propyl, butyl, pentyl) or a cycloalkyl group having a carbon number of 3 to 10 (e.g., cyclopentyl, cyclohexyl, norbornyl).

The aryl group, alkyl group and cycloalkyl group of $R_{204}$ to $R_{207}$ each may have a substituent. Examples of the substituent which the aryl group, alkyl group and cycloalkyl group of $R_{204}$ to $R_{207}$ each may have include an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 15), an alkoxy group (for example, an alkoxy group having a carbon number of 1 to 15), a halogen atom, a hydroxyl group and a phenylthio group.

$Z^-$ represents a non-nucleophilic anion, and examples thereof are the same as those of the non-nucleophilic anion of $Z^-$ in formula (ZI).

Other examples of the acid generator include the compounds represented by the following formulae (ZIV), (ZV) and (ZVI).

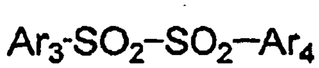

ZIV

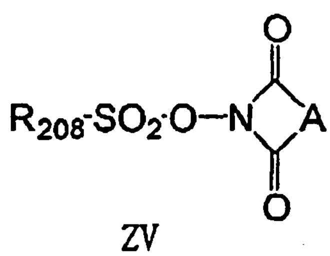

ZV

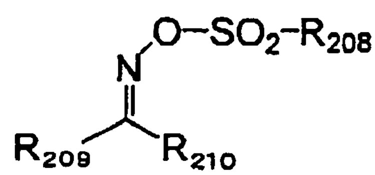

ZVI

In formulae (ZIV) to (ZVI), $Ar_3$ and $Ar_4$ each independently represents an aryl group.

$R_{208}$, $R_{209}$ and $R_{210}$ each independently represents an alkyl group, a cycloalkyl group or an aryl group.

A represents an alkylene group, an alkenylene group or an arylene group.

Among the acid generators, more preferred are the compounds represented by formulae (ZI) to (ZIII).

The acid generator is preferably a compound capable of generating an acid having one sulfonic acid group or imide group, more preferably a compound capable of generating a monovalent perfluoroalkanesulfonic acid, a compound capable of generating a monovalent aromatic sulfonic acid substituted by a fluorine atom or a fluorine atom-containing group, or a compound capable of generating a monovalent imide acid substituted by a fluorine atom or a fluorine atom-containing group, still more preferably a sulfonium salt of fluoro-substituted alkanesulfonic acid, fluorine-substituted benzenesulfonic acid, fluorine-substituted imide acid or fluorine-substituted methide acid.

In particular, the acid generated from the acid generator which can be used is preferably a fluoro-substituted alkanesulfonic acid, a fluoro-substituted benzenesulfonic acid or a fluoro-substituted imide acid, each having a pKa of -1 or less, and in this case, the sensitivity can be enhanced.

A sulfonium salt of at least one acid selected from a fluoro-substituted alkanesulfonic acid, a fluorine-substituted benzenesulfonic acid, a fluorine-substituted imide acid and a fluorine-substituted methide acid is preferably contained as the compound capable of generating an acid upon irradiation with actinic rays or radiation.

Among the acid generators, particularly preferred compounds are set forth below.

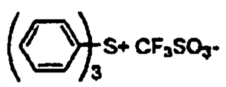
(z1)

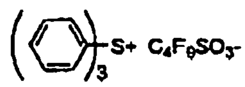
(z2)

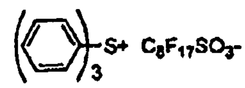
(z3)

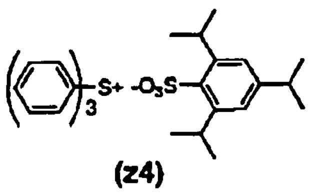
(z4)

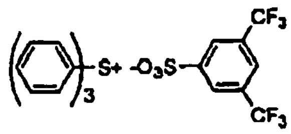
(z5)

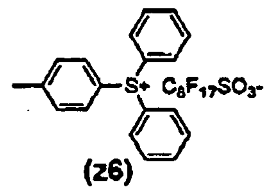
(z6)

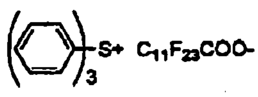
(z7)

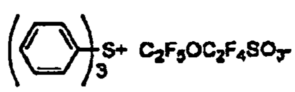
(z8)

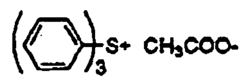
(z9)

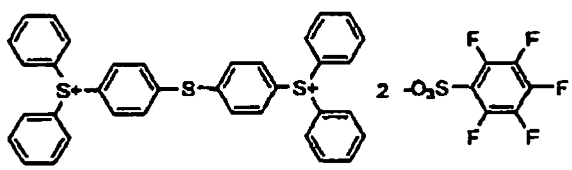
(z10)

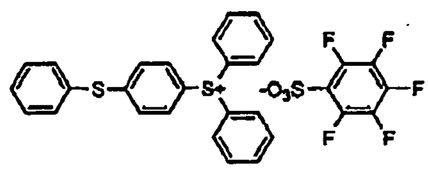
(z11)

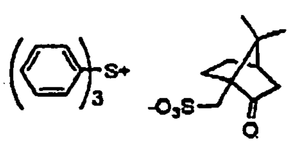
(z12)

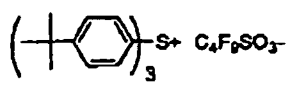
(z13)

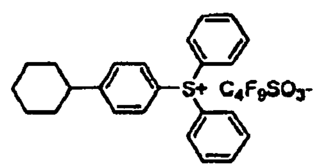
(z14)

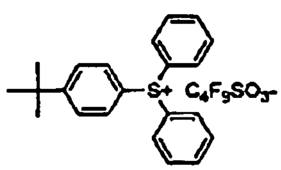
(z15)

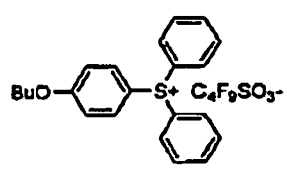
(z16)

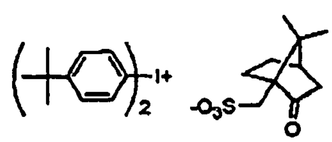
(z17)

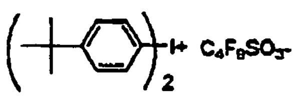

(z18)

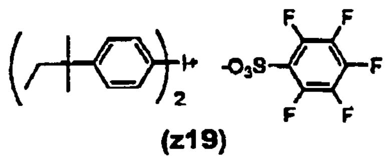

(z19)

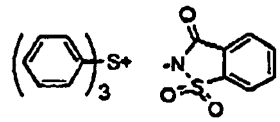

(z20)

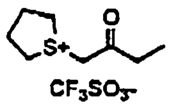

(z21)

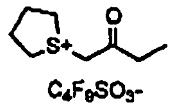

(z22)

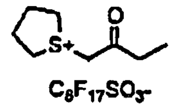

(z23)

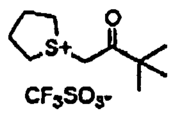

(z24)

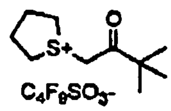

(z25)

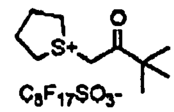

(z26)

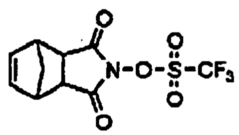

(z27)

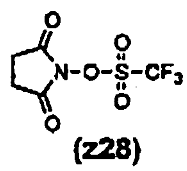

(z28)

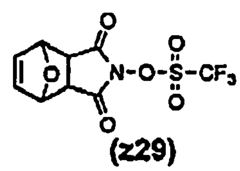

(z29)

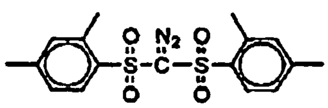

(z30)

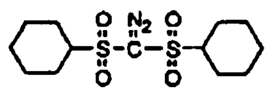

(z31)

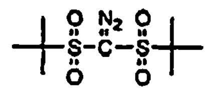

(z32)

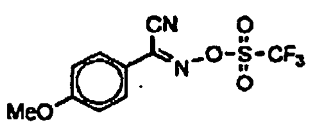

(z33)

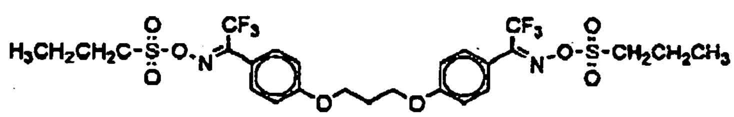

(z34)

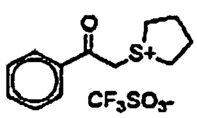

(z35)

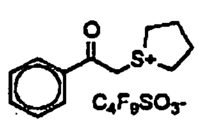

(z36)

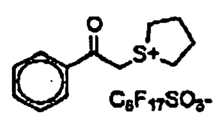

(z37)

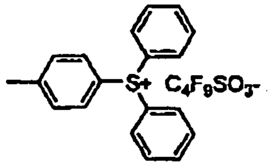
(z38)

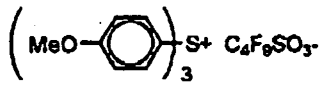
(z39)

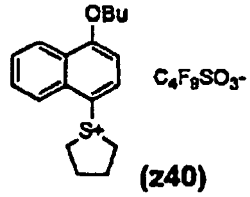
(z40)

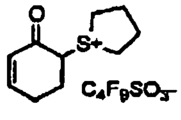
(z41)

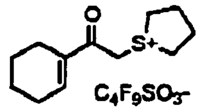
(z42)

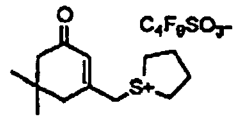
(z43)

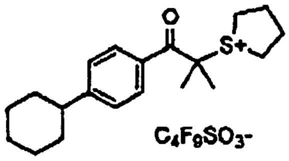
(z44)

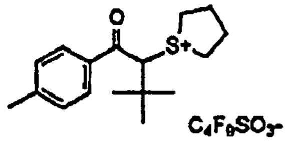
(z45)

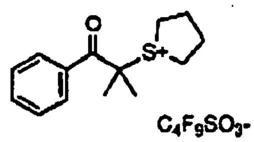
(z46)

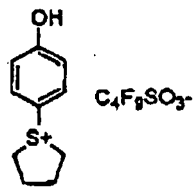
(z47)

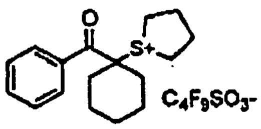
(z48)

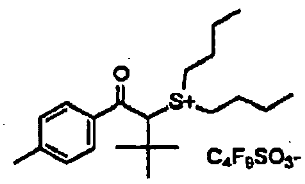
(z49)

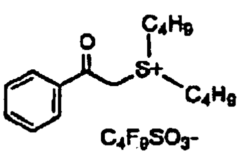
(z50)

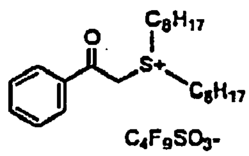
(z51)

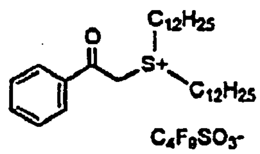
(z52)

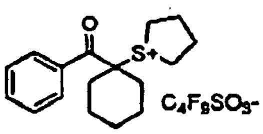
(z53)

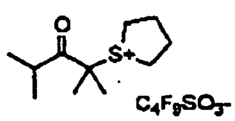
(z54)

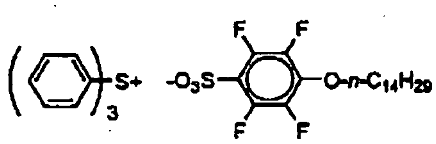
(z55)

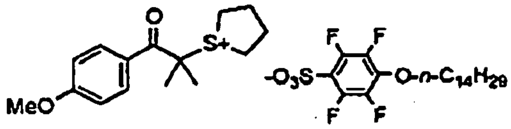

(z56)

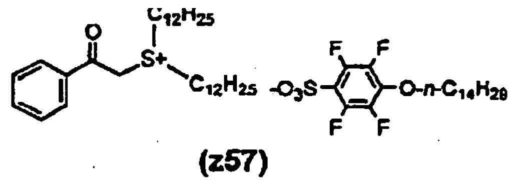

(z57)

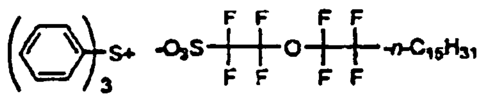

(z58)

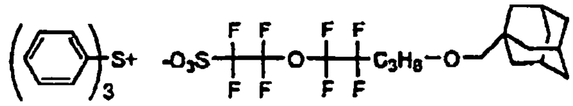

(z59)

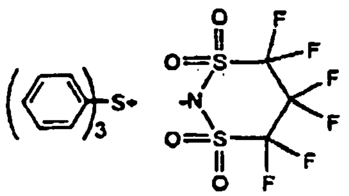

(z60)

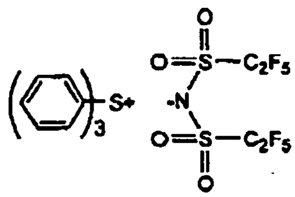

(z61)

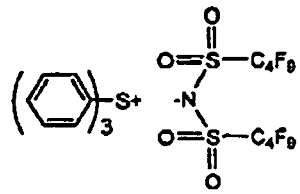

(z62)

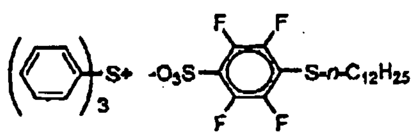

(z63)

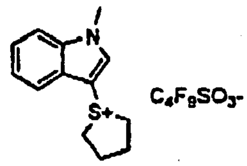

(z64)

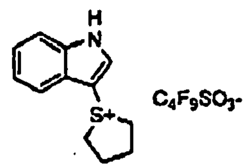

(z65)

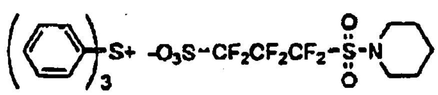

(z66)

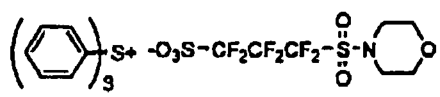

(z67)

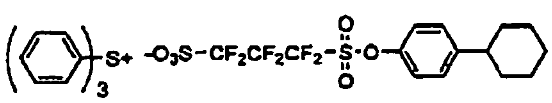

(z68)

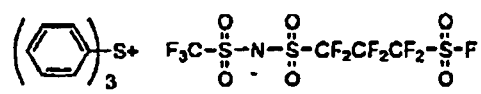

(z69)

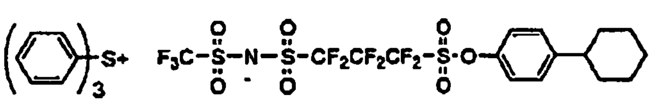

(z70)

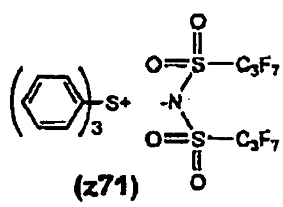

(z71)

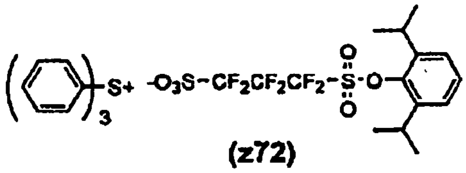

(z72)

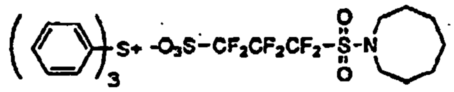

(z73)

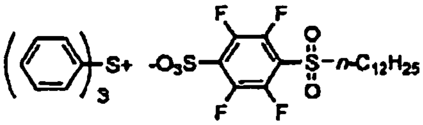

(z74)

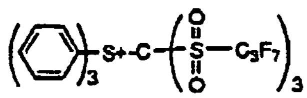

(z75)

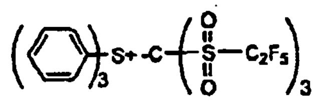

(z76)

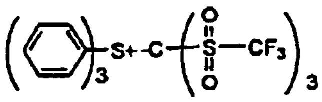

(z77)

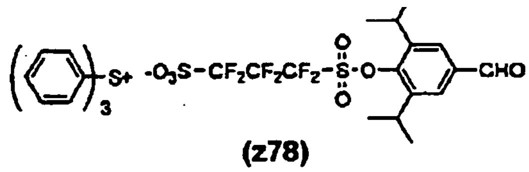

(z78)

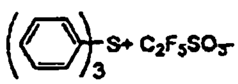

(z79)

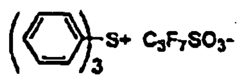

(z80)

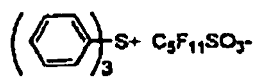

(z81)

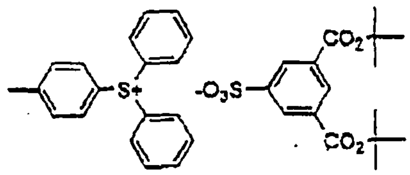

(z82)

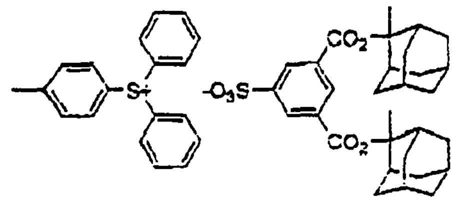

(z83)

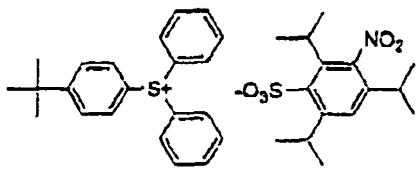

(z84)

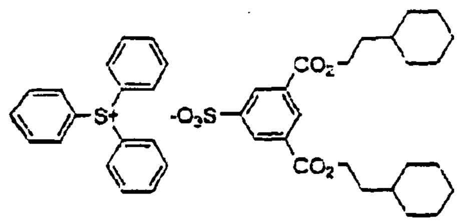

(z85)

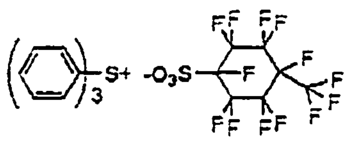

(z86)

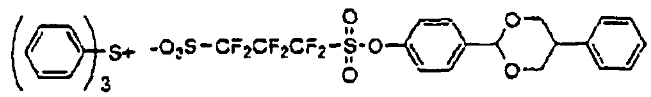

(z87)

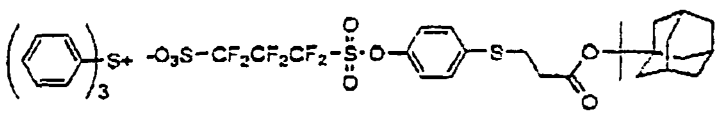

(z88)

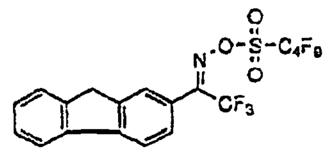

(z89)

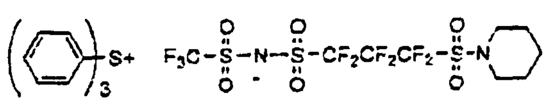

(z90)

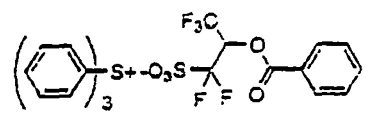

(z91)

One kind of an acid generator may be used alone or two or more kinds of acid generators may be used in combination. The content of the acid generator in the positive resist composition is, based on the entire solid content of the positive resist composition, 5 mass% or more, and is preferably from 5 to 15 mass%, still more preferably from 7 to 12 mass%. <(B) Resin of which polarity increases under the action of an acid>

The resin of which polarity increases under the action of an acid, for use in the resist composition of the present invention, is a resin having a group capable of decomposing under the action of an acid to produce an alkali-soluble group (hereinafter sometimes referred to as an "acid-decomposable group"), in the main or side chain or both the main and side chains of the resin (sometimes referred to as an "acid-decomposable resin", an "acid-decomposable resin (B)" or a "resin (B)"), preferably a resin having a monocyclic or polycyclic alicyclic hydrocarbon structure, where under the action of an acid, the polarity increases, the solubility in an alkali developer increases and the solubility in an organic solvent decreases (hereinafter sometimes referred to as an "alicyclic hydrocarbon-based acid-decomposable resin"). This is because the porality of the resin greatly changes between before and after irradiation with actinic rays or radiation and the dissolution contrast when developing the resist film by using a positive developer (preferably an alkali developer) and a negative developer (preferably an organic solvent) is enhanced. Furthermore, the resin having a monocyclic or polycyclic alicyclic hydrocarbon structure generally has high hydrophobicity and favors a high development rate when the resist film in a region irradiated with weak intensity light is developed using a negative developer (preferably an organic developer), and therefore, the developability on using a negative developer is enhanced.

Examples of the alkali-soluble group include groups having a phenolic hydroxyl group, a carboxylic acid group,

a fluorinated alcohol group, a sulfonic acid group, a sulfonamide group, a sulfonylimide group, an (alkylsulfonyl)(alkylcarbonyl)methylene group, an (alkylsulfonyl)(alkylcarbonyl)imide group, a bis(alkylcarbonyl)methylene group, a bis(alkylcarbonyyl)imide group, a bis(alkylsulfonyl)methylene group, a bis(alkylsulfonyl)-imide group, a tris(alkylcarbonyl)methytene group or a tris(alkylsulfonyl)methylene group.

Among these alkali-soluble groups, a carboxylic acid group, a fluorinated alcohol group (preferably hexafluoroisopropanol) and a sulfonic acid group are preferred.

The group capable of decomposing under the action of an acid (acid-decomposable group) is preferably a group obtained by substituting a hydrogen atom of the above-described alkali-soluble group with a group which leaves under the action of an acid.

Examples of the acid which leaves under the action of an acid include - $C(R_{36})(R_{37})(R_{38})$, $-C(R_{36})(R_{37})(0R_{39})$ and $-C(R_{01})(R_{02})(OR_{39})$.

In the formulae, $R_{36}$ to $R_{39}$ each independently represents an alkyl group, a cycloalkyl group, an aryl group, an aralkyl group or an alkenyl group. $R_{36}$ and $R_{37}$ may combine with each other to form a ring.

$R_{01}$ and $R_{02}$ each independently represents a hydrogen atom, an alkyl group, a cycloalkyl group, an aryl group, an aralkyl group or an alkenyl group.

The acid-decomposable group is preferably a cumyl ester group, an enol ester group, an acetal ester group, a tertiary alkyl ester group or the like, more preferably a tertiary alkyl ester group.

The positive resist composition of the present invention containing a resin having a monocyclic or polycyclic alicyclic hydrocarbon structure, of which polarity increases under the action of an acid, can be suitably used when ArF excimer laser light is irradiated.

The resin having a monocyclic or polycyclic alicyclic hydrocarbon structure, of which polarity increases under the action of an acid (hereinafter sometimes referred to as an "alicyclic hydrocarbon-based acid-decomposable resin"), is preferably a resin containing at least one member selected from the group consisting of a repeating unit having an alicyclic hydrocarbon-containing partial structure represented by any one of the following formulae (pI) to (pV) and a repeating unit represented by the following formula (II-AB).

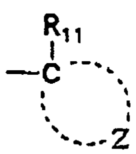
(pI)

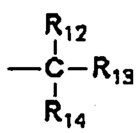
(pII)

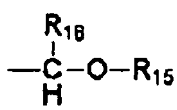
(pIII)

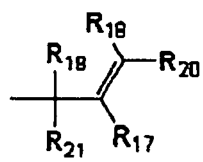
(pIV)

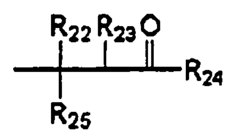
(pV)

In formulae (pI) to (pV), $R_{11}$ represents a methyl group, an ethyl group, an n-propyl group, an isopropyl group, an n-butyl group, an isobutyl group or a sec-butyl group. Z represents an atomic group necessary for forming a cycloalkyl group together with the carbon atom.

$R_{12}$ to $R_{16}$ each independently represents an alkyl group (preferably having a carbon number of 1 to 4) or a cycloalkyl group, provided that at least one of $R_{12}$ to $R_{14}$ or either one of $R_{15}$ and $R_{16}$ represents a cycloalkyl group.

$R_{17}$ to $R_{21}$ each independently represents a hydrogen atom, an alkyl group (preferably having a carbon number of 1 to 4) or a cycloalkyl group, provided that at least one of $R_{17}$ to $R_{21}$ represents a cycloalkyl group and that either one of $R_{19}$ and $R_{21}$ represents an alkyl group (preferably having a carbon number of 1 to 4) or a cycloalkyl group.

$R_{22}$ to $R_{25}$ each independently represents a hydrogen atom, an alkyl group (preferably having a carbon number of 1 to 4) or a cycloalkyl group, provided that at least one of $R_{22}$ to $R_{25}$ represents a cycloalkyl group. $R_{23}$ and $R_{24}$ may combine with each other to form a ring.

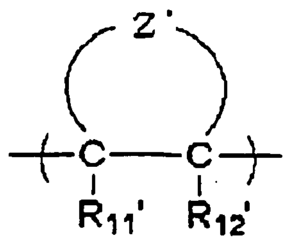

(II-AB)

In formula (II-AB), $R_{11}$' and $R_{12}$' each independently represents a hydrogen atom, a cyano group, a halogen atom or an alkyl group.

Z' represents an atomic group for forming an alicyclic structure containing two bonded carbon atoms (C-C).

Formula (II-AB) is preferably the following formula (II-AB1) or (II-AB2):

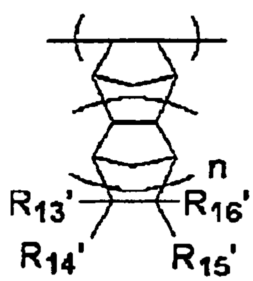

(II-AB1)

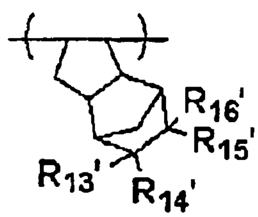

(II-AB2)

In formulae (II-AB1) and (II-AB2), $R_{13}$' to $R_{16}$' each independently represents a hydrogen atom, a halogen atom, a cyano group, -COOH, -$COOR_5$, a group capable of decomposing under the action of an acid, -C(=O)-X-A'-$R_{17}$', an alkyl group or a cycloalkyl group, and at least two members out of $R_{13}$' to $R_{16}$' may combine to form a ring.

$R_5$ represents an alkyl group, a cycloalkyl group or a group having a lactone structure. X represents an oxygen atom, a sulfur atom, -NH-, -$NHSO_2$- or -$NHSO_2NH$-.

A' represents a single bond or a divalent linking group.

$R_{17}$' represents -COOH, -$COOR_5$, -CN, a hydroxyl group, an alkoxy group, -CO-NH-$R_6$, -CO-NH-$SO_2$-$R_6$ or a group having a lactone structure.

$R_6$ represents an alkyl group or a cycloalkyl group.

n represents 0 or 1.

In formulae (pI) to (pV), the alkyl group of $R_{12}$ to $R_{25}$ is a linear or branched alkyl group having a carbon number of 1 to 4.

The cycloalkyl group of $R_{11}$ to $R_{25}$ and the cycloalkyl group formed by Z together with the carbon atom may be monocyclic or polycyclic. Specific examples thereof include a group having a carbon number of 5 or more and having a monocyclo, bicyclo, tricyclo or tetracyclo structure. The carbon number thereof is preferably from 6 to 30, more preferably from 7 to 25. These cycloalkyl groups each may have a substituent.

Preferred examples of the cycloalkyl group include an adamantyl group, a noradamantyl group, a decalin residue, a tricyclodecanyl group, a tetracyclododecanyl group, a norbornyl group, a cedrol group, a cyclopentyl group, a cyclohexyl group, a cycloheptyl group, a cyclooctyl group, a cyclodecanyl group and a cyclododecanyl group. Among these, more preferred are an adamantyl group, a norbornyl group, a cyclohexyl group, a cyclopentyl group, a tetracyclododecanyl group and a tricyclodecanyl group.

Examples of the substituent which the alkyl group and cycloalkyl group each may further have include an alkyl group (having a carbon number of 1 to 4), a halogen atom, a hydroxyl group, an alkoxy group (having a carbon number of 1 to 4), a carboxyl group and an alkoxycarbonyl group (having a carbon number of 2 to 6). Examples of the substituent which these alkyl group, alkoxy group, alkoxycarbonyl group and the like each may further have include a hydroxyl group, a halogen atom and an alkoxy group.

The structures represented by formulae (pI) to (pV) each can be used for the protection of an alkali-soluble

group in the resin. Examples of the alkali-soluble group include various groups known in this technical field.

Specific examples thereof include a structure where the hydrogen atom of a carboxylic acid group, a sulfonic acid group, a phenol group or a thiol group is replaced by the structure represented by any one of formulae (pI) to (pV). A structure where the hydrogen atom of a carboxylic acid group or a sulfonic acid group is replaced by the structure represented by any one of formulae (pI) to (pV) is preferred.

The repeating unit having an alkali-soluble group protected by the structure represented by any one of formulae (pI) to (pV) is preferably a repeating unit represented by the following formula (pA):

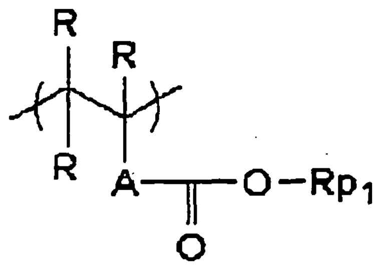

(pA)

In the formula, R represents a hydrogen atom, a halogen atom or a linear or branched alkyl group having a carbon number of 1 to 4, and the plurality of R's may be the same or different. A represents a single bond, or a sole group or a combination of two or more groups selected from the group consisting of an alkylene group, an ether group, a thioether group, a carbonyl group, an ester group, an amido group, a sulfonamido group, a urethane group and a ureylene group. A is preferably a single bond, $Rp_1$ represents a group represented by any one of formulae (pI) to (pV), preferably by formula (pI) or (pII).

The repeating unit represented by formula (pA) is more preferably a repeating unit comprising a 2-alkyl-2-adamantyl (meth)acrylate or a dialkyl(1-adamantyl)methyl (meth)acrylate.

Specific examples of the repeating unit having an acid-decomposable group are set forth below, but the present invention is not limited thereto.

(In the formulae, Rx represents H, $CH_3$ or $CH_2OH$, and Rxa and Rxb each independently represents an alkyl group having a carbon number of 1 to 4.

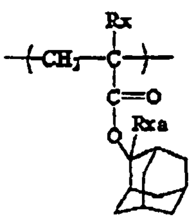

1

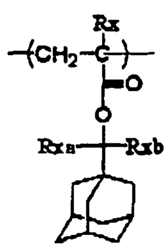

2

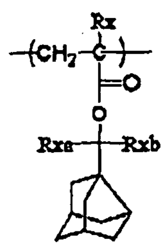

3

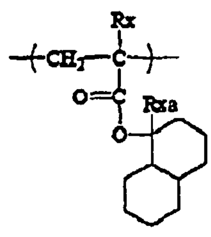

4

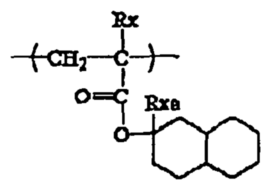

5

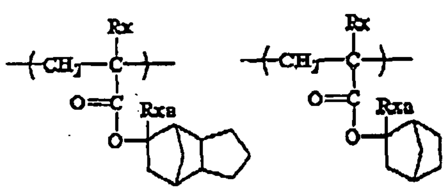

6

7

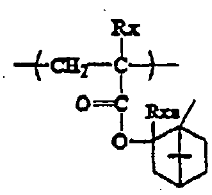

8

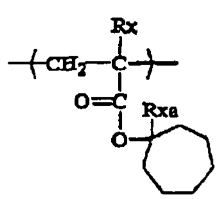

9

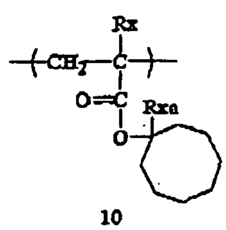

10

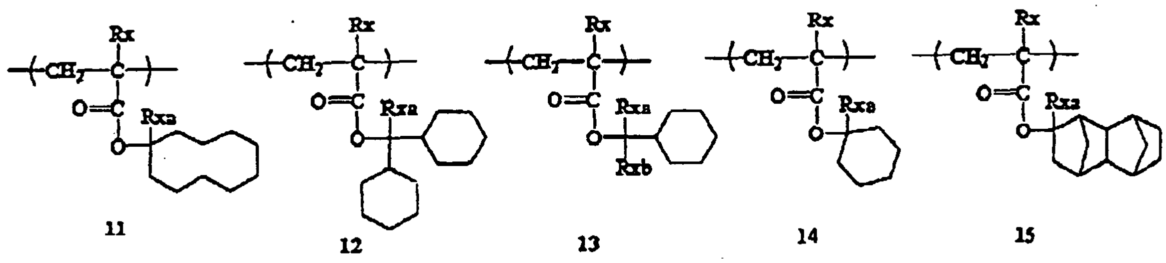

11 12 13 14 15

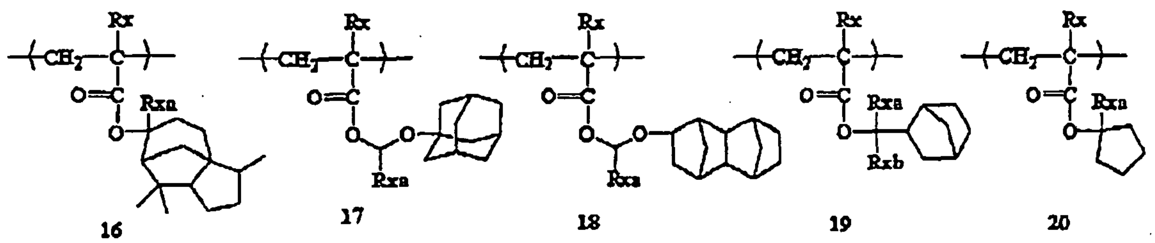

16 17 18 19 20

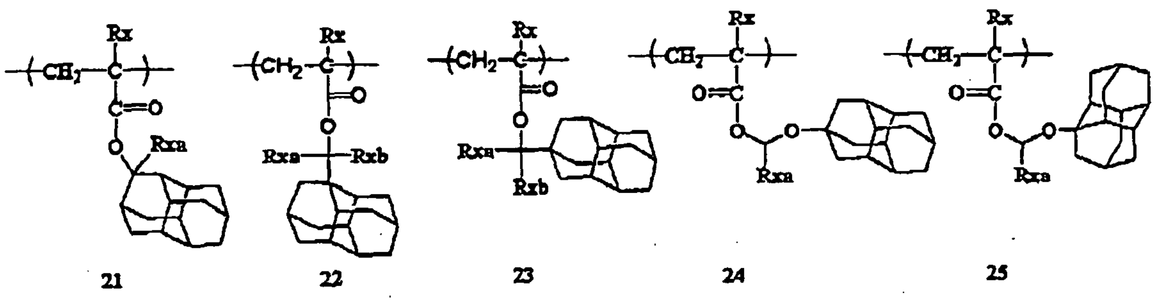

21 22 23 24 25

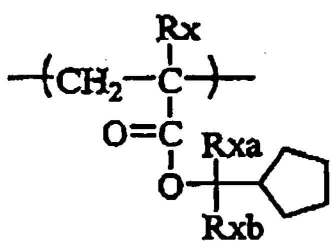

26

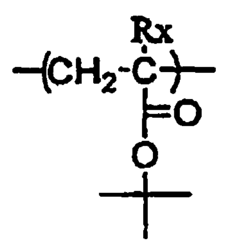

27

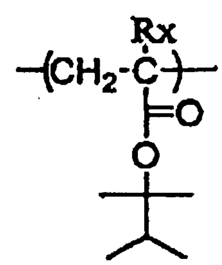

28

Examples of the halogen atom of $R_{11}$' and $R_{12}$' in formula (II-AB) include a chlorine atom, a bromine atom, a fluorine atom and an iodine atom.

The alkyl group of $R_{11}$' and $R_{12}$' includes a linear or branched alkyl group having a carbon number of 1 to 10.

The atomic group of Z' for forming an alicyclic structure is an atomic group for forming a repeating unit comprising an alicyclic hydrocarbon which may have a substituent, in the resin. Above all, an atomic group for forming a crosslinked alicyclic structure to form a crosslinked alicyclic hydrocarbon repeating unit is preferred.

Examples of the skeleton of the alicyclic hydrocarbon formed are the same as those of the alicyclic hydrocarbon group of $R_{12}$ to $R_{25}$ in formulae (pI) to (pV).

The skeleton of the alicyclic hydrocarbon may have a substituent, and examples of the substituent include $R_{13}$' to $R_{16}$' in formulae (II-AB1) and (II-AB2).

In the alicyclic hydrocarbon-based acid-decomposable resin for use in the present invention, the group capable of decomposing under the action of an acid may be contained in at least one repeating unit out of the repeating unit having an alicyclic hydrocarbon-containing partial structure represented by any one of formulae (pI) to (pV), the repeating

unit represented by formula (II-AB), and the repeating unit comprising a copolymerization component described later. The group capable of decomposing under the action of an acid is preferably contained in the repeating unit having an alicylcic hydrocarbon-containing partial structure represented by any one of formulae (pI) to (pV).

Various substituents $R_{13}$' to $R_{16}$' in formulae (II-AB1) and (II-AB2) may become substituents of the atomic group for forming an alicyclic structure in formula (II-AB) or the atomic group Z' for forming a crosslinked alicyclic structure.

Specific examples of the repeating units represented by formulae (II-AB1) and (II-AB2) are set forth below, but the present invention is not limited to these specific examples.

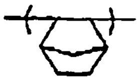
[II-1]

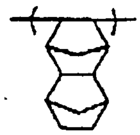
[II-2]

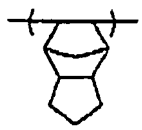
[II-3]

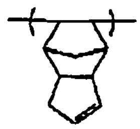
[II-4]

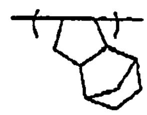
[II-5]

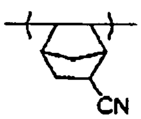
[II-6]

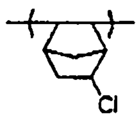
[II-7]

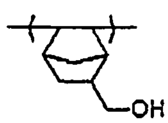
[II-8]

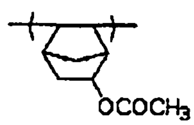
[II-9]

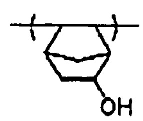
[II-10]

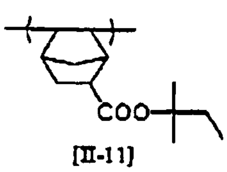
[II-11]

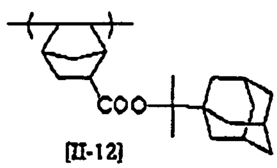
[II-12]

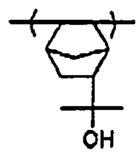
[II-13]

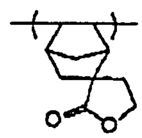
[II-14]

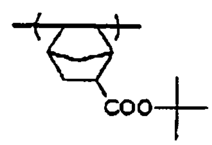
[II-15]

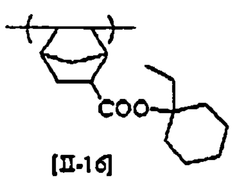
[II-16]

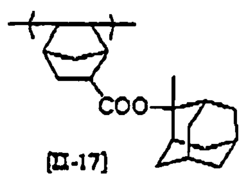
[II-17]

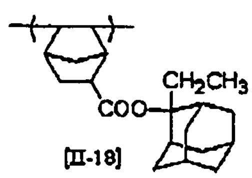
[II-18]

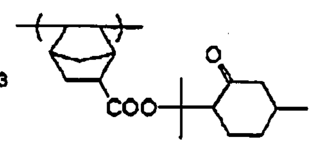
[II-19]

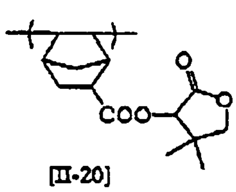
[II-20]

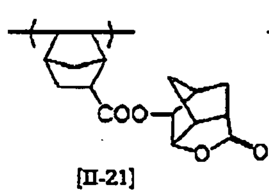
[II-21]

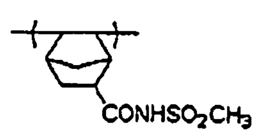
[II-22]

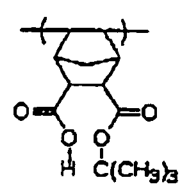
[II-23]

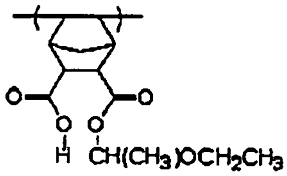
[II-24]

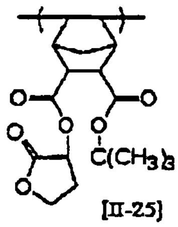
[II-25]

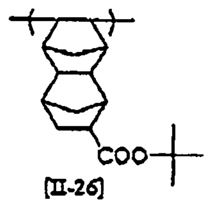
[II-26]

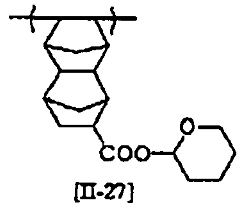
[II-27]

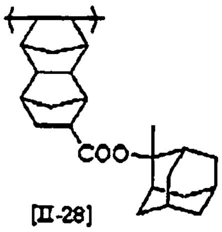
[II-28]

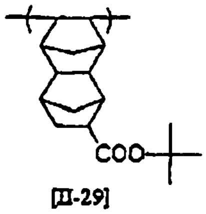
[II-29]

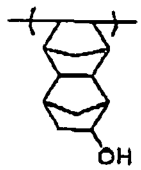
[II-30]

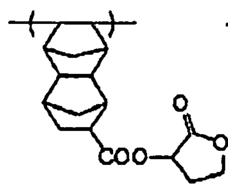
[II-31]

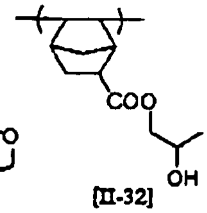
[II-32]

The alicyclic hydrocarbon-based acid-decomposable resin for use in the present invention preferably has a lactone group. As for the lactone group, any group may be used as long as it has a lactone structure, but a group having a 5- to 7-membered ring lactone structure is preferred. The 5- to 7-membered ring lactone structure is preferably condensed with another ring structure in the form of forming a bicyclo or spiro structure. The resin more preferably contains a repeating unit containing a group having a lactone structure represented by any one of the following formulae (LCl-1) to (LC1-16). The group having a lactone structure may be bonded directly to the main chain. Among these lactone structures, preferred are groups represented by formulae (LCl-1), (LCl-4), (LC1-5), (LCl-6), (LC1-13) and (LCl-14). By virtue of using a specific lactone structure, the line edge roughness and development defect are improved.

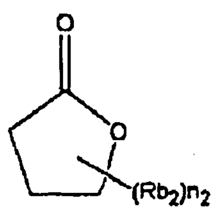
LC1-1

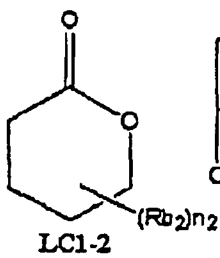
LC1-2

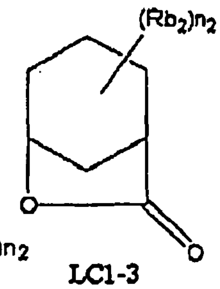
LC1-3

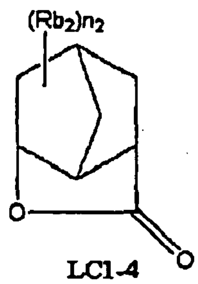
LC1-4

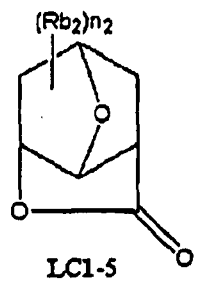
LC1-5

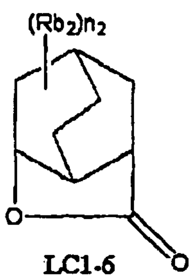
LC1-6

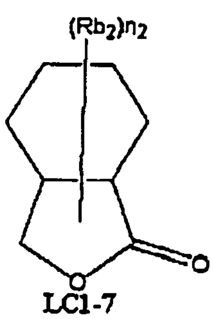
LC1-7

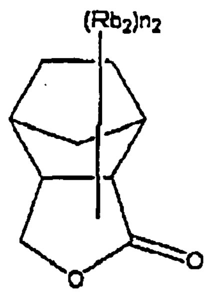
LC1-8

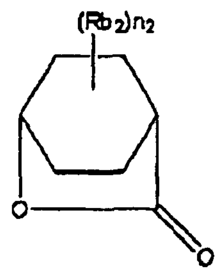
LC1-9

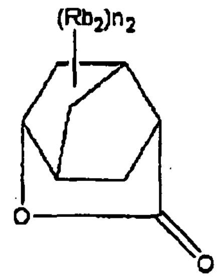
LC1-10

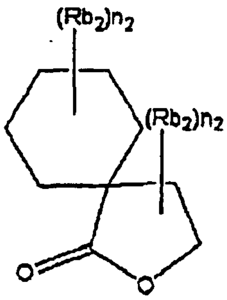

LC1-11

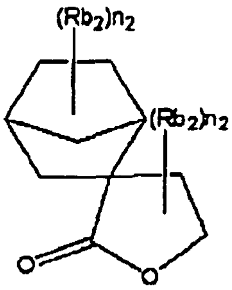

LC1-12

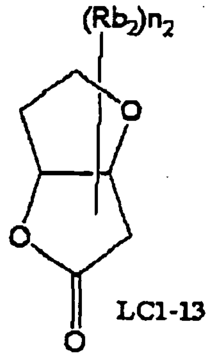

LC1-13

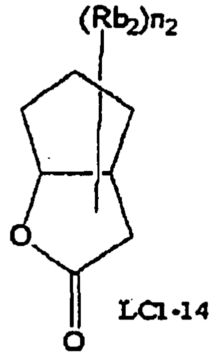

LC1-14

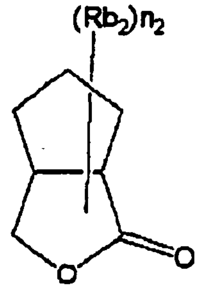

LC1-15

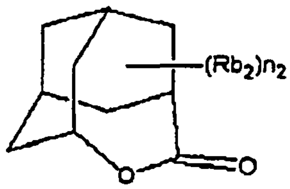

LC1-16

The lactone structure moiety may or may not have a substituent ($Rb_2$). Preferred examples of the substituent ($Rb_2$) include an alkyl group having a carbon number of 1 to 8, a cycloalkyl group having a carbon number of 4 to 7, an alkoxy group having a carbon number of 1 to 8, an alkoxycarbonyl group having a carbon number of 2 to 8, a carboxyl group, a halogen atom, a hydroxyl group, a cyano group and an acid-decomposable group, $n_2$ represents an integer of 0 to 4. When $n_2$ is an integer of 2 or more, the plurality of $Rb_2$'s may be the same or different and also, the plurality of $Rb_2$'s may combine with each other to form a ring.

Examples of the repeating unit containing a group having a lactone structure represented by any one of formulae (LC1-1) to (LC1-16) include a repeating unit where at least one of $R_{13}$' to $R_{16}$' in formula (II-AB1) or (II-AB2) has a group represented by any one of formulae (LC1-1) to (LC1-16) (for example, $R_5$ of $-COOR_5$ is a group represented by any one of formulae (LCl-1) to (LC1-16)), and a repeating unit represented by the following formula (AI):

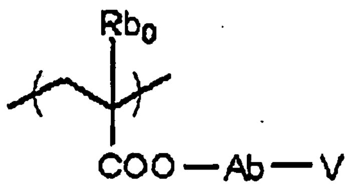

(AI)

In formula (AI), $Rb_0$ represents a hydrogen atom, a halogen atom or an alkyl group having a carbon number of 1 to 4,

Preferred examples of the substituent which the alkyl group of $Rb_0$ may have include a hydroxyl group and a halogen atom.

The halogen atom of $Rb_0$ includes a fluorine atom, a chlorine atom, a bromine atom and an iodine atom.

$Rb_0$ is preferably a hydrogen atom, a methyl group, a hydroxymethyl group or a trifluoromethyl group, particularly preferably a hydrogen atom or a methyl group.

Ab represents a single bond, an alkylene group, a divalent linking group having a monocyclic or polycyclic alicyclic hydrocarbon structure, an ether group, an ester group, a carbonyl group, a carboxyl group, or a divalent group comprising a combination thereof, and is preferably a single bond or a linking group represented by $-Ab_1-CO_2-$. $Ab_1$ represents a linear or branched alkylene group or a monocyclic or polycyclic cycloalkylene group and is preferably a methylene group, an ethylene group, a cyclohexylene group, an adamantyl group or a norbornyl group.

V represents a group represented by any one of formulae (LCl-1) to (LC1-16).

The repeating unit having a lactone structure usually has an optical isomer, but any optical isomer may be used. One optical isomer may be used alone or a mixture of a plurality of optical isomers may be used. In the case of

mainly using one optical isomer, the optical purity (ee) thereof is preferably 90 or more, more preferably 95 or more.

Specific examples of the repeating unit containing a group having a lactone structure are set forth below, but the present invention is not limited thereto.

(In the formulae, Rx is H, $CH_3$, $CH_2OH$ or $CF_3$.)

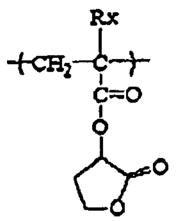
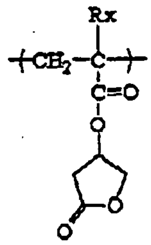
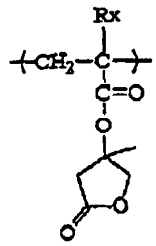
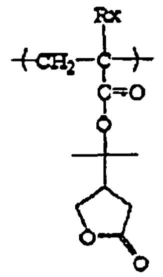
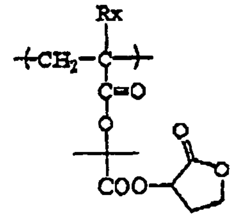

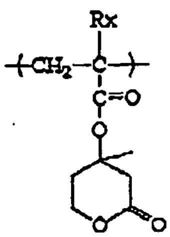
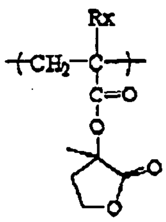
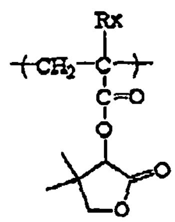
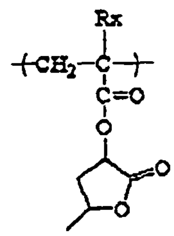
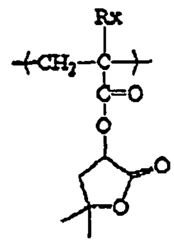

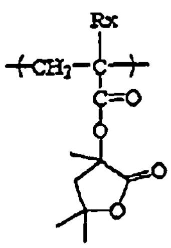
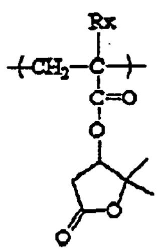
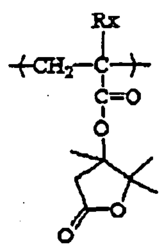
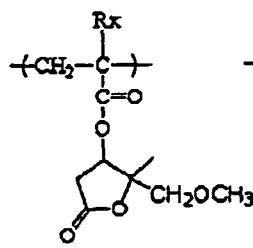
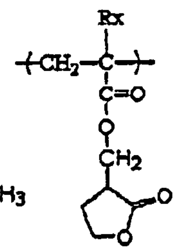

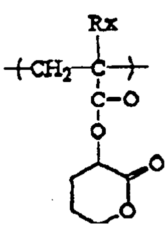
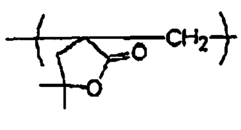
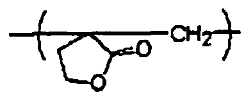
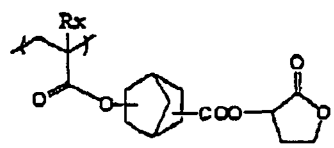

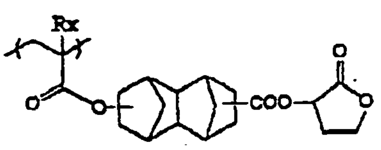
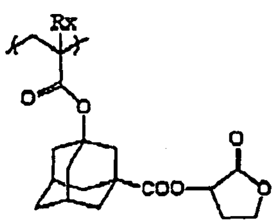

(In the formulae, Rx is H, $CH_3$, $CH_2OH$ or $CF_3$.)

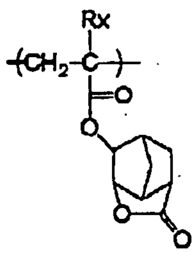
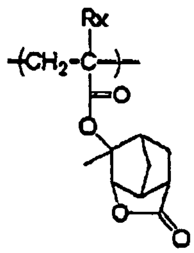
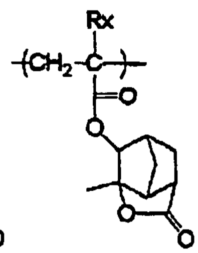
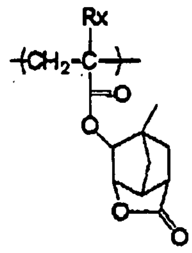
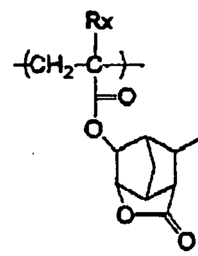
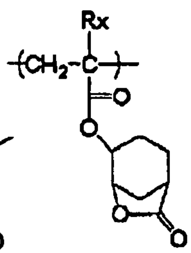

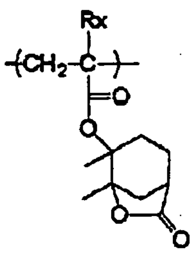
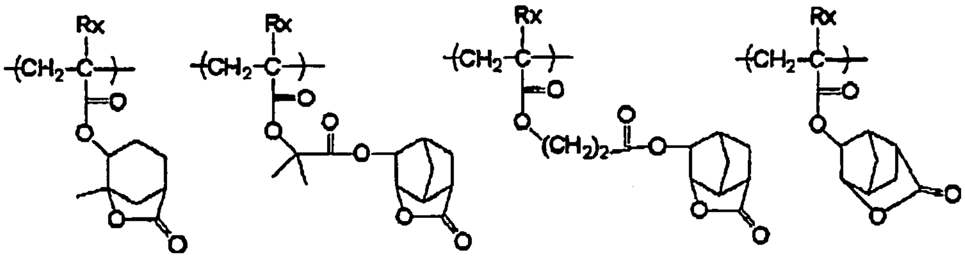

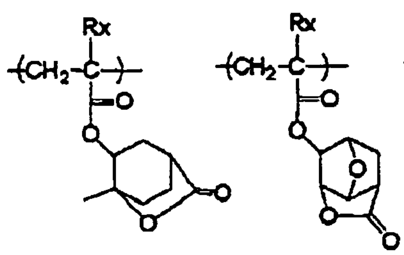
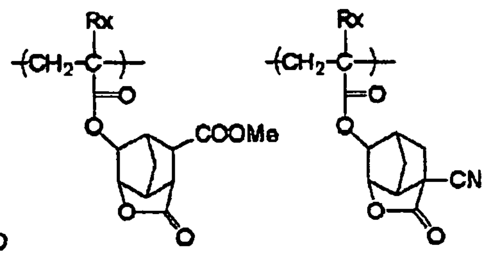
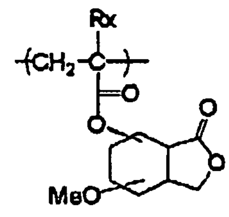

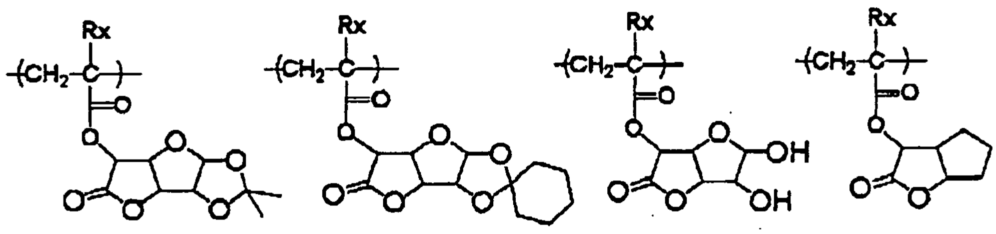

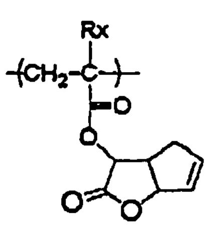
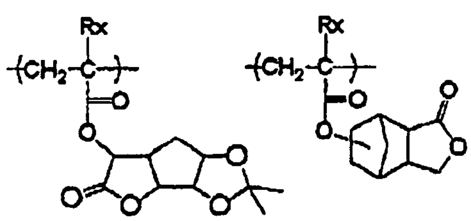
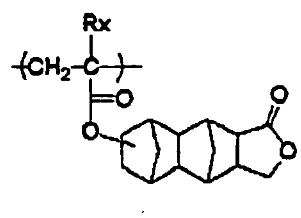

(In the formulae, Rx is H, $CH_3$, $CH_2OH$ or $CF_3$.)

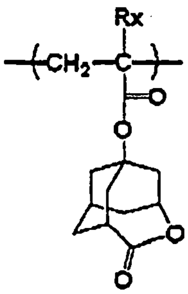
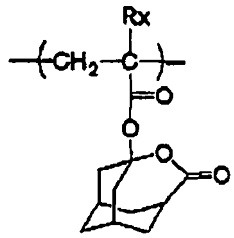
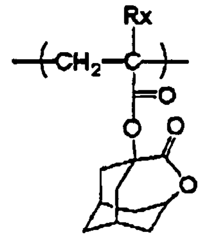
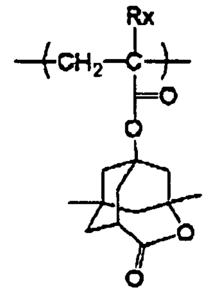
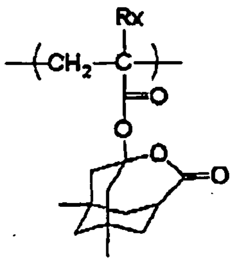
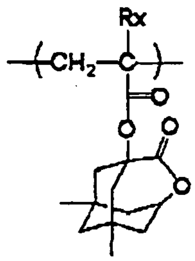
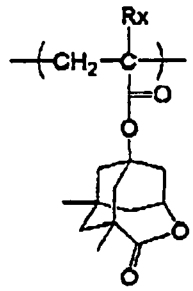
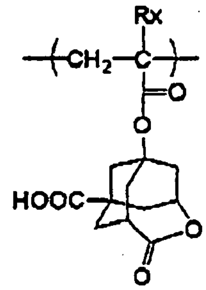
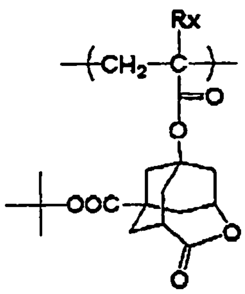
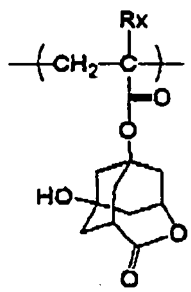
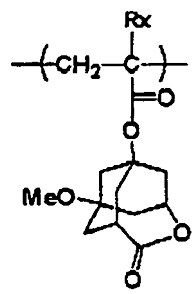
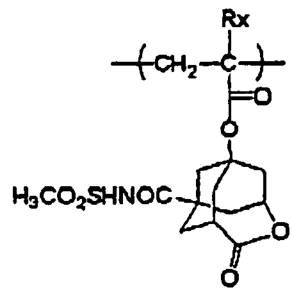

The alicyclic hydrocarbon-based acid-decomposable resin for use in the present invention preferably contains a repeating unit containing an organic group having a polar group, more preferably a repeating unit having an alicyclic hydrocarbon structure substituted by a polar group. By virtue of this repeating unit, the adhesion to substrate and the affinity for developer are enhanced. The alicyclic hydrocarbon structure of the polar group-substituted alicyclic hydrocarbon structure is preferably an adamantyl group, a diamantyl group or a norbomane group. The polar group is preferably a hydroxyl group or a cyano group.

The polar group-substituted alicyclic hydrocarbon structure is preferably a partial structure represented by any one of the following formulae (VIIa) to (VIId):

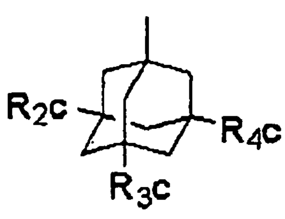
(VIIa)

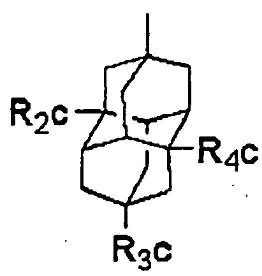
(VIIb)

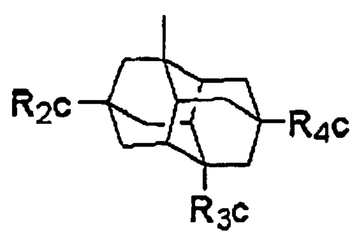
(VIIc)

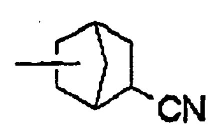
(VIId)

In formulae (VIIa) to (VIIc), $R_{2c}$ to $R_{4c}$ each independently represents a hydrogen atom, a hydroxyl group or a cyano group, provided that at least one of $R_{2c}$ to $R_{4c}$ represents a hydroxyl group or a cyano group. A structure where one or two members out of $R_{2c}$ to $R_{4c}$ are a hydroxyl group with the remaining being a hydrogen atom is preferred.

In formula (VIIa), it is more preferred that two members out of $R_{2c}$ to $R_{4c}$ are a hydroxyl group and the remaining is a hydrogen atom.

The repeating unit having a group represented by any one of formulae (VIIa) to (VIId) includes a repeating unit where at least one of $R_{13}'$ to $R_{16}'$ in formula (II-AB1) or (II-AB2) has a group represented by any one of formulae (VIIa) to (VIId) (for example, $R_5$ of $-COOR_5$ is a group represented by any one of formulae (VIIa) to (VIId)), and repeating units represented by the following formulae (AIIa) to (AIId):

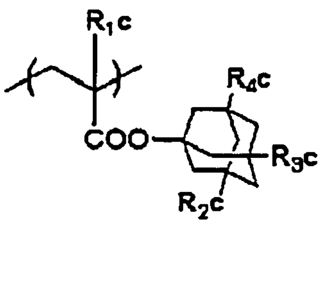
(AIIa)

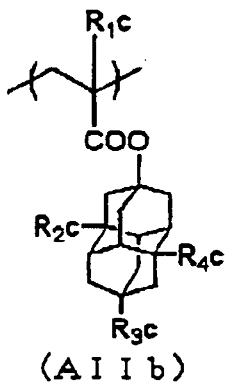
(AIIb)

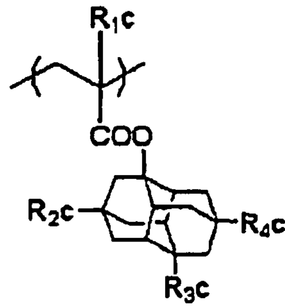
(AIIc)

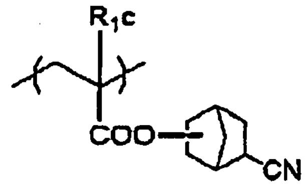
(AIId)

In formulae (AIIa) to (AIId), $R_{1c}$ represents a hydrogen atom, a methyl group, a trifluoromethyl group or a hydroxymethyl group.

$R_{2c}$ to $R_{4c}$ have the same meanings as $R_{2c}$ to $R_{4c}$ in formulae (VIIa) to (VIIc).

Specific examples of the repeating unit having a structure represented by any one of formulae (AIIa) to (AIId) are set forth below, but the present invention is not limited thereto.

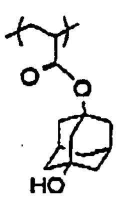
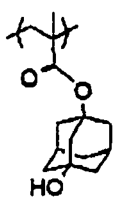
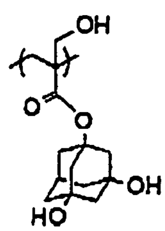
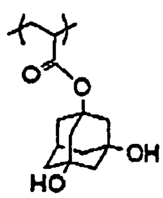
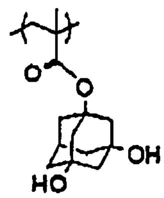
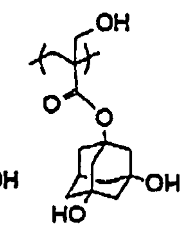

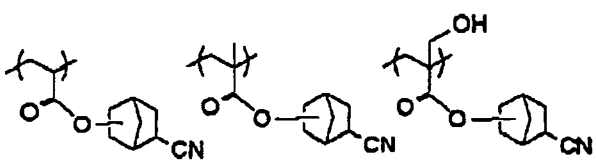
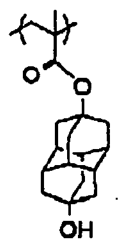
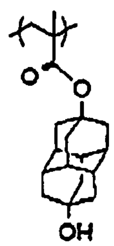
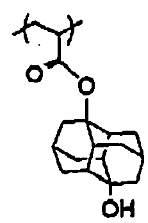
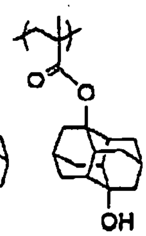

The alicyclic hydrocarbon-based acid-decomposable resin for use in the present invention may contain a repeating unit represented by the following formula (VIII):

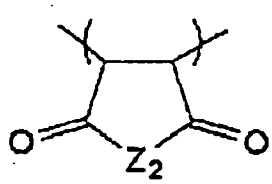

(VIII)

In formula (VIII), $Z_2$ represents -O- or $-N(R_{41})-$. $R_{41}$ represents a hydrogen atom, a hydroxyl group, an alkyl group or $-OSO_2-R_{42}$. $R_{42}$ represents an alkyl group, a cycloalkyl group or a camphor residue. The alkyl group of $R_{41}$ and $R_{42}$ may be substituted by a halogen atom (preferably fluorine atom) or the like.

Specific examples of the repeating unit represented by formula (VIII) are set forth below, but the present invention is not limited thereto.

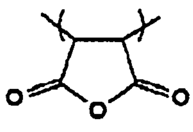

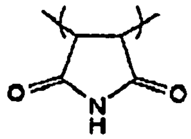

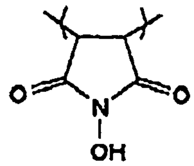

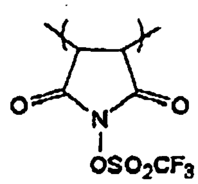

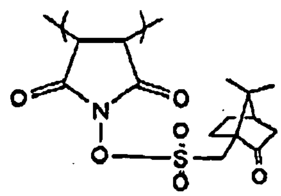

The alicyclic hydrocarbon-based acid-decomposable resin for use in the present invention preferably contains a repeating unit having an alkali-soluble group, more preferably a repeating unit having a carboxyl group. By virtue of containing this repeating unit, the resolution increases in the usage of forming contact holes. As for the repeating unit having a carboxyl group, a repeating unit where a carboxyl group is directly bonded to the resin main chain, such as repeating unit by an acrylic acid or a methacrylic acid, a repeating unit where a carboxyl group is bonded to the resin main chain through a linking group, and a repeating unit where a carboxyl group is introduced into the terminal of the polymer chain by using a polymerization initiator or chain transfer agent having an alkali-soluble group at the polymerization, all are preferred. The linking group may have a monocyclic or polycyclic hydrocarbon structure. A repeating unit by an acrylic acid or a methacrylic acid is more preferred.

The alicyclic hydrocarbon-based acid-decomposable resin for use in the present invention may further contain a repeating unit having from 1 to 3 groups represented by formula (F1). By virtue of this repeating unit, the performance in terms of line edge roughness is enhanced.

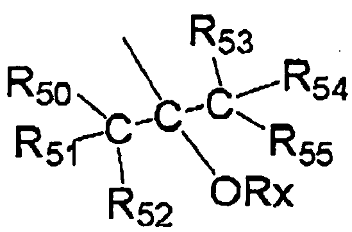

(F1)

In formula (F1), $R_{50}$ to $R_{55}$ each independently represents a hydrogen atom, a fluorine atom or an alkyl group, provided that at least one of $R_{50}$ to $R_{55}$ is a fluorine atom or an alkyl group with at least one hydrogen atom being substituted by a fluorine atom.

Rx represents a hydrogen atom or an organic group (preferably an acid-decomposable protective group, an alkyl group, a cycloalkyl group, an acyl group or an alkoxycarbonyl group).

The alkyl group of $R_{50}$ to $R_{55}$ may be substituted by a halogen atom (e.g., fluorine), a cyano group or the like, and the alkyl group is preferably an alkyl group having a carbon number of 1 to 3, such as methyl group and trifluoromethyl group.

It is preferred that $R_{50}$ to $R_{55}$ all are a fluorine atom.

The organic group represented by Rx is preferably an acid-decomposable protective group or an alkyl, cycloalkyl, acyl, alkylcarbonyl, alkoxycarbonyl, alkoxycarbonylmethyl, alkoxymethyl or 1-alkoxyethyl group which may have a substituent.

The repeating unit having a group represented by formula (F1) is preferably a repeating unit represented by the following formula (F2):

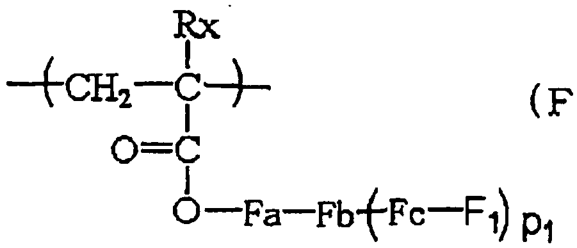

(F 2)

In formula (F2), Rx represents a hydrogen atom, a halogen atom or an alkyl group having a carbon number of 1 to 4. Preferred examples of the substituent which the alkyl group of Rx may have include a hydroxyl group and a halogen atom.

Fa represents a single bond or a linear or branched alkylene group and is preferably a single bond.

Fb represents a monocyclic or polycyclic cyclohydrocarbon group.

Fc represents a single bond or a linear or branched alkylene group and is preferably a single bond or a methylene group.

$F_1$ represents a group represented by formula (F1).

$p_1$ represents a number of 1 to 3.

The cyclic hydrocarbon group in Fb is preferably a cyclopentyl group, a cyclohexyl group or a norbornyl group.

Specific examples of the repeating unit having a group represented by formula (F1) are set forth below, but the present invention is not limited thereto.

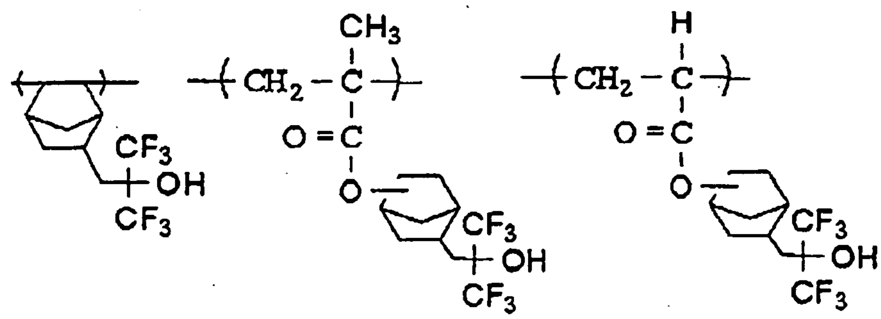

The alicyclic hydrocarbon-based acid-decomposable resin for use in the present invention may further contain a repeating unit having an alicyclic hydrocarbon structure and not exhibiting acid decomposability. By virtue of this repeating unit, the dissolving out of low molecular components from the resist film to the immersion liquid at the immersion exposure can be reduced. Examples of this repeating unit include 1-adamantyl (meth)acrylate, tricyclodecanyl (meth) acrylate and cyclohexyl (meth)acrylate.

It is preferred that the acid acid-decomposable resin (B) of the present invention further contains a repeating unit represented by formula (IX) having neither a hydroxyl group nor a cyano group:

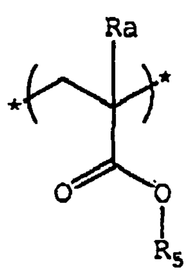

(IX)

In formula (IX), $R_5$ represents a hydrocarbon group having at least one cyclic structure and having neither a

hydroxyl group nor a cyano group.

Ra represents a hydrogen atom, an alkyl group or a $-CH_2-O-Ra_2$ group, wherein $Ra_2$ represents a hydrogen atom, an alkyl group or an acyl group. Ra is preferably a hydrogen atom, a methyl group, a hydroxymethyl group or a trifluoromethyl group, particularly preferably a hydrogen atom or a methyl group.

The cyclic structure possessed by $R_5$ includes a monocyclic hydrocarbon group and a polycyclic hydrocarbon group. Examples of the monocyclic hydrocarbon group include a cycloalkyl group having a carbon number of 3 to 12, such as cyclopentyl group, cyclohexyl group, cycloheptyl group and cyclooctyl group, and a cycloalkenyl group having a carbon number of 3 to 12, such as cyclohexenyl group. As the monocyclic hydrocarbon group, a monocyclic hydrocarbon group having a carbon number of 3 to 7 is preferred, and a cyclopentyl group and a cyclohexyl group are more preferred.

The polycyclic hydrocarbon group includes a ring gathered hydrocarbon group and a crosslinked cyclic hydrocarbon group. Examples of the ring gathered hydrocarbon group include a bicyclohexyl group and a perhydronaphthalenyl group. Examples of the crosslinked cyclic hydrocarbon ring include a bicyclic hydrocarbon ring such as pinane, bornane, norpinane, norbomane and bicyclooctane rings (e.g., bicyclo[2.2.2]octane ring, bicyclo[3.2.1]octane ring), a tricyclic hydrocarbon ring such as homobredane, adamantane, tricyclo[5.2.1.$0^{2,6}$]decane and tricyclo[4.3.1.$1^{2,5}$]undecane rings, and a tetracyclic hydrocarbon ring such as tetracyclo[4.4.0.$1^{2,5}$.$1^{7,10}$]dodecane and perhydro-1,4-methano-5,8-methanonaphthalene rings. The crosslinked cyclic hydrocarbon ring also includes a condensed cyclic hydrocarbon ring, and examples thereof include a condensed ring formed by condensing a plurality of 5- to 8-membered cycloalkane rings such as perhydronaphthalene (decalin), perhydroanthracene, perhydrophenanthrene, perhydroacenaphthene, perhydrofluorene, perhydroindene and perhydrophenanthrene rings.

As the crosslinked cyclic hydrocarbon ring, a norbornyl group, an adamantyl group, a bicyclooctanyl group, a tricyclo[5.2.1.$0^{2.6}$]decanyl group are preferred, and a norbornyl group and an adamantyl group are more preferred.

Such an alicyclic hydrocarbon group may have a substituent, and preferred examples of the substituent include a halogen atom, an alkyl group, a hydroxyl group protected by a protective group, and an amino group protected by a protective group. Preferred halogen atoms include bromine, chlorine and fluorine atoms, and preferred alkyl groups include methyl, ethyl, butyl and tert-butyl groups. This alkyl group may further have a substituent, and the substituent which the alkyl group may further have includes a halogen atom, an alkyl group, a hydroxyl group protected by a protective group, and an amino group protected by a protective group.

Examples of the protective group include an alkyl group, a cycloalkyl group, an aralkyl group, a substituted methyl group, a substituted ethyl group, an acyl group, an alkoxycarbonyl group and an aralkyloxycarbonyl group. For example, the alkyl group is preferably an alkyl group having a carbon number of 1 to 4, the substituted methyl group is preferably a methoxymethyl, methoxythiomethyl, benzyloxymethyl, tert-butoxymethyl or 2-methoxyethoxymethyl group, the substituted ethyl group is preferably a 1-ethoxyethyl or 1-methyl-1-methoxyethyl group, the acyl group is preferably an aliphatic acyl group having a carbon number of 1 to 6, such as formyl, acetyl, propionyl, butyryl, isobutyryl, valeryl and pivaloyl groups, and the alkoxycarbonyl group is preferably an alkoxycarbonyl group having a carbon number of 1 to 4.

The content of the repeating unit represented by formula (IX) having neither a hydroxyl group nor a cyano group is preferably from 0 to 40 mol%, more preferably from 0 to 20 mol%, based on all repeating units in the acid acid-decomposable resin (B).

Specific examples of the repeating unit represented by formula (IX) are set forth below, but the present invention is not limited thereto.

In formulae, Ra represents H, $CH_3$, $CH_2OH$ or $CF_3$.

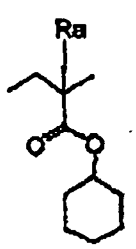
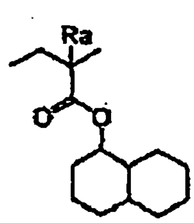
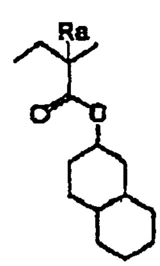
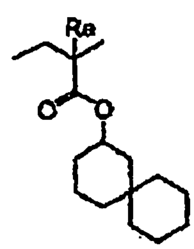

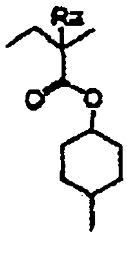 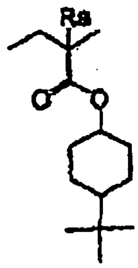 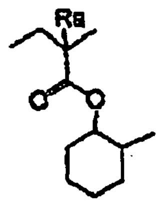 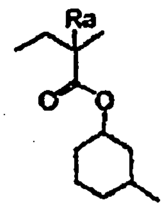

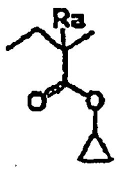 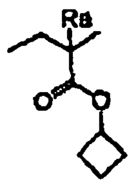 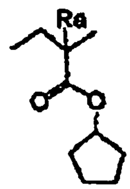 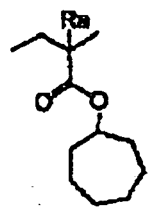

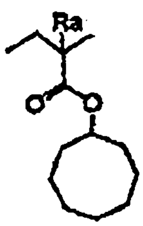 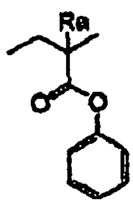 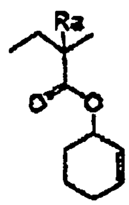 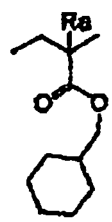

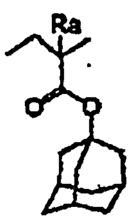 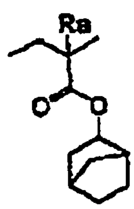 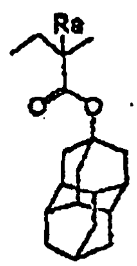 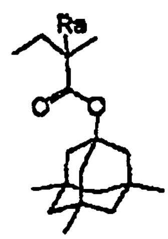

The alicyclic hydrocarbon-based acid-decomposable resin for use in the present invention may contain, in addition to the above-described repeating units, various repeating structural units for the purpose of controlling dry etching resistance, suitability for standard developer, adhesion to substrate, resist profile and properties generally required of the resist, such as resolving power, heat resistance and sensitivity.

Examples of such a repeating structural unit include, but are not limited to, repeating structural units corresponding to the monomers described below.

By virtue of such a repeating structural unit, the performance required of the alicyclic hydrocarbon-based acid-decomposable resin, particularly,

(1) solubility in coating solvent,
(2) film-forming property (glass transition point),
(3) solubility in positive or negative developer,
(4) film loss (selection of hydrophilic, hydrophobic or alkali-soluble group),
(5) adhesion of unexposed area to substrate,

(6) dry etching resistance

and the like, can be subtly controlled.

Examples of the monomer include a compound having one addition-polymerizable unsaturated bond selected from acrylic acid esters, methacrylic acid esters, acrylamides, methacrylamides, allyl compounds, vinyl ethers and vinyl esters.

Other than these, an addition-polymerizable unsaturated compound copolymerizable with the monomers corresponding to the above-described various repeating structural units may be copolymerized.

In the alicyclic hydrocarbon-based acid-decomposable resin, the molar ratio of respective repeating structural units contained is appropriately determined to control the dry etching resistance of resist, suitability for standard developer, adhesion to substrate, resist profile and performances generally required of the resist, such as resolving power, heat resistance and sensitivity.

The preferred embodiment of the alicyclic hydrocarbon-based acid-decomposable resin for use in the present invention includes the followings:

(1) a resin containing a repeating unit having an alicyclic hydrocarbon-containing partial structure represented by any one of formulae (pI) to (pV) (side chain type), preferably a resin containing a (meth)acrylate repeating unit having a structure represented by any one of formulae (pI) to (pV), and

(2) a resin containing a repeating unit represented by formula (II-AB) (main chain type).

The resin of (2) further includes:

(3) a resin having a repeating unit represented by formula (II-AB), a maleic anhydride derivative and a (meth)acrylate structure (hybrid type).

In the alicyclic hydrocarbon-based acid-decomposable resin, the content of the repeating unit having an acid-decomposable group is preferably from 10 to 60 mol%, more preferably from 20 to 50 mol%, still more preferably from 30 to 50 mol%, based on all repeating structural units.

In the acid-decomposable resin, the content of the repeating unit having an acid-decomposable group is preferably from 10 to 60 mol%, more preferably from 20 to 50 mol%, still more preferably from 30 to 50 mol%, based on all repeating structural units.

In the alicyclic hydrocarbon-based acid-decomposable resin, the content of the repeating unit having an alicyclic hydrocarbon-containing partial structure represented by any one of formulae (pI) to (pV) is preferably from 20 to 70 mol%, more preferably from 20 to 50 mol%, still more preferably from 30 to 50 mol%, based on all repeating structural units.

In the alicyclic hydrocarbon-based acid-decomposable resin, the content of the repeating unit represented by formula (II-AB) is preferably from 10 to 60 mol%, more preferably from 15 to 55 mol%, still more preferably from 20 to 50 mol%, based on all repeating structural units.

In the acid-decomposable resin, the content of the repeating unit having a lactone ring is preferably from 10 to 70 mol%, more preferably from 20 to 60 mol%, still more preferably from 25 to 50 mol%, based on all repeating structural units.

In the acid-decomposable resin, the content of the repeating unit having a polar group-containing organic group is preferably from 1 to 40 mol%, more preferably from 5 to 30 mol%, still more preferably from 5 to 20 mol%, based on all repeating structural units.

The content of the repeating structural unit based on the monomer as a further copolymerization component, in the resin, can also be appropriately selected according to the desired resist performance but in general, the content thereof is preferably 99 mol% or less, more preferably 90 mol% or less, still more preferably 80 mol% or less, based on the total molar number of the repeating structural unit having an alicyclic hydrocarbon-containing partial structure represented by any one of formulae (pI) to (pV) and the repeating unit represented by formula (II-AB).

In the case of using the resist composition of the present invention for ArF exposure, the acid-decomposable resin (B) preferably has no aromatic group in view of transparency to ArF light.

The alicyclic hydrocarbon-based acid-decomposable resin for use in the present invention is preferably a resin where all repeating units are composed of a (meth)acrylate. based repeating unit. In this case, the repeating units may be all a methacrylate-based repeating unit, all an acrylate-based repeating unit, or all a mixture of methacrylate-based repeating unit/acrylate-based repeating unit, but the content of the acrylate-based repeating unit is preferably 50 mol% or less based on all repeating units.

The alicyclic hydrocarbon-based acid-decomposable resin is preferably a copolymer having three kinds of repeating unit, that is, a (meth)acrylate-based repeating unit having a lactone ring, a (meth)acrylate-based repeating unit having an organic group substituted by at least either one of a hydroxyl group and a cyano group, and a (meth) acrylate-based repeating unit having an acid-decomposable group.

The copolymer is preferably a ternary copolymerization polymer comprising from 20 to 50 mol% of the repeating

unit having an alicyclic hydrocarbon-containing partial structure represented by any one of formulae (pI) to (pV), from 20 to 50 mol% of the repeating unit having a lactone structure and from 5 to 30 mol% of the repeating unit having a polar group-substituted alicyclic hydrocarbon structure, or a quaternary copolymerization polymer further comprising from 0 to 20 mol% of other repeating units.

In particular, the resin is preferably a ternary copolymerization polymer comprising from 20 to 50 mol% of an acid-decomposable group-containing repeating unit represented by any one of the following formulae (ARA-1) to (ARA-5), from 20 to 50 mol% of a lactone group-containing repeating unit represented by any one of the following formulae (ARL-1) to (ARL-6), and from 5 to 30 mol% of a repeating unit having a polar group-substituted alicyclic hydrocarbon structure represented by any one of the following formulae (ARH-1) to (ARH-3), or a quaternary copolymerization polymer further comprising from 5 to 20 mol% of a repeating unit containing a carboxyl group or a structure represented by formula (F1) and a repeating unit having an alicyclic hydrocarbon structure and not exhibiting acid decomposability.

(In the formulae, $Rxy_1$ represents a hydrogen atom or a methyl group, and $Rxa_1$ and $Rxb_1$ each represents a methyl group or an ethyl group).

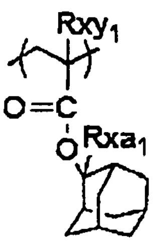
ARA-1

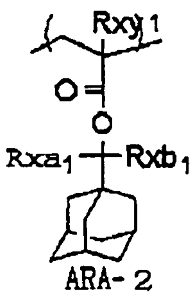
ARA-2

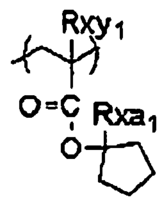
ARA-3

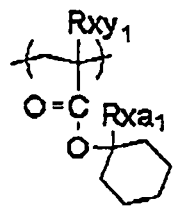
ARA-4

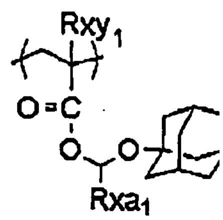
ARA-5

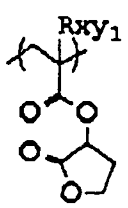
ARL-1

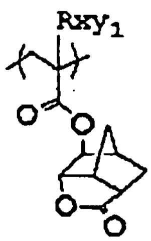
ARL-2

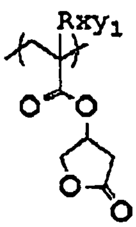
ARL-3

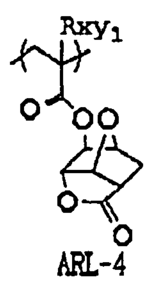
ARL-4

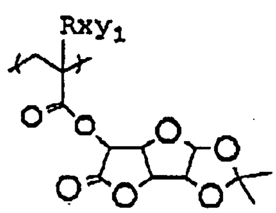
ARL-5

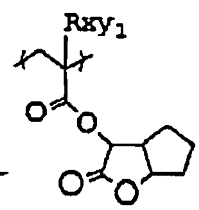
ARL-6

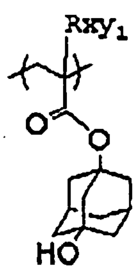
ARH-1

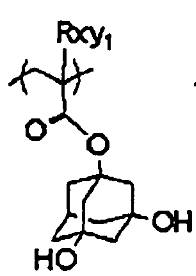
ARH-2

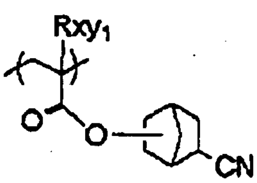
ARH-3

The alicyclic hydrocarbon-based acid-decomposable resin for use in the present invention can be synthesized by an ordinary method (for example, radical polymerization). Examples of the synthesis method in general include a batch polymerization method of dissolving monomer species and an initiator in a solvent and heating the solution, thereby effecting the polymerization, and a dropping polymerization method of adding dropwise a solution containing monomer species and an initiator to a heated solvent over 1 to 10 hours. A dropping polymerization method is preferred. Examples of the reaction solvent include tetrahydrofuran, 1,4-dioxane, ethers such as diisopropyl ether, ketones such as methyl ethyl ketone and methyl isobutyl ketone, an ester solvent such as ethyl acetate, an amide solvent such as dimethylformamide and dimethylacetamide, and a solvent capable of dissolving the composition of the present invention, which is

described later, such as propylene glycol monomethyl ether acetate, propylene glycol monomethyl ether and cyclohexanone. The polymerization is more preferably performed using the same solvent as the solvent used in the resist composition of the present invention. By the use of this solvent, production of particles during storage can be suppressed.

The polymerization reaction is preferably performed in an inert gas atmosphere such as nitrogen and argon. As for the polymerization initiator, the polymerization is started using a commercially available radical initiator (e.g., azo-based initiator, peroxide). The radical initiator is preferably an azo-based initiator, and an azo-based initiator having an ester group, a cyano group or a carboxyl group is preferred. Preferred examples of the initiator include azobisisobutyronitrile, azobisdimethylvaleronitrile and dimethyl 2,2'-azobis(2-methyl-propionate). The initiator is added additionally or in parts, if desired. After the completion of reaction, the reaction product is charged into a solvent, and the desired polymer is recovered by a method such as powder or solid recovery. The reaction concentration is from 5 to 50 mass%, preferably from 10 to 30 mass%, and the reaction temperature is usually from 10 to 150˚C, preferably from 30 to 120˚C, more preferably from 60 to 100˚C.

The purification may be performed by the same method as that for a resin (HR) described later, and there may be applied a normal method, for example, a liquid-liquid extraction method of applying water washing or combining an appropriate solvent to remove residual monomers or oligomer components, a purification method in a solution sate, such as ultrafiltration of removing by extraction only polymers having a molecular weight lower than a specific molecular weight, a reprecipitation method of adding dropwise the resin solution in a bad solvent to solidify the resin in the bad solvent and thereby remove residual monomers or the like, or a purification method in a solid state, such as a method of separating the resin slurry by filtration and washing it with a bad solvent.

The weight average molecular weight of the resin for use in the present invention is 6,000 or less, preferably from 1,000 to 5,000, more preferably from 2,000 to 3,500, in terms of polystyrene by the GPC method. When the weight average molecular weight of the resin is 6,000 or less, the line edge roughness of the resist pattern is reduced.

The dispersity (molecular weight distribution, Mw/Mn) is 1.7 or less, preferably 1.5 or less, more preferably 1.3 or less. As the dispersity is smaller, the line edge roughness of the resist pattern is more reduced.

By combining the preferred ranges of the weight average molecular weight and dispersity of the resin for use in the present invention, the line edge roughness can be further reduced.

In the resist composition of the present invention, the amount of all resins for use in the present invention blended in the entire composition is preferably from 50 to 99.9 mass%, more preferably from 60 to 99.0 mass%, based on the entire solid content.

In the present invention, one resin may be used or a plurality of resins may be used in combination.

The alicyclic hydrocarbon-based acid-decomposable resin for use in the present invention preferably contains no fluorine or silicon atom.

<Hydrophobic Resin (HR)>

The amount of the hydrophobic resin added may be appropriately adjusted to give a resist film having a receding contact angle in the range above but is preferably from 0.1 to 10 mass%, more preferably from 0.1 to 5 mass%, based on the entire solid content of the positive resist composition.

The hydrophobic resin (HR) is, as described above, unevenly distributed in the interface but unlike a surfactant, need not necessarily have a hydrophilic group in the molecule and may not contribute to uniform mixing of polar/nonpolar substances.

The fluorine atom or silicon atom in the hydrophobic resin (HR) may be present in the main chain of the resin or may be substituted to the side chain.

The hydrophobic resin (HR) is preferably a resin having, as the fluorine atom-containing partial structure, a fluorine atom-containing alkyl group, a fluorine atom-containing cycloalkyl group or a fluorine atom-containing aryl group.

The fluorine atom-containing alkyl group (preferably having a carbon number of 1 to 10, more preferably from 1 to 4) is a linear or branched alkyl group with at least one hydrogen atom being substituted by a fluorine atom and may further have another substituent.

The fluorine atom-containing cycloalkyl group is a monocyclic or polycyclic cycloalkyl group with at least one hydrogen atom being substituted by a fluorine atom and may further have another substituent.

The fluorine atom-containing aryl group is an aryl group (e.g., phenyl, naphthyl) with at least one hydrogen atom being substituted by a fluorine atom and may further have another substituent.

Preferred examples of the fluorine atom-containing alkyl groups, fluorine atom-cycloalkyl group and fluorine atom-containing aryl group include the groups represented by the following formulae (f1) to (f3), but the present invention is not limited thereto.

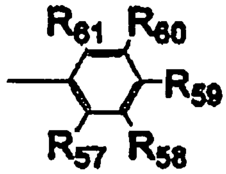
(f1)

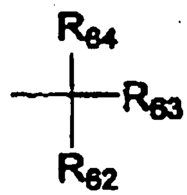
(f2)

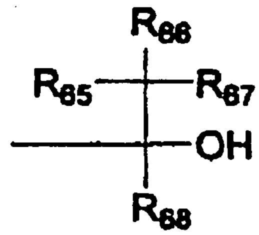
(f3)

In formulae (f1) to (f3), $R_{57}$ to $R_{68}$ each independently represents a hydrogen atom, a fluorine atom or an alkyl group, provided that at least one of $R_{57}$ to $R_{61}$, at least one of $R_{62}$ to $R_{64}$ and at least one of $R_{65}$ to $R_{68}$ are a fluorine atom or an alkyl group (preferably having a carbon number of 1 to 4) with at least one hydrogen atom being substituted by a fluorine atom. It is preferred that $R_{57}$ to $R_{61}$ and $R_{65}$ to $R_{67}$ all are a fluorine atom. $R_{62}$, $R_{63}$ and $R_{68}$ each is preferably an alkyl group (preferably having a carbon number of 1 to 4) with at least one hydrogen atom being substituted by a fluorine atom, more preferably a perfluoroalkyl group having a carbon number of 1 to 4. $R_{62}$ and $R_{63}$ may combine with each other to form a ring.

Specific examples of the group represented by formula (f1) include p-fluorophenyl group, pentafluorophenyl group and 3,5-di(trifluoromethyl)phenyl group.

Specific examples of the group represented by formula (f2) include trifluoroethyl group, pentafluoropropyl group, pentafluoroethyl group, heptafluorobutyl group, hexafluoroisopropyl group, heptafluoroisopropyl group, hexafluoro(2-methyl)isopropyl group, nonafluorobutyl group, octafluoroisobutyl group, nonafluorohexyl group, nonafluoro-tert-butyl group, perfluoroisopentyl group, pertluorooctyl group, perfluoro(trimethyl)hexyl group, 2,2,3,3-tetrafluarocyclobutyl group and perfluorocyclohexyl group. Among these, hexafluoroisopropyl group, heptafluoroisopropyl group, hexatluoro(2-methyl)isopropyl group, octafluoroisobutyl group, nonafluoro-tert-butyl group and perfluoroisopentyl group are preferred, and hexafluoroisopropyl group and heptafluoroisopropyl group are more preferred.

Specific examples of the group represented by formula (f3) include $-C(CF_3)_2OH$, $-C(C_2F_5)_2OH$, $-C(CF_3)(CH_3)OH$ and $-CH(CF_3)OH$, with $-C(CF_3)_2OH$ being preferred.

Specific examples of the repeating unit having a fluorine atom are set forth below, but the present invention is not limited thereto.

In specific examples, $X_1$ represents a hydrogen atom, $-CH_3$, -F or $-CF_3$.

$X_2$ represents -F or $-CF_3$.

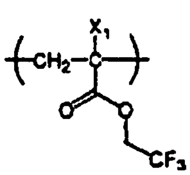
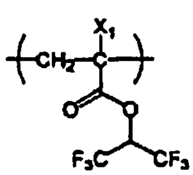
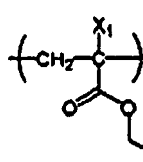
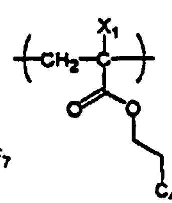
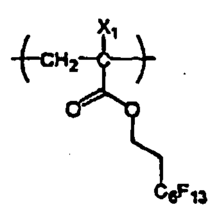

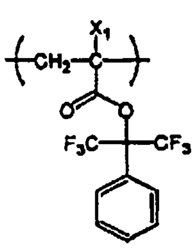
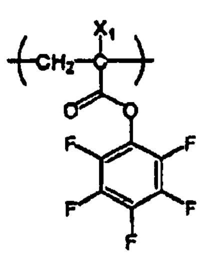
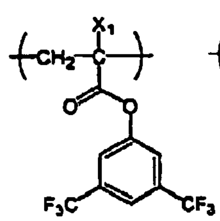
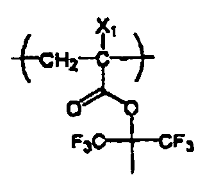
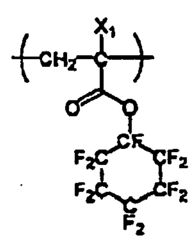

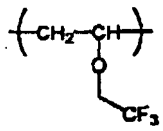
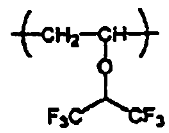
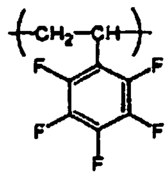

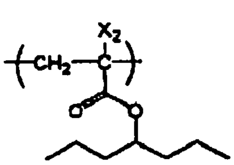
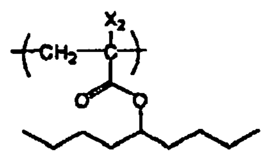
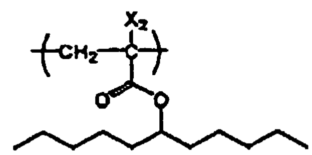

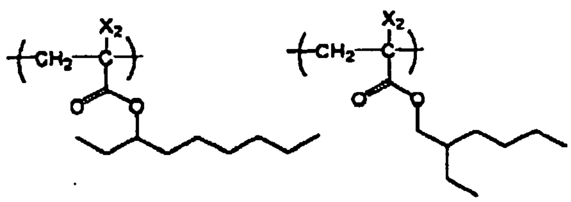
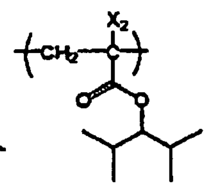
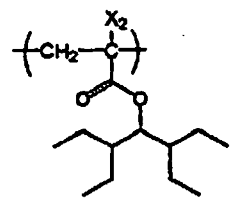

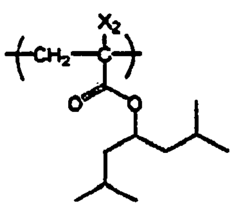
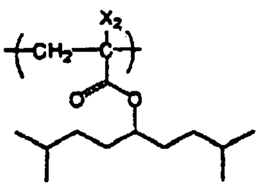
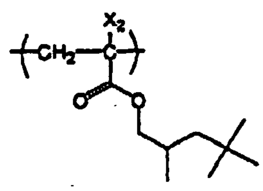
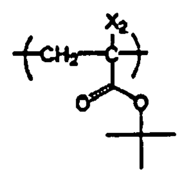

The hydrophobic resin (HR) is preferably a resin having, as the silicon atom-containing partial structure, an alkylsilyl structure (preferably a trialkylsilyl group) or a cyclic siloxane structure.

Specific examples of the alkylsilyl structure and cyclic siloxane structure include the groups represented by the following formulae (CS-1) to (CS-3);

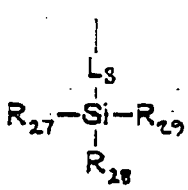
(CS-1)

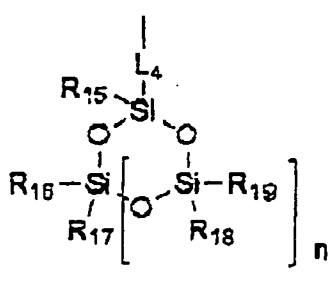
(CS-2)

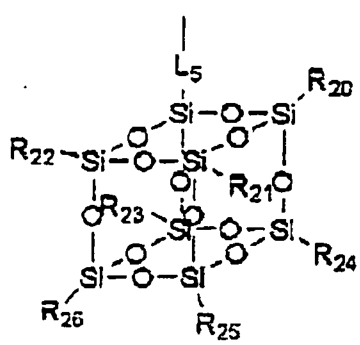
(CS-3)

In formulae (CS-1) to (CS-3), $R_{15}$ to $R_{29}$ each independently represents a linear or branched alkyl group (preferably having a carbon number of 1 to 20) or a cycloalkyl group (preferably having a carbon number of 3 to 20).

$L_3$ to $L_5$ each represents a single bond or a divalent linking group. The divalent linking group is a sole group or a combination of two or more groups selected from the group consisting of an alkylene group, a phenylene group, an ether group, a thioether group, a carbonyl group, an ester group, an amide group, a urethane group and a ureylene group.

n represents an integer of 1 to 5.

Specific examples of the repeating unit having a silicon atom are set forth below, but the present invention is not limited thereto.

In specific examples, $X_1$ represents a hydrogen atom, $-CH_3$, -F or $-CF_3$.

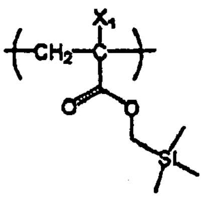
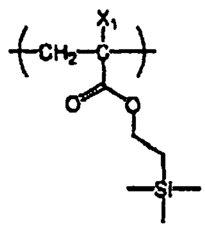
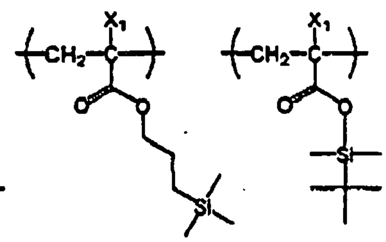
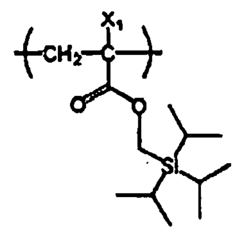

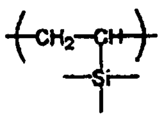
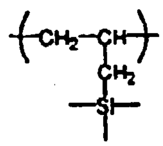
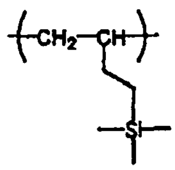
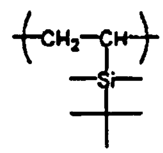
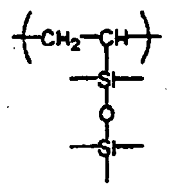

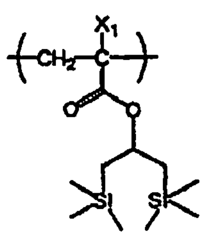
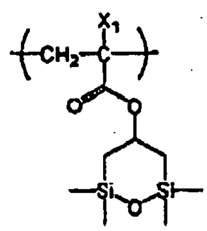
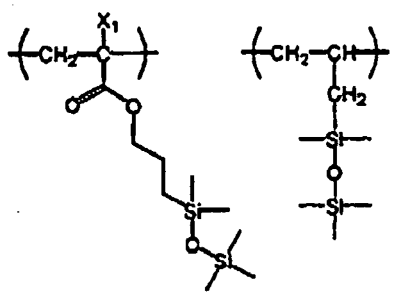
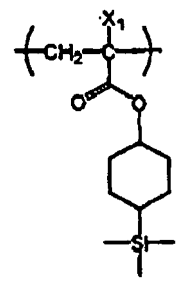

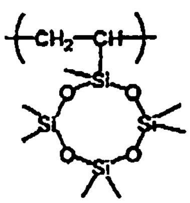
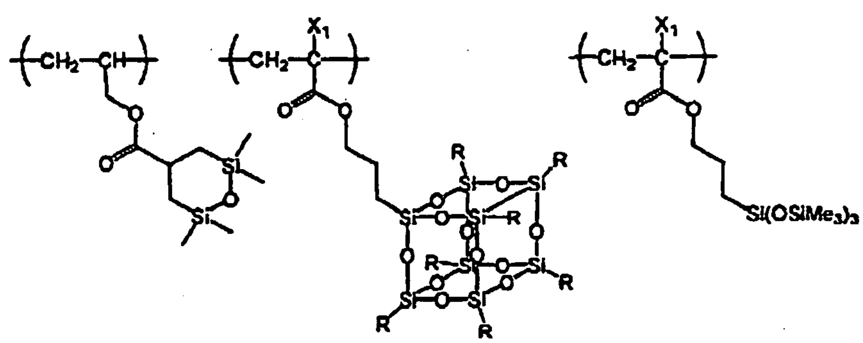

R=$CH_3$, $C_2H_5$, $C_3H_7$, $C_4H_9$

The hydrophobic resin (HR) may further contain at least one group selected from the group consisting of the following (x) to (z):

(x) an alkali-soluble group,

(y) a group which decomposes under the action of an alkali developer to increase the solubility in an alkali developer, and

(z) a group which decomposes under the action of an acid.

Examples of the (x) alkali-soluble group include groups having a phenolic hydroxyl group, a carboxylic acid group, a fluorinated alcohol group, a sulfonic acid group, a sulfonamide group, a sulfonylimide group, an (alkylsulfonyl)(alkylcarbonyl)methylene group, an (alkylsulfonyl)(alkylcarbonyl)imide group, a bis(alkylcarbonyl)methylene group, a bis(alkylcarbonyl)imide group, a bis(alkylsulfonyl)methylene group, a bis(alkylsulfonyl)-imide group, a tris(alkylcarbonyl)methylene group or a tris(alkylsulfonyl)methylene group.

Preferred alkali-soluble groups are a fluorinated alcohol group (preferably hexafluoroisopropanol), a sulfonimide group and a bis(carbonyl)methylene group.

As for the repeating unit having (x) an alkali-soluble group, all of a repeating unit where an alkali-soluble group is directly bonded to the resin main chain, such as repeating unit by an acrylic acid or a methacrylic acid, a repeating unit where an alkali-soluble group is bonded to the resin main chain through a linking group, and a repeating unit where an alkali-soluble group is introduced into the polymer chain terminal by using an alkali-soluble group-containing polymerization initiator or chain transfer agent at the polymerization, are preferred.

The content of the repeating unit having (x) an alkali-soluble group is preferably from 1 to 50 mol%, more preferably from 3 to 35 mol%, still more preferably from 5 to 20 mol%, based on all repeating units in the polymer.

Specific examples of the repeating unit having (x) an alkali-soluble group are set forth below, but the present invention is not limited thereto.

In the formulae, Rx represents H, $CH_3$, $CF_3$ or $CH_2OH$.

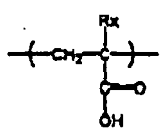
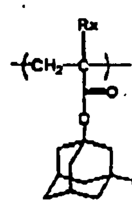
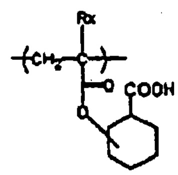
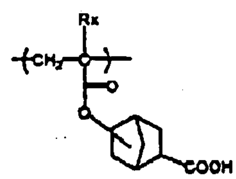

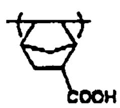
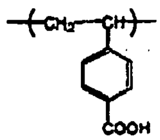
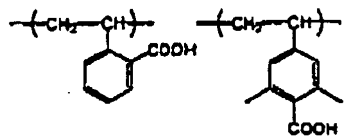
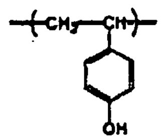

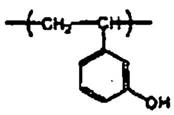
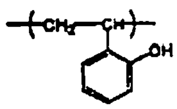
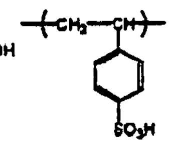
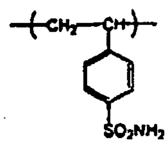
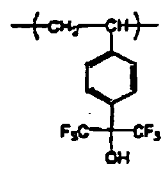

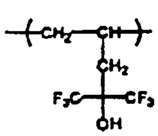
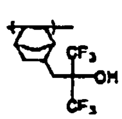
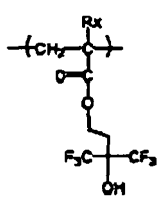
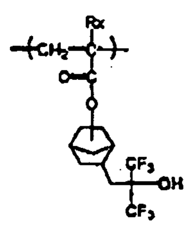

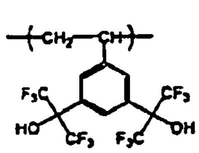
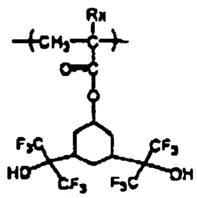
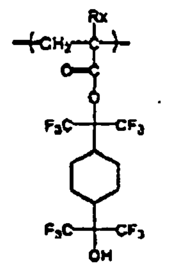
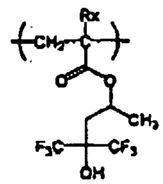

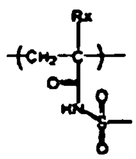
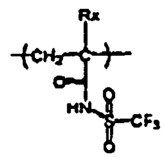
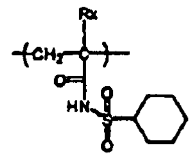
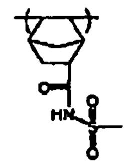
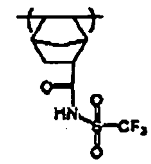

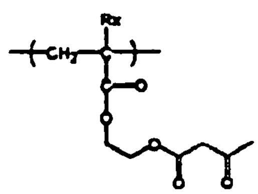
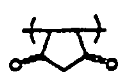
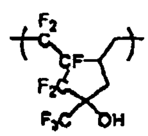

Examples of the (y) group which decomposes under the action of an alkali developer to increase the solubility in an alkali developer include a lactone structure-containing group, an acid anhydride and an acid imide group, with a lactone group being preferred.

As for the repeating unit having (y) a group which decomposes under the action of an alkali developer to increase the solubility in an alkali developer, both a repeating unit where (y) a group which decomposes under the action of an alkali developer to increase the solubility in an alkali developer is bonded to the resin main chain, such as repeating unit by an acrylic acid ester or a methacrylic acid ester, and a repeating unit where (y) a group capable of increasing the solubility in an alkali developer is introduced into the polymer chain terminal by using a polymerization initiator or chain transfer agent having the group at the polymerization, are preferred.

The content of the repeating unit having (y) a group capable of increasing the solubility in an alkali developer is preferably from 1 to 40 mol%, more preferably from 3 to 30 mol%, still more preferably from 5 to 15 mol%, based on all repeating units in the polymer.

Specific examples of the repeating unit having (y) a group capable of increasing the solubility in an alkali developer are the same as those of the repeating unit having a lactone structure described for the resin as the component (B).

Examples of the repeating unit having (z) a group which decomposes under the action of an acid, contained in the hydrophobic resin (HR), are the same as those of the repeating unit having an acid-decomposable group described for the resin as the component (B). In the hydrophobic resin (HR), the content of the repeating unit having (z) a group which decomposes under the action of an acid is preferably from 1 to 80 mol%, more preferably from 10 to 80 mol%, still more preferably from 20 to 60 mol%, based on all repeating units in the polymer.

The hydrophobic resin (HR) may further contain a repeating unit represented by the following formula (III).

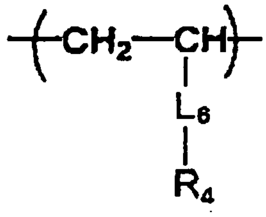

(III)

In formula (III), $R_4$ represents a group having an alkyl group, a cycloalkyl group, an alkenyl group or a cycloalkenyl group.

$L_6$ represents a single bond or a divalent linking group.

In formula (III), the alkyl group of $R_4$ is preferably a linear or branched alkyl group having a carbon number of 3 to 20.

The cycloalkyl group is preferably a cycloalkyl group having a carbon number of 3 to 20.

The alkenyl group is preferably an alkenyl group having a carbon number of 3 to 20.

The cycloalkenyl group is preferably a cycloalkenyl group having a carbon number of 3 to 20.

The divalent linking group of $L_6$ is preferably an alkylene group (preferably having a carbon number of 1 to 5) or an oxy group.

In the case where the hydrophobic resin (HR) contains a fluorine atom, the fluorine atom content is preferably from 5 to 80 mass%, more preferably from 10 to 80 mass%, based on the molecular weight of the hydrophobic resin (HR). Also, the fluorine atom-containing repeating unit preferably occupies from 10 to 100 mass%, more preferably from 30 to 100 mass%, in the hydrophobic resin (HR).

In the case where the hydrophobic resin (HR) contains a silicon atom, the silicon atom content is preferably from 2 to 50 mass%, more preferably from 2 to 30 mass%, based on the molecular weight of the hydrophobic resin (HR). Also, the silicon atom-containing repeating unit preferably occupies from 10 to 100 mass%, more preferably from 20 to 100 mass%, in the hydrophobic resin (HR).

The standard polystyrene-reduced weight average molecular of the hydrophobic resin (HR) is preferably from 1,000 to 100,000, more preferably from 1,000 to 50,000, still more preferably from 2,000 to 15,000.

Similarly to the resin as the component (B), it is of course preferred that the hydrophobic resin (HR) has less impurities such as metal. In addition, the content of the residual monomers or oligomer components is preferably from 0 to 10 mass%, more preferably from 0 to 5 mass%, still more preferably from 0 to 1 mass%. When these conditions are satisfied, a resist free from foreign matters in liquid or change in the sensitivity and the like with aging can be obtained. Also, in view of the resolution, resist profile, and side wall, roughness or the like of the resist pattern, the molecular weight distribution (Mw/Mn, sometimes referred to as "dispersity") is preferably from 1 to 5, more preferably from 1 to 3, still more preferably from 1 to 2.

As for the hydrophobic resin (HR), various commercially available products may be used or the resin may be synthesized by an ordinary method (for example, radical polymerization)). Examples of the synthesis method in general include a batch polymerization method of dissolving monomer species and an initiator in a solvent and heating the solution, thereby effecting the polymerization, and a dropping polymerization method of adding dropwise a solution containing monomer species and an initiator to a heated solvent over 1 to 10 hours. A dropping polymerization method is preferred. Examples of the reaction solvent include tetrahydrofuran, 1,4-dioxane, ethers such as diisopropyl ether, ketones such as methyl ethyl ketone and methyl isobutyl ketone, an ester solvent such as ethyl acetate, an amide solvent such as dimethylformamide and dimethylacetamide, and a solvent capable of dissolving the composition of the present invention, which is described later, such as propylene glycol monomethyl ether acetate, propylene glycol monomethyl ether and cyclohexanone. The polymerization is more preferably performed using the same solvent as the solvent used in the positive resist composition of the present invention. By the use of this solvent, generation of particles during storage can be suppressed.

The polymerization reaction is preferably performed in an inert gas atmosphere such as nitrogen and argon. As for the polymerization initiator, the polymerization is initiated using a commercially available radical initiator (e.g., azo-based initiator, peroxide). The radical initiator is preferably an azo-based initiator, and an azo-based initiator having an ester group, a cyano group or a carboxyl group is preferred. Preferred examples of the initiator include azobisisobutyronitrile, azobisdimethylvaleronitrile and dimethyl 2,2'-azobis(2-methyl-propionate). The reaction concentration is from 5 to 50 mass%, preferably from 30 to 50 mass%, and the reaction temperature is usually from 10 to 150°C, preferably from 30 to 120°C, more preferably from 60 to 100°C.

After the completion of reaction, the reaction product is allowed to cool to room temperature and purified. The

purification may be performed by a normal method, for example, a liquid-liquid extraction method of applying water washing or combining an appropriate solvent to remove residual monomers or oligomer components, a purification method in a solution sate, such as ultrafiltration of removing by extraction only polymers having a molecular weight lower than a specific molecular weight, a reprecipitation method of adding dropwise the resin solution in a bad solvent to solidify the resin in the bad solvent and thereby remove residual monomers or the like, or a purification method in a solid state, such as a method of separating the resin slurry by filtration and washing it with a bad solvent. For example, the resin is precipitated as a solid through contact with a solvent in which the resin is sparingly soluble or insoluble (bad solvent) and which is in a volume amount of 10 times or less, preferably from 10 to 5 times, the reaction solution.

The solvent used at the operation of precipitation or reprecipitation from the polymer solution (precipitation or reprecipitation solvent) may be sufficient if it is a bad solvent to the polymer, and the solvent used may be appropriately selected, for example, from a hydrocarbon, a halogenated hydrocarbon, a nitro compound, an ether, a ketone, an ester, a carbonate, an alcohol, a carboxylic acid, water, and a mixed solvent containing such a solvent according to the kind of the polymer. Among these solvents, the precipitation or reprecipitation solvent is preferably a solvent containing at least an alcohol (particularly methanol or the like) or water.

The amount of the precipitation or reprecipitation solvent used may be appropriately selected by taking into consideration the efficiency, yield and the like, but the amount used is generally from 100 to 10,000 parts by mass, preferably from 200 to 2,000 parts by mass, more preferably from 300 to 1,000 parts by mass, per 100 parts by mass of the polymer solution.

The temperature at the precipitation or reprecipitation may be appropriately selected by taking into consideration the efficiency or operability, but the temperature is usually on the order of 0 to 50˚C, preferably in the vicinity of room temperature (for example, approximately from 20 to 35˚C). The precipitation or reprecipitation operation may be performed using a commonly employed mixing vessel such as stirring tank, by a known method such as batch system or continuous system.

The precipitated or reprecipitated polymer is usually subjected to commonly employed solid-liquid separation such as filtration and centrifugation, then dried and used. The filtration is performed using a solvent-resistant filter element preferably under pressure. The drying is performed under atmospheric pressure or reduced pressure (preferably under reduced pressure) at a temperature of approximately from 30 to 100˚C, preferably on the order of 30 to 50˚C.

Incidentally, the resin after once precipitated and separated may be again dissolved in a solvent and then put into contact with a solvent in which the resin is sparingly soluble or insoluble. More specifically, there may be used a method comprising, after the completion of radical polymerization reaction, bringing the polymer into contact with a solvent in which the polymer is sparingly soluble or insoluble, to precipitate a resin (step a), separating the resin from the solution (step b), anew dissolving the resin in a solvent to prepare a resin solution A (step c), bringing the resin solution A into contact with a solvent in which the resin is sparingly soluble or insoluble and which is in a volume amount of less than 10 times (preferably in a volume amount of 5 times or less) the resin solution A, to precipitate a resin solid (step d), and separating the precipitated resin (step e).

Specific examples of the hydrophobic resin (HR) are set forth below. Also, the molar ratio of repeating units (corresponding to respective repeating units from the left), weight average molecular weight and dispersity of each resin are shown in Table 1 below.

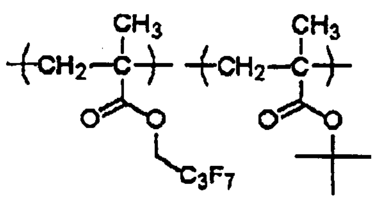

(HR-1)

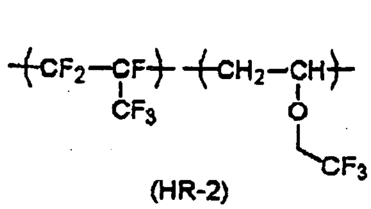

(HR-2)

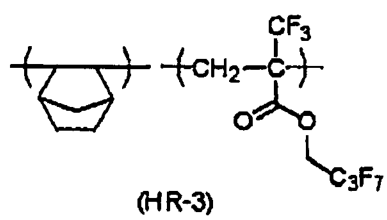

(HR-3)

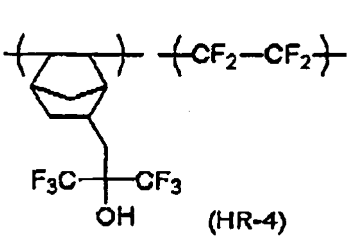
(HR-4)

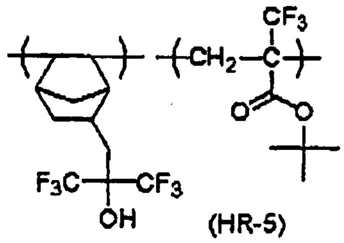
(HR-5)

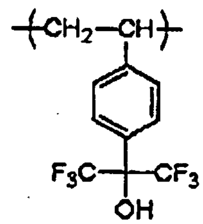
(HR-6)

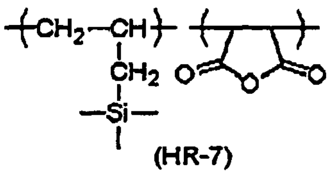
(HR-7)

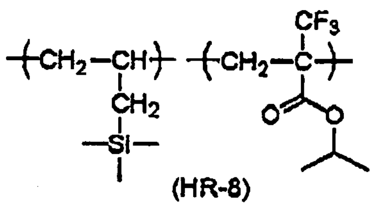
(HR-8)

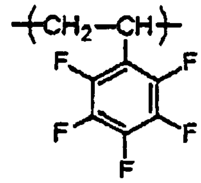
(HR-9)

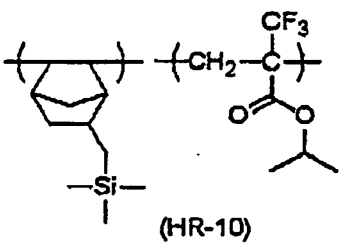
(HR-10)

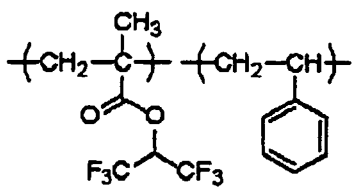
(HR-11)

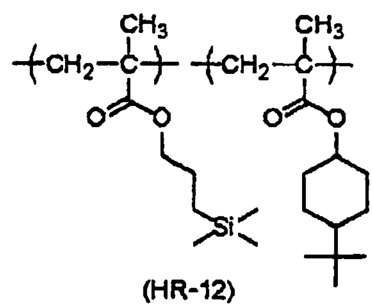
(HR-12)

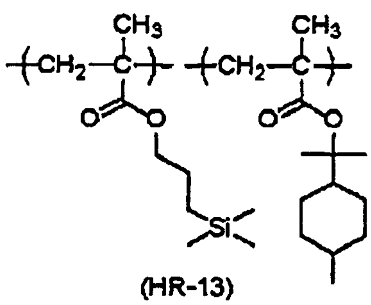
(HR-13)

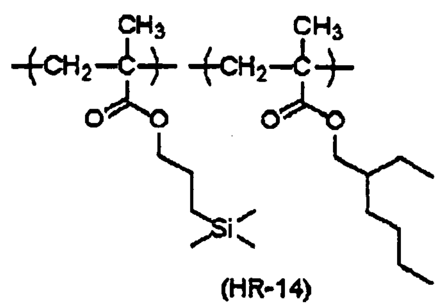
(HR-14)

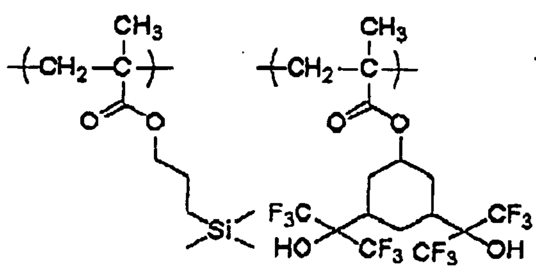
(HR-15)

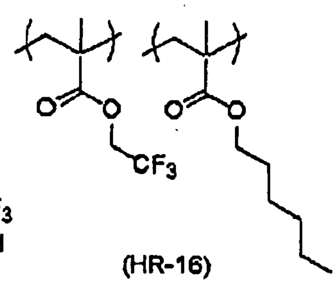
(HR-16)

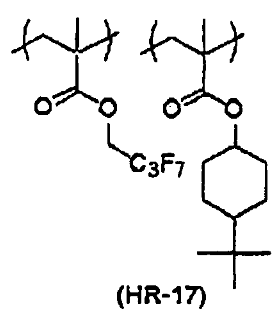
(HR-17)

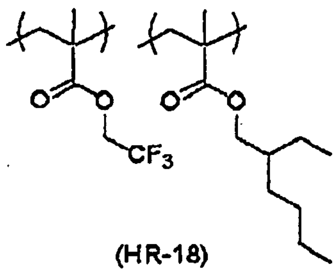
(HR-18)

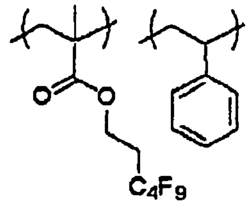
(HR-19)

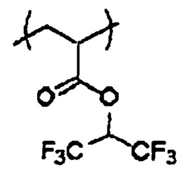
(HR-20)

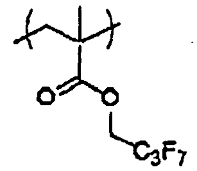
(HR-21)

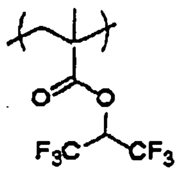
(HR-22)

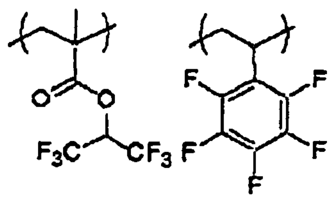
(HR-23)

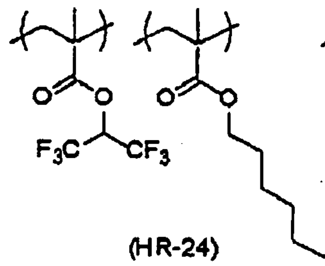
(HR-24)

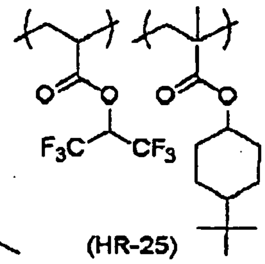
(HR-25)

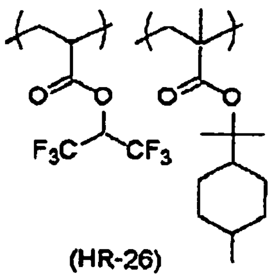
(HR-26)

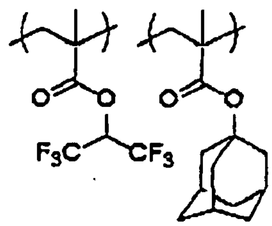
(HR-27)

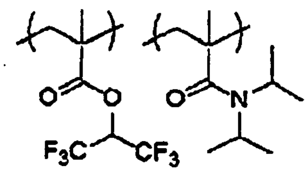
(HR-28)

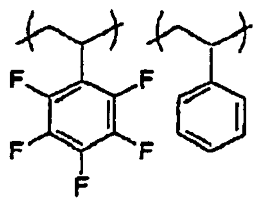
(HR-29)

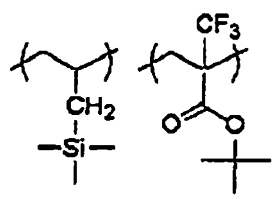
(HR-30)

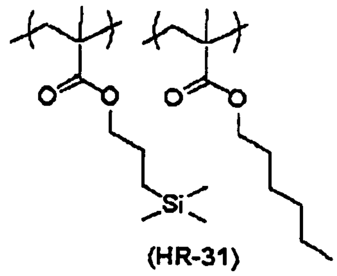
(HR-31)

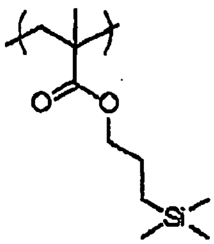

(HR-32)

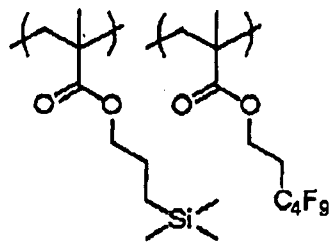

(HR-33)

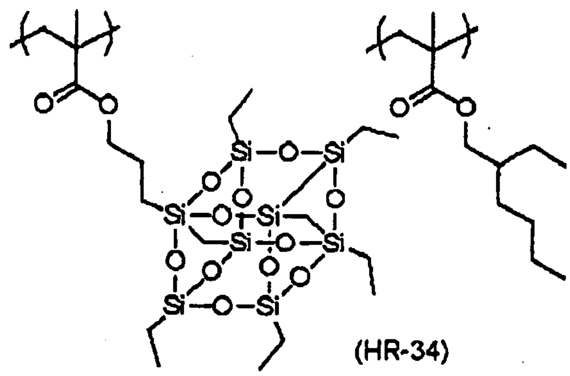

(HR-34)

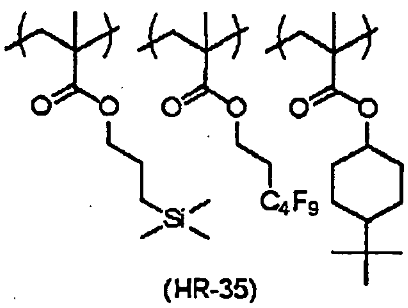

(HR-35)

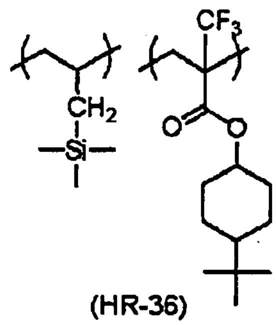

(HR-36)

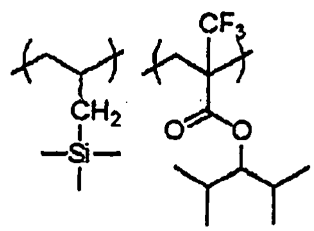

(HR-37)

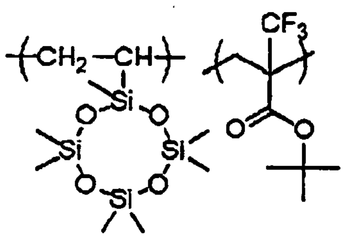

(HR-38)

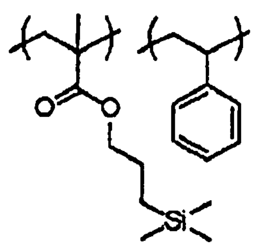

(HR-39)

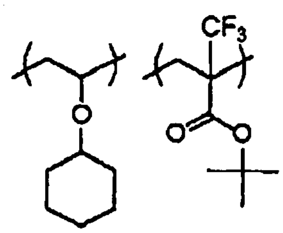

(HR-40)

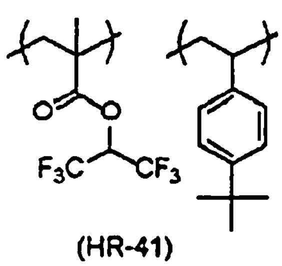

(HR-41)

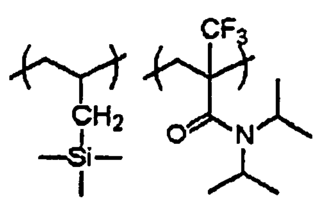

(HR-42)

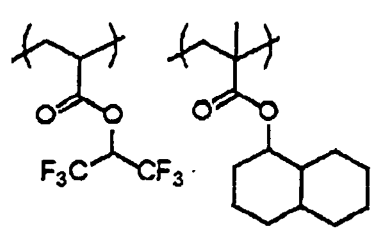

(HR-43)

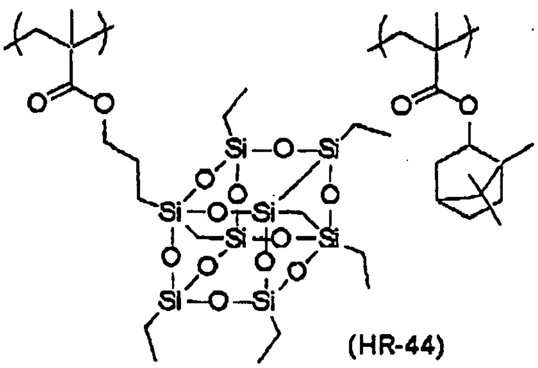

(HR-44)

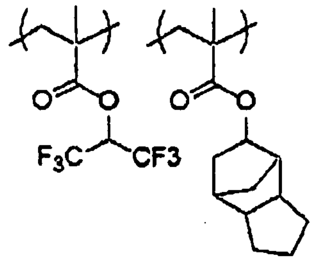

(HR-45)

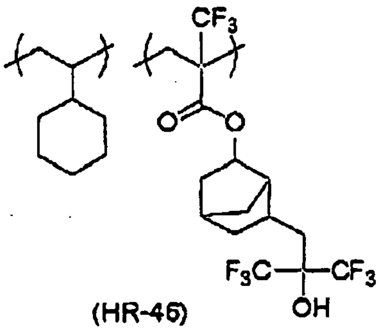

(HR-46)

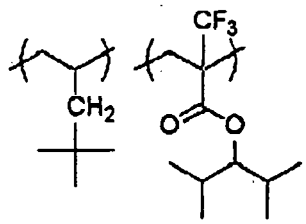

(HR-47)

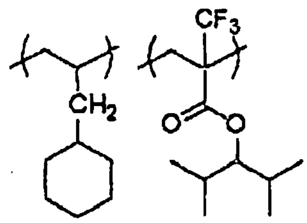

(HR-48)

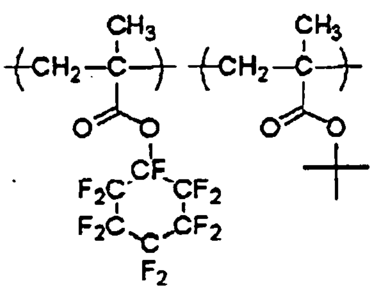

(HR-49)

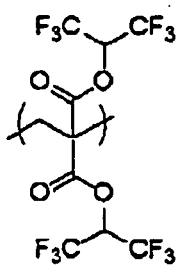

(HR-50)

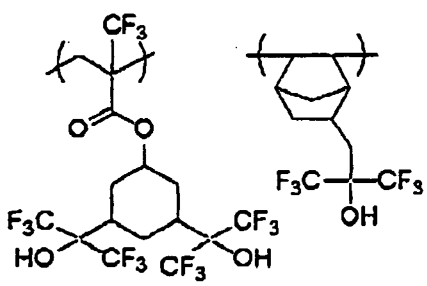

(HR-51)

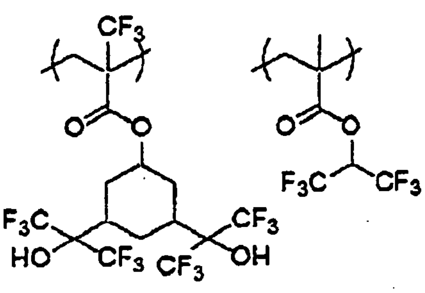

(HR-52)

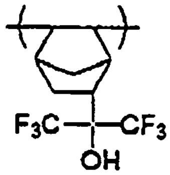

(HR-53)

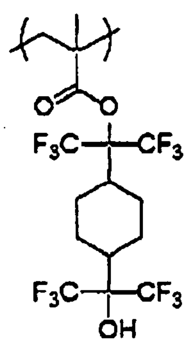

(HR-54)

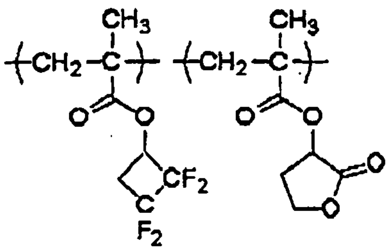

(HR-55)

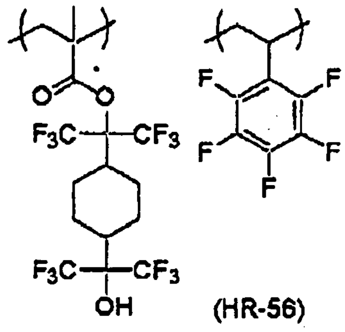

(HR-56)

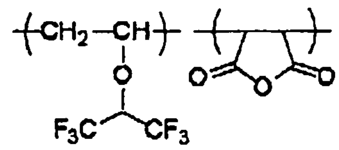

(HR-57)

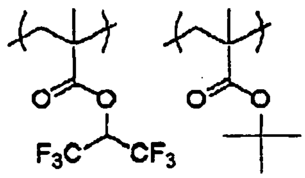

(HR-58)

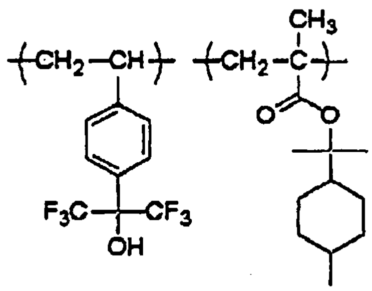

(HR-59)

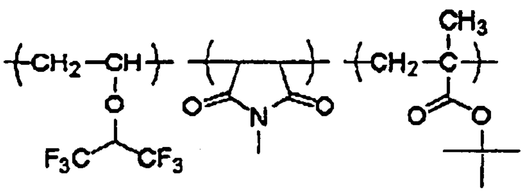

(HR-60)

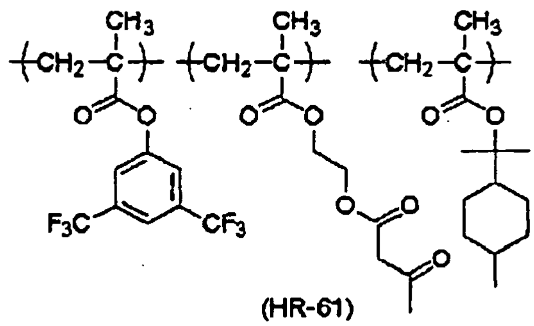

(HR-61)

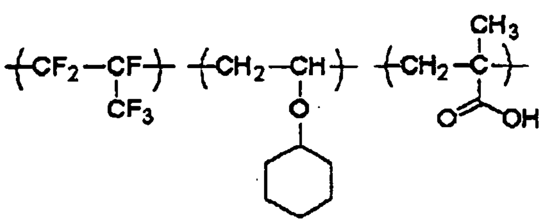

(HR-62)

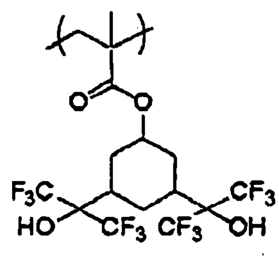

(HR-63)

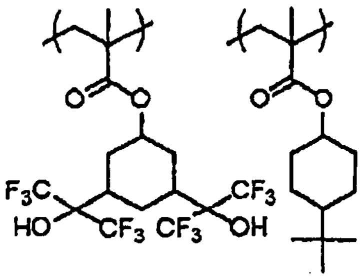

(HR-64)

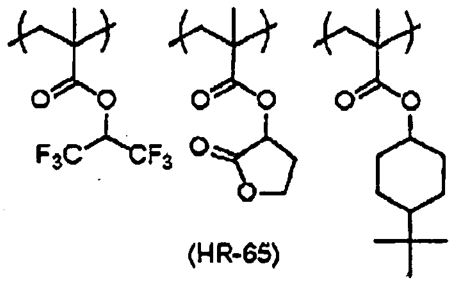

(HR-65)

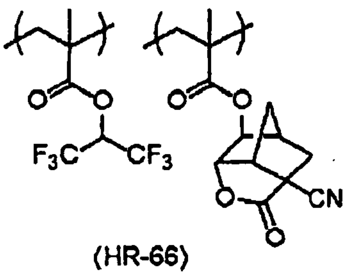

(HR-66)

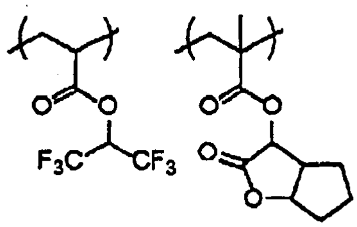

(HR-67)

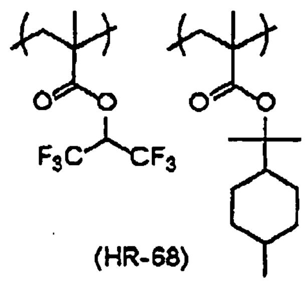

(HR-68)

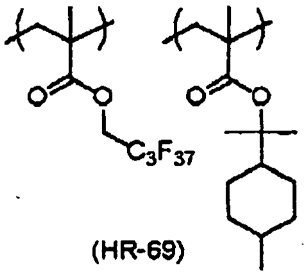

(HR-69)

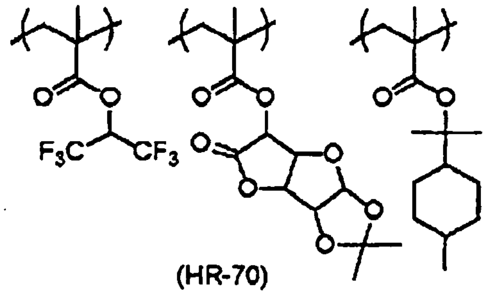

(HR-70)

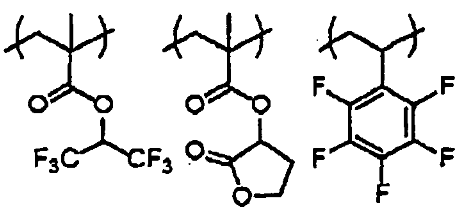

(HR-71)

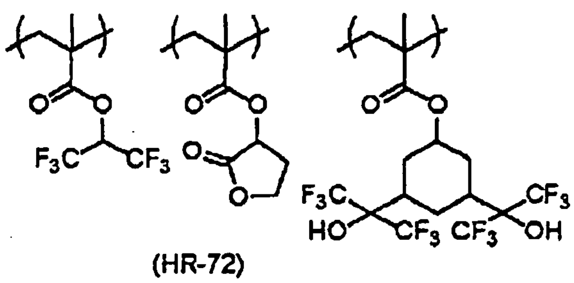

(HR-72)

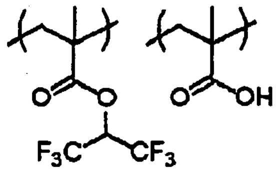

(HR-73)

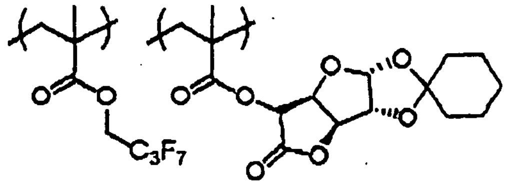

(HR-74)

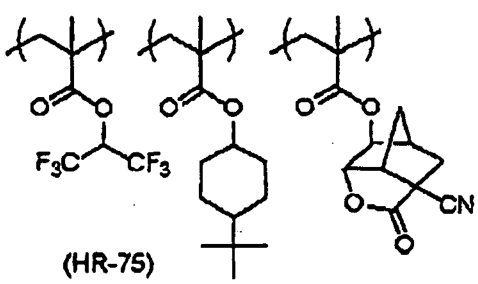

(HR-75)

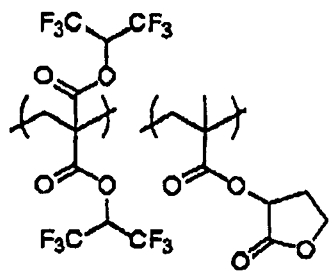

(HR-76)

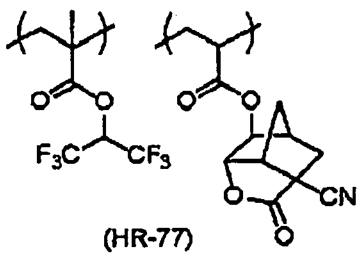

(HR-77)

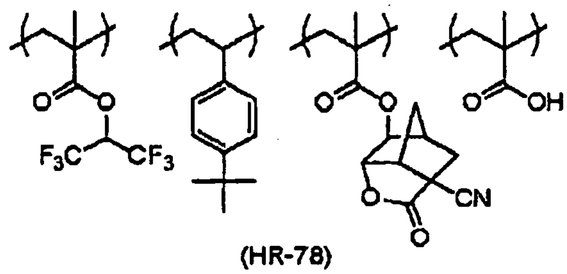

(HR-78)

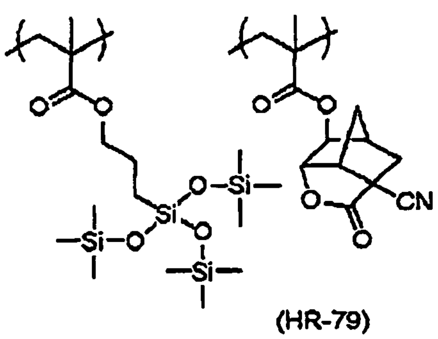

(HR-79)

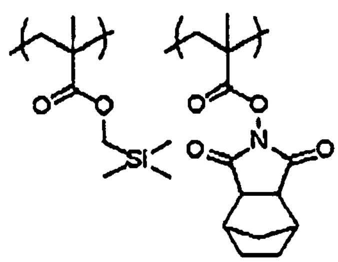

(HR-80)

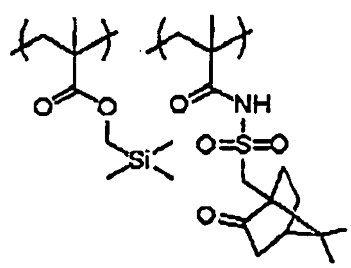

(HR-81)

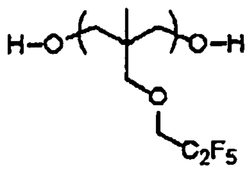

(HR-82)

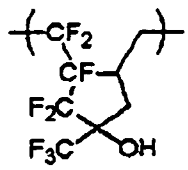

(HR-83)

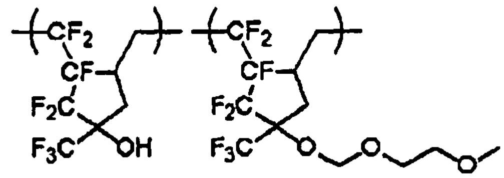

(HR-84)

Table 1

| Resin | Composition | Mw | Mw/Mn | Resin | Composition | Mw | Mw/Mn |
|---|---|---|---|---|---|---|---|
| HR-1 | 50/50 | 8800 | 2.1 | HR-51 | 60/40 | 8800 | 1.5 |
| HR-2 | 50/50 | 5200 | 1.8 | HR-52 | 68/32 | 11000 | 1.7 |
| HR-3 | 50/50 | 4800 | 1.9 | HR-53 | 100 | 8000 | 1.4 |
| HR-4 | 50/50 | 5300 | 1.9 | HR-54 | 100 | 8500 | 1.4 |
| HR-5 | 50/50 | 6200 | 1.9 | HR-55 | 80/20 | 13000 | 2.1 |
| HR-6 | 100 | 12000 | 2.0 | HR-56 | 70/30 | 18000 | 2.3 |
| HR-7 | 50/50 | 5800 | 1.9 | HR-57 | 50/50 | 5200 | 1.9 |
| HR-8 | 50/50 | 6300 | 1.9 | HR-58 | 50/50 | 10200 | 2.2 |
| HR-9 | 100 | 5500 | 2.0 | HR-59 | 60/40 | 7200 | 2.2 |
| HR-10 | 50/50 | 7500 | 1.9 | HR-60 | 32/32/36 | 5600 | 2.0 |
| HR-11 | 70/30 | 10200 | 2.2 | HR-61 | 30/30/40 | 9600 | 1.6 |
| HR-12 | 40/60 | 15000 | 2.2 | HR-62 | 40/40/20 | 12000 | 2.0 |
| HR-13 | 40/60 | 13000 | 2.2 | HR-63 | 100 | 6800 | 1.6 |
| HR-14 | 80/20 | 11000 | 2.2 | HR-64 | 50/50 | 7900 | 1.9 |
| HR-15 | 60/40 | 9800 | 2.2 | HR-65 | 40/30/30 | 5600 | 2.1 |
| HR-16 | 50/50 | 8000 | 2.2 | HR-66 | 50/50 | 6800 | 1.7 |
| HR-17 | 50/50 | 7600 | 2.0 | HR-67 | 50/50 | 5900 | 1.6 |
| HR-18 | 50/50 | 12000 | 2.0 | HR-68 | 49/51 | 6200 | 1.8 |
| HR-19 | 20/80 | 6500 | 1.8 | HR-69 | 50/50 | 8000 | 1.9 |
| HR-20 | 100 | 6500 | 1.2 | HR-70 | 30/40/30 | 9600 | 2.3 |
| HR-21 | 100 | 6000 | 1.6 | HR-71 | 30/40/30 | 9200 | 2.0 |
| HR-22 | 100 | 2000 | 1.6 | HR-72 | 40/29/31 | 3200 | 2.1 |
| HR-23 | 50/50 | 6000 | 1.7 | HR-73 | 90/10 | 6500 | 2.2 |
| HR-24 | 50/50 | 8800 | 1.9 | HR-74 | 50/50 | 7900 | 1.9 |
| HR-25 | 50/50 | 7800 | 2.0 | HR-75 | 20/30/50 | 10800 | 1.6 |
| HR-26 | 50/50 | 8000 | 2.0 | HR-76 | 50/50 | 2200 | 1.9 |
| HR-27 | 80/20 | 8000 | 1.8 | HR-77 | 50/50 | 5900 | 2.1 |
| HR-28 | 30/70 | 7000 | 1.7 | HR-78 | 40/20/30/10 | 14000 | 2.2 |

(continued)

| Resin | Composition | Mw | Mw/Mn | | Resin | Composition | Mw | Mw/Mn |
|---|---|---|---|---|---|---|---|---|
| HR-29 | 50/50 | 6500 | 1.6 | | HR-79 | 50/50 | 5500 | 1.8 |
| HR-30 | 50/50 | 6500 | 1.6 | | HR-80 | 50/50 | 10600 | 1.9 |
| HR-31 | 50/50 | 9000 | 1.8 | | HR-81 | 50/50 | 8600 | 2.3 |
| HR-32 | 100 | 10000 | 1.6 | | HR-82 | 100 | 15000 | 2.1 |
| HR-33 | 70/30 | 8000 | 2.0 | | HR-83 | 100 | 6900 | 2.5 |
| HR-34 | 10/90 | 8000 | 1.8 | | HR-84 | 50/50 | 9900 | 2.3 |
| HR-35 | 30/30/40 | 9000 | 2.0 | | | | | |
| HR-36 | 50/50 | 6000 | 1.4 | | | | | |
| HR-37 | 50/50 | 5500 | 1.5 | | | | | |
| HR-38 | 50/50 | 4800 | 1.8 | | | | | |
| HR-39 | 60/40 | 5200 | 1.8 | | | | | |
| HR-40 | 50/50 | 8000 | 1.5 | | | | | |
| HR-41 | 20/80 | 7500 | 1.8 | | | | | |
| HR-42 | 50/50 | 6200 | 1.6 | | | | | |
| HR-43 | 60/40 | 16000 | 1.8 | | | | | |
| HR-44 | 80/20 | 10200 | 1.8 | | | | | |
| HR-45 | 50/50 | 12000 | 2.6 | | | | | |
| HR-46 | 50/50 | 10900 | 1.9 | | | | | |
| HR-47 | 50/50 | 6000 | 1.4 | | | | | |
| HR-48 | 50/50 | 4500 | 1.4 | | | | | |
| HR-49 | 50/50 | 6900 | 1.9 | | | | | |
| HR-50 | 100 | 2300 | 2.6 | | | | | |

<Solvent>

Examples of the solvent which can be used at the time of preparing a positive resist composition by dissolving respective components described above include an organic solvent such as alkylene glycol monoalkyl ether carboxylate, alkylene glycol monoalkyl ether, alkyl lactate, alkyl alkoxypropionate, cyclic lactone having a carbon number of 4 to 10, monoketone compound having a carbon number of 4 to 10, which may contain a ring, alkylene carbonate, alkyl alkoxyacetate and alkyl pyruvate.

Preferred examples of the alkylene glycol monoalkyl ether carboxylate include propylene glycol monomethyl ether acetate, propylene glycol monoethyl ether acetate, propylene glycol monopropyl ether acetate, propylene glycol monobutyl ether acetate, propylene glycol monomethyl ether propionate, propylene glycol monoethyl ether propionate, ethylene glycol monomethyl ether acetate and ethylene glycol monoethyl ether acetate.

Preferred examples of the alkylene glycol monoalkyl ether include propylene glycol monomethyl ether, propylene glycol monoethyl ether, propylene glycol monopropyl ether, propylene glycol monobutyl ether, ethylene glycol monomethyl ether and ethylene glycol monoethyl ether.

Preferred examples of the alkyl lactate include methyl lactate, ethyl lactate, propyl lactate and butyl lactate.

Preferred examples of the alkyl alkaxypropionate include ethyl 3-ethoxypropionate, methyl 3-methoxypropionate, methyl 3-ethoxypropionate and ethyl 3-methoxypropionate.

Preferred examples of the cyclic lactone having a carbon number of 4 to 10 include β-propiolactone, β-butyrolactone, γ-butyrolactone, α-methyl-γ-butyrolactone, β-methyl-γ-butyrolactone, γ-valerolactone, γ-caprolactone, γ-octanoic lactone and α-hydroxy-γ-butyrolactone.

Preferred examples of the monoketone compound having a carbon number of 4 to 10, which may contain a ring, include 2-butanone, 3-methylbutanone, pinacolone, 2-pentanone, 3-pentanone, 3-methyl-2-pentanone, 4-methyl-2-pentanone, 2-methyl-3-pentanone, 4,4-dimethyl-2-pentanone, 2,4-dimethyl-3-pentanone, 2,2,4,4-tetramethyl-3-pentanone, 2-hexanone, 3-hexanone, 5-methyl-3-hexanone, 2-heptanone, 3-heptanone, 4-heptanone, 2-methyl-3-heptanone, 5-methyl-3-heptanone, 2,6-dimethyl-4-heptanone, 2-octanone, 3-octanone, 2-nonanone, 3-nonanone, 5-nonanone, 2-decanone, 3-decanone, 4-decanone, 5-hexen-2-one, 3-penten-2-one, cyclopentanone, 2-methylcyclopentanone, 3-methylcyclopentanone, 2,2-dimethylcyclopentanone, 2,4,4-trimethylcyclopentanone, cyclohexanone, 3-methylcyclohexanone, 4-methylcyclohexanone, 4-ethylcyclohexanone, 2,2-dimethylcyclohexanone, 2,6-dimethylcyclohexanone, 2,2,6-trimethylcyclohexanone, cycloheptanone, 2-methylcycloheptanone and 3-methylcycloheptanone.

Preferred examples of the alkylene carbonate include propylene carbonate, vinylene carbonate, ethylene carbonate and butylene carbonate.

Preferred examples of the alkyl alkoxyacetate include 2-methoxyethyl acetate, 2-ethoxyethyl acetate, 2-(2-ethoxyethoxy)ethyl acetate, 3-methoxy-3-methylbutyl acetate and 1-methoxy-2-propyl acetate,

Preferred examples of the alkyl pyruvate include methyl pyruvate, ethyl pyruvate and propyl pyruvate.

The solvent which can be preferably used is a solvent having a boiling point of 130˚C or more at ordinary temperature under atmospheric pressure, and specific examples thereof include cyclopentanone, γ-butyrolactone, cyclohexanone, ethyl lactate, ethylene glycol monoethyl ether acetate, propylene glycol monomethyl ether acetate, ethyl 3-ethoxypropionate, ethyl pyruvate, 2-ethoxyethyl acetate, 2-(2-ethoxyethoxy)ethyl acetate and propylene carbonate.

In the present invention, one of these solvents may be used alone, or two or more thereof may be used in combination.

In the present invention, a mixed solvent prepared by mixing a solvent containing a hydroxyl group in the structure and a solvent not containing a hydroxyl group may be used as the organic solvent.

Examples of the solvent containing a hydroxyl group include ethylene glycol, ethylene glycol monomethyl ether, ethylene glycol monoethyl ether, propylene glycol, propylene glycol monomethyl ether, propylene glycol monoethyl ether and ethyl lactate. Among these, propylene glycol monomethyl ether and ethyl lactate are preferred.

Examples of the solvent not containing a hydroxyl group include propylene glycol monomethyl ether acetate, ethyl ethoxypropionate, 2-heptanone, γ-butyrolactone, cyclohexanone, butyl acetate, N-methylpyrrolidone, N,N-dimethylacetamide and dimethylsulfoxide. Among these, propylene glycol monomethyl ether acetate, ethyl ethoxypropionate, 2-heptanone, γ-butyrolactone, cyclohexanone and butyl acetate are preferred, and propylene glycol monomethyl ether acetate, ethyl ethoxypropionate and 2-heptanone are most preferred.

The mixing ratio (by mass) of the solvent containing a hydroxyl group and the solvent not containing a hydroxyl group is from 1/99 to 99/1, preferably from 10/90 to 90/10, more preferably from 20/80 to 60/40. A mixed solvent in which the solvent not containing a hydroxyl group is contained in an amount of 50 mass% or more is preferred in view of coating uniformity.

The solvent is preferably a mixed solvent of two or more species including propylene glycol monomethyl ether acetate.

<Basic Compound>

The positive resist composition of the present invention preferably contains a basic compound for reducing the change of performance with aging from exposure until heating.

Preferred examples of the basic compound include compounds having structures represented by the following formulae (A) to (E).

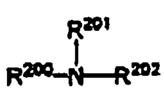
(A)

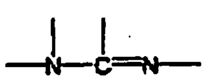
(B)

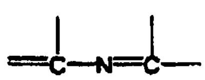
(C)

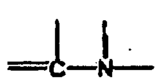
(D)

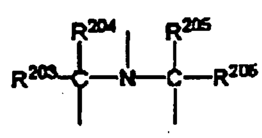
(E)

In formulae (A) and (E), $R^{200}$, $R^{201}$ and $R^{202}$, which may be the same or different, each represents a hydrogen atom, an alkyl group (preferably having a carbon number of 1 to 20), a cycloalkyl group (preferably having a carbon number of 3 to 20) or an aryl group (having a carbon number of 6 to 20), and $R^{201}$ and $R^{202}$ may combine with each other to form a ring.

As for the alkyl group, the alkyl group having a substituent is preferably an aminoalkyl group having a carbon number of 1 to 20, a hydroxyalkyl group having a carbon number of 1 to 20, or a cyanoalkyl group having a carbon number of 1 to 20.

$R^{203}$, $R^{204}$, $R^{205}$ and $R^{206}$, which may be the same or different, each represents an alkyl group having a carbon number of 1 to 20.

The alkyl group in these formulae (A) and (E) is more preferably unsubstituted.

Preferred examples of the compound include guanidine, aminopyrrolidine, pyrazole, pyrazoline, piperazine, aminomorpholine, aminoalkylmorpholine and piperidine. More preferred examples of the compound include a compound having an imidazole structure, a diazabicyclo structure, an onium hydroxide structure, an onium carboxylate structure, a trialkylamine structure, an aniline structure or a pyridine structure; an alkylamine derivative having a hydroxyl group and/or an ether bond; and an aniline derivative having a hydroxyl group and/or an ether bond.

Examples of the compound having an imidazole structure include imidazole, 2,4,5-triphenylimidazole and benzimidazole. Examples of the compound having a diazabicyclo structure include 1,4-diazabicyclo[2,2,2]octane, 1,5-diazabicyclo[4,3,0]non-5-ene and 1,8-diazabicyclo[5,4,0]undec-7-ene. Examples of the compound having an onium hydroxide structure include triarylsulfonium hydroxide, phenacylsulfonium hydroxide and sulfonium hydroxide having a 2-oxoalkyl group, specifically, tripheaylsulfonium hydroxide, tris(tert-butylphenyl)sulfonium hydroxide, bis(tert-butylphenyl)iodonium hydroxide, phenacylthiophenium hydroxide and 2-oxopropylthiophenium hydroxide. Examples of the compound having an onium carboxylate structure include a compound where the anion moiety of the compound having an onium hydroxide structure is converted into a carboxylate, such as acetate, adamantane-1-carboxylate and perfluoroalkyl carboxylate. Examples of the compound having a trialkylamine structure include tri(n-butyl)amine and tri(n-octyl)amine. Examples of the aniline compound include 2,6-diisopropylaniline, N,N-dimethylaniline, N,N-dibutylaniline and N,N-dihexylaniline. Examples of the alkylamine derivative having a hydroxyl group and/or an ether bond include ethanolamine, diethanolamine, triethanolamine and tris(methoxyethoxyethyl)amine. Examples of the aniline derivative having a hydroxyl group and/or an ether bond include N,N-bis(hydroxyethyl)aniline.

One of these basic compounds is used alone, or two or more thereof are used in combination.

The amount of the basic compound used is usually from 0.001 to 10 mass%, preferably from 0.01 to 5 mass%, based on the solid content of the positive resist composition.

The ratio of the acid generator and the basic compound used in the composition is preferably acid generator/basic compound (by mol) = from 2.5 to 300. That is, the molar ratio is preferably 2.5 or more in view of sensitivity and resolution and preferably 300 or less from the standpoint of suppressing the reduction in resolution due to thickening of the resist pattern with aging after exposure until heat treatment. The acid generator/basic compound (by mol) is more preferably from 5.0 to 200, still more preferably from 7.0 to 150.

<Surfactant>

The positive resist composition of the present invention preferably further contains a surfactant, more preferably any one fluorine-containing and/or silicon-containing surfactant (a fluorine-containing surfactant, a silicon-containing surfactant or a surfactant containing both a fluorine atom and a silicon atom) or two or more species thereof.

When the positive resist composition of the present invention contains the above-described surfactant, a resist pattern with good sensitivity, resolution and adhesion as well as less development defects can be obtained on use of an exposure light source of 250 nm or less, particularly 220 nm or less.

Examples of the fluorine-containing and/or silicon-containing surfactant include surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, JP-A-2002-277862 and U.S. Patents 5,405,720, 5,360,692, 5,529,881, 5,296,330, 5,436,098, 5,576,143, 5,294,511 and 5,824,451. The following commercially available surfactants each may also be used as it is.

Examples of the commercially available surfactant which can be used include a fluorine-containing surfactant and a silicon-containing surfactant, such as EFtop EF301 and EF303 (produced by Shin-Akita Kasei K.K.); Florad FC430, 431 and 4430 (produced by Sumitomo 3M Inc.); Megafac F171, F173, F176, F189, F113, F110, F177, F120 and R08 (produced by Dainippon Ink & Chemicals, Inc.); Surflon S-382, SC101, 102, 103, 104, 105 and 106 (produced by Asahi Glass Co., Ltd.); Troysol S-366 (produced by Troy Chemical); GF-300 and GF-150 (produced by Toagosei Chemical Industry Co., Ltd); Surflon S-393 (produced by Seimi Chemical Co., Ltd.); Eftop EF121, EF122A, EF122B, RF122C, EF125M, EF135M, EF351, 352, EF801, EF802 and EF601 (produced by JEMCO Inc.); PF636, PF656, PF6320 and PF6520 (produced by OMNOVA); and FTX-204D, 208G, 218G, 230G, 204D, 208D, 212D, 218 and 222D (produced by NEOS Co., Ltd.). In addition, polysiloxane polymer KP-341 (produced by Shin-Etsu Chemical Co., Ltd.) may also be used as a silicon-containing surfactant.

Other than these known surfactants, a surfactant using a polymer having a fluoro-aliphatic group derived from a fluoro-aliphatic compound which is produced by a telomerization process (also called a telomer process) or an oligomerization process (also called an oligomer process), may be used. The fluoro-aliphatic compound can be synthesized by the method described in JP-A-2002-90991.

The polymer having a fluoro-aliphatic group is preferably a copolymer of a fluoro-aliphatic group-containing monomer with a (poly(oxyalkylene)) acrylate and/or a (poly(oxyalkylene)) methacrylate, and the polymer may have an

irregular distribution or may be a block copolymer. Examples of the poly(oxyalkylene) group include a poly(oxyethylene) group, a poly(oxypropylene) group and a poly(oxybutylene) group. This group may also be a unit having alkylenes differing in the chain length within the same chain, such as block-linked poly(oxyethylene, oxypropylene and oxyethylene) and block-linked poly(oxyethylene and oxypropylene). Furthermore, the copolymer of a fluoro-aliphatic group-containing monomer and a (poly(oxyalkylene)) acrylate (or methacrylate) is not limited only to a binary copolymer but may also be a ternary or greater copolymer obtained by simultaneously copolymerizing two or more different fluoro-aliphatic group-containing monomers or two or more different (poly(oxyalkylene)) acrylates (or methacrylates).

Examples thereof include, as the commercially available surfactant, Megafac F178, F-470, F-473, F-475, F-476 and F-472 (produced by Dainippon Ink & Chemicals, Inc.) and further include a copolymer of a $C_6F_{13}$ group-containing acrylate (or methacrylate) with a (poly(oxyalkylene)) acrylate (or methacrylate), and a copolymer of a $C_3F_7$ group-containing acrylate (or methacrylate) with a (poly(oxyethylene)) acrylate (or methacrylate) and a (poly(oxypropylene)) acrylate (or methacrylate).

In the present invention, a surfactant other than the fluorine-containing and/or silicon-containing surfactant may also be used. Specific examples thereof include a nonionic surfactant such as polyoxyethylene alkyl ethers (e.g., polyoxyethylene lauryl ether, polyoxyethylene stearyl ether, polyoxyethylene cetyl ether, polyoxyethylene oleyl ether), polyoxyethylene alkylallyl ethers (e.g., polyoxyethylene octylphenol ether, polyoxyethylene nonylphenol ether), polyoxyethylene•polyoxypropylene block copolymers, sorbitan fatty acid esters (e.g., sorbitan monolaurate, sorbitan monopalinitate, sorbitan monostearate, sorbitan monooleate, sorbitan trioleate, sorbitan tristearate), and polyoxyethylene sorbitan fatty acid esters (e.g., polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate).

One of these surfactants may be used alone, or several species thereof may be used in combination.

The amount of the surfactant used is preferably from 0.01 to 10 mass%, more preferably from 0.1 to 5 mass%, based on the entire amount of the positive resist composition (excluding the solvent).

<Onium Carboxylate>

The positive resist composition of the present invention may contain an onium carboxylate. Examples of the onium carboxylate include sulfonium carboxylate, iodonium carboxylate and ammonium carboxylate. In particular, the onium carboxylate is preferably an iodonium salt or a sulfonium salt. Furthermore, the carboxylate residue of the onium carboxylate for use in the present invention preferably contains no aromatic group and no carbon-carbon double bond, The anion moiety is preferably a linear, branched, monocyclic or polycyclic alkylcarboxylate anion having a carbon number of 1 to 30, more preferably a carboxylate anion where the alkyl group is partially or entirely substituted by fluorine. The alkyl chain may contain an oxygen atom. By using such an anion, the transparency to light at 220 nm or less is secured, the sensitivity and the resolving power are enhanced, and the defocus latitude depended on line pitch and the exposure margin are improved.

Examples of the fluorine-substituted carboxylate anion include fluoroacetate anion, difluoroacetate anion, trifluoroacetate anion, pentafluoropropionate anion, heptaflurobutyrate anion, nonafluoropentanoate anion, perfluorododecanoate anion, perfluorotridecanoate anion, perfluorocyclohexanecarboxylate anion and 2,2-bistrifluoromethylpropionate anion.

These onium carboxylates can be synthesized by reacting a sulfonium, iodonium or ammonium hydroxide and a carboxylic acid with silver oxide in an appropriate solvent.

The onium carboxylate content in the composition is generally from 0.1 to 20 mass%, preferably from 0.5 to 10 mass%, more preferably from 1 to 7 mass%, based on the entire solid content of the composition.

<Dissolution inhibiting compound having a molecular weight of 3,000 or less, which decomposes under the action of an acid to increase the solubility in an alkali developer>

In order to prevent reduction in the transmittance at 220 nm or less, the dissolution inhibiting compound having a molecular weight of 3,000 or less, which decomposes under the action of an acid to increase the solubility in an alkali developer (hereinafter, sometimes referred to as a "dissolution inhibiting compound"), is preferably an alicyclic or aliphatic compound containing an acid-decomposable group, such as acid-decomposable group-containing cholic acid derivative described in Proceeding of SPIE, 2724, 355 (1996). Examples of the acid-decomposable group and alicyclic structure include those described above for the alicyclic hydrocarbon-based acid-decomposable resin.

In the case where the positive resist composition of the present invention is exposed by a KrF excimer laser or irradiated with an electron beam, the composition preferably contains a structure where the phenolic hydroxyl group of a phenol compound is substituted by an acid-decomposable group. The phenol compound is preferably a phenol compound containing from 1 to 9 phenol skeletons, more preferably from 2 to 6 phenol skeletons.

The molecular weight of the dissolution inhibiting compound for use in the present invention is 3,000 or less,

preferably from 300 to 3,000, more preferably from 500 to 2,500.

The amount of the dissolution inhibiting compound added is preferably from 3 to 50 mass%, more preferably from 5 to 40 mass%, based on the solid content of the positive resist composition.

Specific examples of the dissolution inhibiting compound are set forth below, but the present invention is not limited thereto.

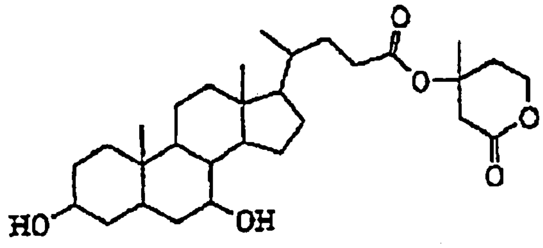

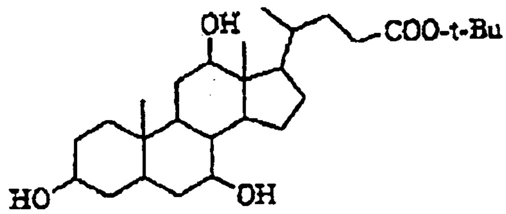

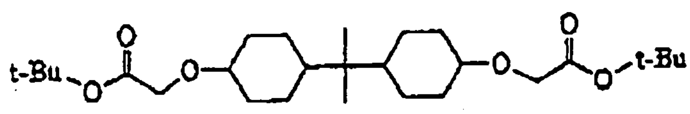

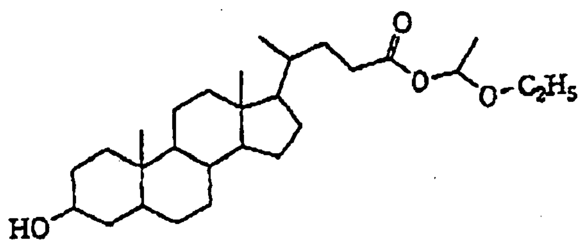

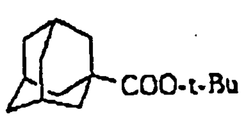

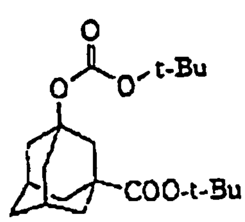

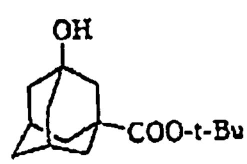

<Other Additives>

The positive resist composition of the present invention may further contain, if desired, a dye, a plasticizer, a photosensitizer, a light absorbent, a compound which accelerates dissolution in a developer (for example, a phenol

compound having a molecular weight of 1,000 or less, or a carboxyl group-containing alicyclic or aliphatic compound), and the like.

The phenol compound having a molecular weight of 1,000 or less can be easily synthesized by one skilled in the art while referring to the method described, for example, in JP-A-4-122938, JP-A-2-28531, U.S. Patent 4,916,210 and European Patent 219294.

Specific examples of the carboxyl group-containing alicyclic or aliphatic compound include, but are not limited to, a carboxylic acid derivative having a steroid structure, such as cholic acid, deoxycholic acid and lithocholic acid, an adamantanecarboxylic acid derivative, an adamantanedicarboxylic acid, a cyclohexanecarboxylic acid and a cyclohexanedicarboxylic acid.

<Pattern Forming Method>

The positive resist composition of the present invention is preferably used in a film thickness of 30 to 250 nm, more preferably from 30 to 200 nm, from the standpoint of enhancing the resolving power. Such a film thickness can be obtained by setting the solid content concentration in the positive resist composition to an appropriate range to give an appropriate viscosity and thereby enhance the coatability and film-forming property.

The entire solid content concentration in the positive resist composition is generally from 1 to 10 mass%, preferably from 1 to 8.0 mass%, more preferably from 1.0 to 6.0 mass%.

The positive resist composition of the present invention is used by dissolving the above-described components in a predetermined organic solvent, preferably a mixed solvent described above, filtering the solution, and coating it on a predetermined support as follows. The filter used for filtering is preferably a filter made of polytetrafluoroethylene, polyethylene or nylon and having a pore size of 0.1 microns or less, more preferably 0.05 μmicrons or less, still more preferably 0.03 microns or less.

For example, the positive resist composition is coated on such a substrate (e.g., silicon/silicon dioxide-coated substrate) as used in the production of a precision integrated circuit device, by an appropriate coating method such as spinner or coater, and dried to form a resist film.

Multiple exposure is performed by irradiating actinic rays or radiation on the formed resist film through a predetermined mask. The multiple exposure process as used in the present invention is a process of applying exposure a plurality of times on the same resist film, where the pattern in the exposure field is divided into a plurality of pattern groups and the exposure is preformed in parts a plurality of times for respective divided pattern groups. As disclosed in Digest of Papers, Micro Process' 94, pp. 4-5, this process is generally performed by a method of dividing the pattern in the exposure field into two groups and performing double exposure. As regards the specific method for dividing the pattern, for example, as shown in Fig. 2, two masks each having a pattern consisting of a 60-nm line and a 180-nm space are used and exposure is performed twice by displacing the position between those masks by 120 nm, whereby a 1:1 line-and-space pattern of 60 nm is formed. In general, as the pitch of the pattern (in the 1:1 line-and-space pattern of 60 nm, the pitch is 120 nm) becomes narrow. the optical resolution decreases. However, in the double exposure, the pattern in each of divided groups comes to have a pitch of 2 times the pitch in the original pattern and the resolution is enhanced.

The resist film after exposure is preferably baked (heated), then developed and rinsed, whereby a good pattern can be obtained.

Examples of the actinic rays or radiation include infrared light, visible light, ultraviolet light, far ultraviolet light, X-ray and electron beam, but the radiation is preferably far ultraviolet light at a wavelength of 250 nm or less, more preferably 220 nm or less, still more preferably from 1 to 200 nm. Specific examples thereof include KrF excimer laser light (248 nm), ArF excimer laser light (193 nm), $F_2$ excimer laser light (157 nm), X-ray and electron beam. ArF excimer laser light, $F_2$ excimer laser light, EUV (13 nm) and electron beam are preferred.

Before forming the resist film, an antireflection film may be previously provided by coating on the substrate.

The antireflection film used may be either an inorganic film type such as titanium, titanium dioxide, titanium nitride, chromium oxide, carbon and amorphous silicon, or an organic film type comprising a light absorbent and a polymer material. Also, the organic antireflection film may be a commercially available organic antireflection film such as DUV30 Series and DUV-40 Series produced by Brewer Science, Inc., and AR-2, AR-3 and AR-5 produced by Shipley Co., Ltd.

In the development step, an alkali developer is used as follows. The alkali developer which can be used for the positive resist composition is an alkaline aqueous solution of inorganic alkalis such as sodium hydroxide, potassium hydroxide, sodium carbonate, sodium silicate, sodium metasilicate and aqueous ammonia, primary amines such as ethylamine and n-propylamine, secondary amines such as diethylamine and di-n-butylamine, tertiary amines such as triethylamine and methyldiethylamine, alcohol amines such as dimetylethanolamine and triethanolamine, quaternary ammonium salts such as tetramethylammonium hydroxide and tetraethylammonium hydroxide, or cyclic amines such as pyrrole and piperidine.

In the alkali developer, alcohols and a surfactant may also be added each in an appropriate amount.
The alkali concentration of the alkali developer is usually from 0.1 to 20 mass%.
The pH of the alkali developer is usually from 10.0 to 15.0.
Also, in the above-described alkaline aqueous solution, alcohols and a surfactant may be added each in an appropriate amount.
Pure water is used as the rinsing solution, and a surfactant may be added thereto in an appropriate amount.
After the development or rinsing, the developer or rinsing solution adhering on the pattern may removed by a supercritical fluid.
The exposure may be performed by filling a liquid (immersion medium) having a refractive index higher than that of air between the resist film and a lens at the irradiation with actinic rays or radiation (immersion exposure). By this exposure, the resolution can be enhanced. The immersion medium used may be any liquid as long as it has a refractive index higher than that of air, but pure water is preferred.
The immersion liquid used in the immersion exposure is described below.
The immersion liquid is preferably a liquid transparent to light at the exposure wavelength and having as small a refractive index temperature coefficient as possible so as to minimize the distortion of an optical image projected on the resist film. Particularly, when the exposure light source is an ArF excimer laser (wavelength: 193 nm), water is preferably used in view of easy availability and easy handleability in addition to the above-described aspects.
Furthermore, a medium having a refractive index of 1.5 or more can also be used in that the refractive index can be more enhanced. This medium may be either an aqueous solution or an organic solvent.
In the case of using water as the immersion liquid, for the purpose of decreasing the surface tension of water and increasing the surface activity, an additive (liquid) which does not dissolve the resist film on a wafer and at the same time, gives only a negligible effect on the optical coat at the undersurface of the lens element, may be added in a small ratio. The additive is preferably an aliphatic alcohol having a refractive index nearly equal to that of water, and specific examples thereof include methyl alcohol, ethyl alcohol and isopropyl alcohol. By virtue of adding an alcohol having a refractive index nearly equal to that of water, even when the alcohol component in water is evaporated and the content concentration is changed, the change in the refractive index of the entire liquid can be advantageously made very small. On the other hand, if a substance opaque to light at 193 nm or an impurity greatly differing in the refractive index from water is mingled, this incurs distortion of the optical image projected on the resist film. Therefore, the water used is preferably distilled water. Pure water after further filtration through an ion exchange filter or the like may also be used
The electrical resistance of water is preferably 18.3 MΩcm or more, and TOC (total organic carbon) is preferably 20 ppb or less. Also, the water is preferably subjected to a deaeration treatment.
The lithography performance can be enhanced by increasing the refractive index of the immersion liquid. From such a standpoint, an additive which increases the refractive index may be added to water, or heavy water ($D_2O$) may be used in place of water.
In order to prevent the resist film from directly contacting with the immersion liquid, an immersion liquid sparingly soluble film (hereinafter, sometimes referred to as a "topcoat") may be provided between the immersion liquid and the resist film formed from the positive resist composition of the present invention. The functions required of the topcoat are suitability for coating on the resist upper layer part, transparency to radiation particularly at 193 nm, and low solubility in the immersion liquid. It is preferred that the topcoat does not intermix with the resist and can be uniformly coated on the resist upper layer.
In view of transparency to light at 193 nm, an aromatic-free polymer is preferred for the topcoat, and specific examples thereof include a hydrocarbon polymer, an acrylic acid ester polymer, a polymethacrylic acid, a polyacrylic acid, a polyvinyl ether, a silicon-containing polymer and a fluorine-containing polymer. The above-described hydrophobic resin (HR) is suitable also as the topcoat If impurities dissolve out into the immersion liquid from the topcoat, the optical lens is contaminated. In this viewpoint, the residual monomer components of the polymer are preferably less contained in the topcoat.
On peeling off the topcoat, a developer may be used or a releasing agent may be separately used. The releasing agent is preferably a solvent less permeating into the resist. From the standpoint that the peeling step can be performed simultaneously with the resist film development step, the topcoat is preferably peelable with an alkali developer. In the light of peeling with an alkali developer, the topcoat is preferably acidic, but in view of non-intermixing with the resist, the topcoat may be neutral or may be alkaline.
With no difference in the refractive index between the topcoat and the immersion liquid, the resolving power is enhanced. In the case of using water as the immersion liquid at the exposure with an ArF excimer laser (wavelength: 193 nm), the topcoat for ArF immersion exposure preferably has a refractive index close to the refractive index of the immersion liquid. From the standpoint of making the refractive index close to that of the immersion liquid, the topcoat preferably contains a fluorine atom. Also, in view of transparency and refractive index, the topcoat is preferably a thin film.
The topcoat is preferably free of intermixing with the resist film and further with the immersion liquid. From this standpoint, when the immersion liquid is water, the solvent used for the topcoat is preferably a medium which is sparingly

soluble in the solvent used for the positive resist composition and is insoluble in water. Furthermore, when the immersion liquid is an organic solvent, the topcoat may be either water-soluble or water-insoluble.

The pattern forming method and the positive resist composition of the present invention may be applied to a multilayer resist process (particularly, a three-layer resist process).

The multilayer resist process comprises the following steps:

(a) forming a lower resist layer comprising an organic material on a substrate to be processed,
(b) sequentially stacking on the lower resist layer an intermediate layer and an upper resist layer comprising an organic material capable of crosslinking or decomposing upon irradiation with radiation, and
(c) forming a predetermined pattern on the upper resist layer and then sequentially etching the intermediate layer, the lower layer and the substrate.

An organopolysiloxane (silicone resin) or $SiO_2$ coating solution (SOG) is generally used for the intermediate layer. As for the lower layer resist, an appropriate organic polymer film is used, but various known resists may be used. Examples thereof include various series such as FH Series and FHi Series produced by Fujifilm Arch Co., Ltd., and PFI Series produced by Sumitomo Chemical Co., Ltd.

The film thickness of the lower resist layer is preferably from 0.1 to 4.0 μm, more preferably from 0.2 to 2.0 μm, still more preferably from 0.25 to 1.5 μm. The film thickness is preferably 0.1 μm or more in view of antireflection or dry etching resistance and preferably 4.0 μm or less in view of aspect ratio or pattern collapse of the fine pattern formed.

[Examples]

The present invention is described in greater detail below by referring to Examples, but the present invention should not be construed as being limited thereto.

<Synthesis Example 1: Synthesis of Resin (1)>

Under a nitrogen stream, 12.7 g of cyclohexanone was charged into a three-neck flask and heated at 80˚C. Subsequently, a solution prepared by dissolving 8.9 g of norbornanecarbolactone methacrylate, 5.1 g of 3,5-dihydroxy-1-adamantyl methacrylate, 10.5 g of 2-(1-adamantyl)propan-2-yl and azobisisobutyronitrile in an amount corresponding to 6 mol% of the total mass of the monomer, in 114.4 g of cyclohexanone was added dropwise to the flask over 6 hours. After the completion of dropwise addition, the flask was heated at 80˚C for 2 hours. The reaction solution was left standing to cool to room temperature and then poured in 1,150-ml hexane/280-ml ethyl acetate, and the precipitated powder was collected by filtration and dried to obtain 19.6 g of Resin (1). The weight average molecular weight (Mw) of Resin (1) obtained was 8,500, the dispersity (Mw/Mn) was 1.85, and the molar compositional ratio of monomers was 41/19/40. The structure of Resin (1) is shown below.

Other resins were synthesized in the same manner. The weight average molecular weight was adjusted by changing the amount of the polymerization initiator.

Regarding Resins (1) to (9) of the present invention, the monomers used for the synthesis, the molar ratio of repeating units corresponding to the monomers, the weight average molecular weight (Mw) and the dispersity (Mw/Mn) are shown in Table 2 below.

Table 2

| No. | Monomer (1) | Monomer (2) | Monomer (3) | Monomer (4) | Compositional Ratio (by mol) | Mw | Mw/Mn |
|---|---|---|---|---|---|---|---|
| 1 | 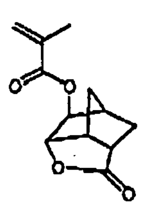 | 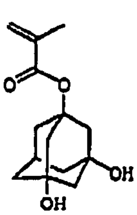 | 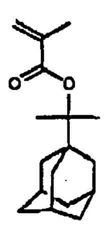 | | 41/19/40 | 8500 | 1.85 |

(continued)

| No. | Monomer (1) | Monomer (2) | Monomer (3) | Monomer (4) | Compositional Ratio (by mol) | Mw | Mw/Mn |
|---|---|---|---|---|---|---|---|
| 2 | 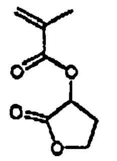 | 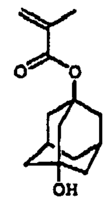 | 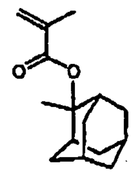 | | 40/15/45 | 12000 | 1.70 |
| 3 | 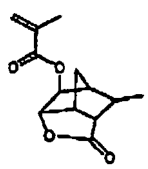 | 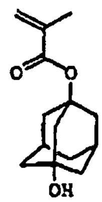 | 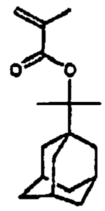 | | 50/20/30 | 6300 | 1.52 |
| 4 | 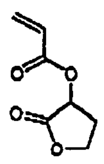 | 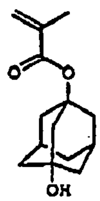 | 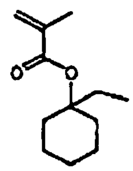 | 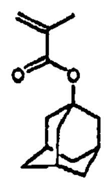 | 30/20/40/10 | 5500 | 1.35 |
| 5 | 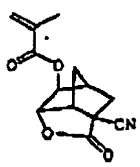 | 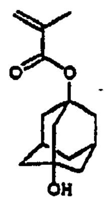 | 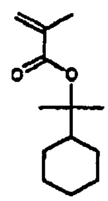 | | 40/25/35 | 4800 | 1.68 |
| 6 | 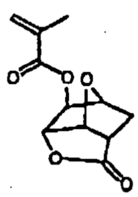 | 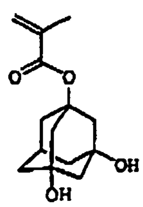 | 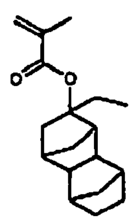 | 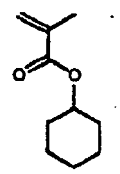 | 40/10/40/10 | 9500 | 1.58 |
| 7 | 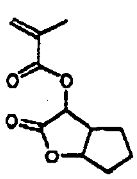 | 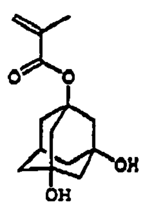 | 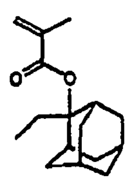 | 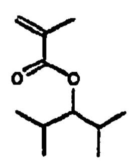 | 50/10/30/10 | 5200 | 1.42 |
| 8 | 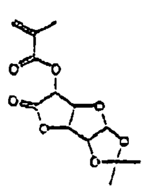 | 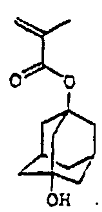 | 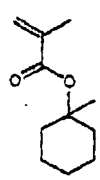 | | 30/30/40 | 7300 | 1.25 |

(continued)

| No. | Monomer (1) | Monomer (2) | Monomer (3) | Monomer (4) | Compositional Ratio (by mol) | Mw | Mw/Mn |
|---|---|---|---|---|---|---|---|
| 9 | 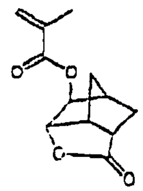 | 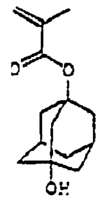 | 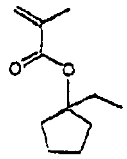 | 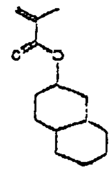 | 25/25/30/20 | 9000 | 1.65 |

<Synthesis Example 2: Synthesis of Resin (HR-22)>

Under a nitrogen stream, 5.0 g of cyclohexanone was charged into a three-neck flask and heated at 80˚C. Subsequently, a solution prepared by dissolving 5.0 g of bis(trifluoromethyl)methyl methacrylate and azobisisobutyronitrile in an amount corresponding to 10 mol% of the mass of the monomer, in 25.0 g of cyclohexanone was added dropwise to the flask over 2 hours. After the completion of dropwise addition, the flash was heated at 80˚C for 2 hours. The reaction solution was left standing to cool to room temperature and then poured in 300-ml methanol, and the precipitated powder was collected by filtration and dried to obtain 4.5 g of Resin (HR-22). The weight average molecular weight (Mw) of Resin (HR-22) obtained was 2,000, the dispersity (Mw/Mn) was 1.6.

Other resins were synthesized in the same manner. The weight average molecular weight was adjusted by changing the amount of the polymerization initiaton.

[Examples 1 to 9 and Comparative Examples 1 and 2]

<Preparation of Resist>

The components shown in Table 3 below were dissolved in a solvent to prepare a solution having a solid content concentration of 5 mass%, and the obtained solution was filtered through a polyethylene filler having a pore size of 0.1 μm to prepare a positive resist composition. Using the prepared positive resist composition, a resist patters was formed by the following method. As for each component in Table 3, when a plurality of species were used, the ratio is a ratio by mass.

Also, in Table 3, the surface contact angle is a value obtained by coating the prepared positive resist composition on a silicon wafer, baking it at 120˚C for 60 seconds to form a resist film having a film thickness of 120 nm, and measuring the contact angle of the resist film for water (measurement temperature: 23˚C) by a contact angle meter, DM500, manufactured by Kyowa Interface Science Co., Ltd.

Table 3

| Resist | Acid Generator | g | Resin (10 g) | Basic Compound | g | Surfactant (0.03 g) | Solvent | (mass ratio) | Hydrophobic Resin (HR) | g | Surface Contact Angle (°) |
|---|---|---|---|---|---|---|---|---|---|---|---|
| 1 | z38 | 0.6 | 1 | PEA | 0.03 | W-4 | A1/B1 | 80/20 | HR-22 | 0.1 | 85 |
| 2 | z78 | 0.55 | 2 | DIA | 0.03 | W-6 | A1/B1 | 60/40 | HR-37 | 0.4 | 88 |
| 3 | z60 | 0.7 | 3 | TOA | 0.03 | W-1 | A1/B2 | 70/30 | HR-5 | 0.2 | 80 |
| 4 | z64 | 0.8 | 4 | PBI | 0.04 | W-2 | A1/A2 | 60/40 | HR-15 | 0.2 | 77 |
| 5 | z70 | 0.7 | 5 | DIA | 0.02 | W-4 | A1/B1 | 70/30 | HR-53 | 0.2 | 89 |
| 6 | z72 | 0.6 | 6 | PEA | 0.02 | W-3 | A1/B1 | 50/50 | HR-37 | 0.4 | 82 |
| 7 | z69 | 0.55 | 7 | PBI | 0.03 | W-5 | A1/B1 | 70/30 | HR-65 | 0.2 | 85 |
| 8 | z66 | 0.6 | 8 | TOA | 0.01 | W-6 | A1/B1 | 60/40 | HR-83 | 0.3 | 84 |
| 9 | z68 | 0.7 | 9 | DIA | 0.02 | W-2 | A1 | 100 | HR-44 | 0.1 | 79 |
| 10 | z38 | 0.4 | 1 | PEA | 0.03 | W-1 | A1/B1 | 80/20 | HR-22 | 0.1 | 85 |
| 11 | z38 | 0.4 | 1 | PEA | 0.03 | W-1 | A1/B1 | 80/20 | - | - | 65 |

(Exposure Condition (I): dry double exposure)

An organic antireflection film, ARC29A (produced by Nissan Chemical Industries, Ltd.), was coated on a silicon wafer and baked at 205˚C for 60 seconds to form an antireflection film having a film thickness of 78 nm, and the prepared positive resist solution was coated thereon and baked at 120˚C for 60 seconds to form a resist film having a film thickness of 120 nm. The obtained wafer was subjected to first exposure through a 6% halftone mask having a 100-nm space and 400-nm line pattern by using an ArF excimer laser scanner (PAS5500/1100, manufactured by ASML, NA: 0.75) and further to second exposure through a mask having the same pattern as that of the first mask while dislocating the position of the mask by 200 nm so that a space could be located between a space and a space of the first exposure. Thereafter, the resist film was heated at 120˚C for 60 seconds, developed with an aqueous tetramethylammonium hydroxide solution (2.38 mass%) for 30 seconds, rinsed with pure water and spin-dried to obtain a 1:1 line-and-space pattern of 100 nm.

(Exposure Condition (2): immersion double exposure)

An organic antireflection film, ARC29A (produced by Nissan Chemical Industries, Ltd.), was coated on a silicon wafer and baked at 205˚C for 60 seconds to form an antireflection film having a film thickness of 78 nm, and the prepared positive resist solution was coated thereon and baked at 120˚C for 60 seconds to form a resist film having a film thickness of 120 nm. The obtained wafer was subjected to first exposure through a 6% halftone mask having a 80-nm space and 240-nm line pattern by using an ArF excimer laser immersion scanner (PAS5500/1250i, manufactured by ASML, NA: 0.85) and further to second exposure through a mask having the same pattern as that of the first mask while dislocating the position of the mask by 160 nm so that a space could be located between a space and a space of the first exposure. The immersion liquid used was ultrapure water, Thereafter, the resist film was heated at 120˚C for 60 seconds, developed with an aqueous tetramethylammonium hydroxide solution (2.38 mass%) for 30 seconds, rinsed with pure water and spin-dried to obtain a 1:1 line-and-space pattern of 80 nm.

The cross-sectional shape and pattern profile of the resist pattern prepared under (Exposure Condition (1)) or (Exposure Condition (2)) were observed through a scanning electron microscope (S-4800, manufactured by Hitachi, Ltd.), and the film thickness of the pattern was measured. The results are shown in Table 4.

Table 4

| | Resist | Exposure Condition (1) | Exposure Condition (2) |
|---|---|---|---|
| Example 1 | 1 | 110 nm | 109 nm |
| Example 2 | 2 | 105 nm | 106 nm |
| Example 3 | 3 | 108 nm | 109 nm |
| Example 4 | 4 | 104 nm | 102 nm |
| Example 5 | 5 | 105 nm | 102 nm |
| Example 6 | 6 | 108 nm | 105 nm |
| Example 7 | 7 | 107 nm | 101 nm |
| Examples 8 | 8 | 103 nm | 105 nm |
| Example 9 | 9 | 105 nm | 102 nm |
| Comparative Example 1 | 10 | 88 mn | 85 nm |
| Comparative Example 2 | 11 | 68 nm | 72 nm |

[Basic Compound]

DIA: 2,6-Diisopropylaniline
PEA: N-Phenyldiethanolamine
TOA: Trioctylamine
PBI: 2-Phenylbenzimidazole

[Surfactant]

W-1: Megafac F176 (produced by Dainippon Ink & Chemicals, Inc.) (fluorine-containing)
W-2: Megafac R08 (produced by Dainipnon Ink & Chemicals, Inc.) (fluorine- and silicon-containing)
W-3: polysiloxane polymer KP-341 (produced by Shin-Etsu Chemical Co., Ltd.) (silicon-containing)
W-4: Troysol S-3 66 (produced by Troy Chemical)
W-5: PF656 (produce by OMNOVA, fluorine-containing)
W-6: PF6320 (produced by OMNOVA, fluorine-containing)

[Solvent]

A1: Propylene glycol monomethyl ether acetate
A2: Cyclohexanone
B1: Propylene glycol monomethyl ether
B2: Ethyl lactate

As seen from the results in Table 4, the positive resist composition of the present invention subjected to double exposure is reduced in the film loss of the pattern not only in normal exposure (dry exposure) but also in immersion exposure.

According to the present invention, a pattern forming method using a positive resist composition suitable for multiple exposure, ensuring that in a multiple exposure process of performing exposure a plurality of times on the same resist film, the pattern is reduced in the film loss, can be provided.

## Claims

1. A method for forming a resist pattern comprising exposing a positive resist film to actinic rays or radiation a plurality of times;
wherein the contact angle formed by a water droplet on the surface of the resist film prior to exposure is at least 75° when measured at 23°C; and
wherein the resist film comprises:

   (i) a surface layer comprising a hydrophobic resin (HR), the hydrophobic resin comprising at least one of a fluorine atom and a silicon atom, and
   (ii) at least 5 mass%, based on the total solid content of the resist film, of a compound (A) which is capable of generating an acid upon irradiation with actinic rays or radiation.

2. A method according to Claim 1, wherein the resist film further comprises a resin (B) whose solubility in an alkali developer increases under the action of an acid, the resin having a repeating unit represented by the following formula (pA):

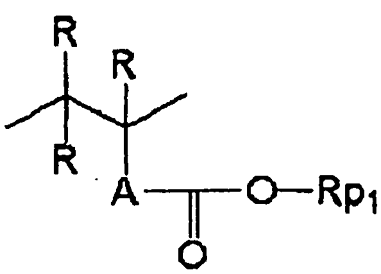

(pA)

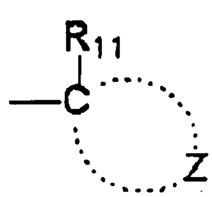

(pI)

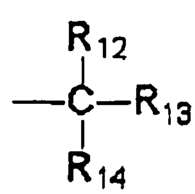

(pII)

wherein each R independently represents a hydrogen atom, a halogen atom or an alkyl group; A represents a single

bond; $Rp_1$ is a group represented by formula (pI) or formula (pII) ; $R_{11}$ represents a methyl group, an ethyl group, an n-propyl group, an isopropyl group, an n-butyl group, an isobutyl group or a sec-butyl group; Z represents an atomic group necessary for forming a cycloalkyl group together with the carbon atom; and $R_{12}$ to $R_{14}$ each independently represents an alkyl group or a cycloalkyl group, provided that at least one of $R_{12}$ to $R_{14}$ represents a cycloalkyl group.

**3.** A method according to Claim 1, wherein the resist film comprises a sulfonium salt of at least one of a fluorine-substituted alkanesulfonic acid, a fluorine-substituted benzenesulfonic acid, a fluorine-substituted imide acid and a fluorine-substituted methide acid as compound (A).

**4.** A method according to Claim 2, wherein the resin (B) further contains a repeating unit having a lactone structure.

**5.** A method according to Claim 2, wherein the resin (B) further contains a repeating unit having a hydroxyl group or a cyano group.

**6.** A method according to Claim 2, wherein the resin (B) further contains a repeating unit having a lactone structure and a repeating unit having a hydroxyl group.

**7.** A method according to Claim 1, wherein the resist film further comprises a basic compound and at least one of a fluorine-containing surfactant and a silicon-containing surfactant.

**8.** A method according to Claim 7, wherein the basic compound is at least one of a compound having an imidazole structure, a diazabicyclo structure, an onium hydroxide structure, an onium carboxylate structure, a trialkylamine structure, an aniline structure or a pyridine structure; an alkylamine derivative having at least one of a hydroxyl group and an ether bond; and an aniline derivative having at least one of a hydroxyl group and an ether bond.

**9.** A method according to Claim 1, wherein the hydrophobic resin (HR) has a fluorine atom-containing alkyl group, a fluorine atom-containing cycloalkyl group or a fluorine atom-containing aryl group.

**10.** A method according to Claim 9, wherein the fluorine atom-containing alkyl group, the fluorine atom-containing cycloalkyl group or the fluorine atom-containing aryl group is a group represented by any one of formulae (f1) to (f3):

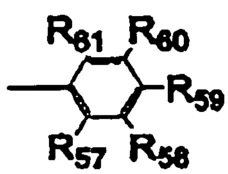

(f1)

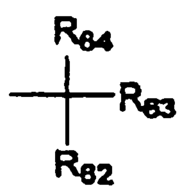

(f2)

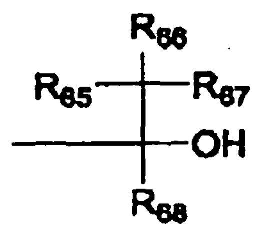

(f3)

wherein $R_{57}$ to $R_{68}$ each independently represents a hydrogen atom, a fluorine atom or an alkyl group, provided that at least one of $R_{57}$ to $R_{61}$, at least one of $R_{62}$ to $R_{64}$ and at least one of $R_{65}$ to $R_{68}$ is a fluorine atom or an alkyl group having at least one hydrogen atom being substituted by a fluorine atom.

**11.** A method according to Claim 1, wherein the hydrophobic resin (HR) has an alkylsilyl structure or a cyclic siloxane structure.

**12.** A method according to Claim 11, wherein the alkylsilyl structure or the cyclic siloxane structure is a group represented by any one of formulae (CS-1) to (CS-3):

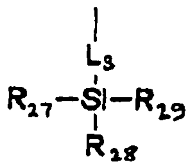

(CS-1)

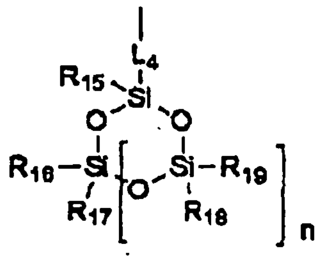

(CS-2)

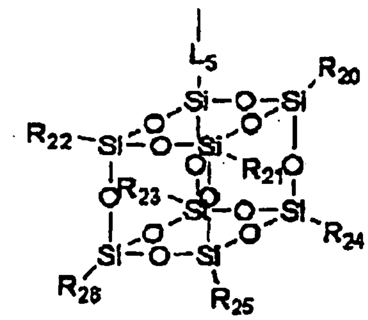

(CS-3)

wherein $R_{15}$ to $R_{29}$ each independently represents a linear or branched alkyl group or a cycloalkyl group; $L_3$ to $L_5$ each independently represents a single bond or a divalent linking group; and n represents an integer of 1 to 5.

**13.** A method according to Claim 1, wherein the resist film is subjected to immersion exposure.

**14.** A method according to Claim 1, wherein the resist film is subjected to double exposure.

**Patentansprüche**

**1.** Verfahren zum Bilden eines Fotolackmusters, umfassend das mehrmalige Belichten eines positiven Fotolackfilms mit aktinischer Strahlung oder Strahlung;
worin der Kontaktwinkel, der von einem Wassertropfen auf der Oberfläche des Fotolackfilms vor der Belichtung gebildet wird, mindestens 75° beträgt, wenn bei 23°C gemessen wird; und
worin der Fotolackfilm umfasst:

(i) eine Oberflächenschicht, die ein hydrophobes Harz (HR) umfasst, wobei das hydrophobe Harz mindestens eines von einem Fluoratom und einem Siliziumatom umfasst, und
(ii) mindestens 5 Masse%, bezogen auf den Gesamtfeststoffgehalt des Fotolackfilms, einer Verbindung (A), die in der Lage ist, bei Bestrahlung mit aktinischen Strahlen oder Strahlung eine Säure zu bilden.

**2.** Verfahren gemäß Anspruch 1, worin der Fotolackfilm ferner ein Harz (B) umfasst, dessen Löslichkeit in einem Alkali-Entwickler sich unter der Wirkung einer Säure erhöht, wobei das Harz eine durch die folgende Formel (pA) dargestellte Wiederholungseinheit aufweist:

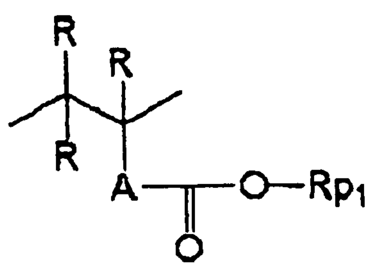

(pA)

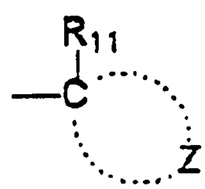

(pI)

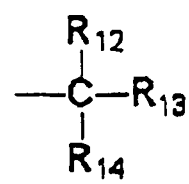

(pII)

worin jedes R unabhängig ein Wasserstoffatom, ein Halogenatom oder eine Alkylgruppe darstellt; A eine Einfachbindung darstellt; $Rp_1$ eine Gruppe ist, die durch die Formel (pI) oder Formel (pII) dargestellt wird; $R_{11}$ eine Methylgruppe, eine Ethylgruppe, eine n-Propylgruppe, eine Isopropylgruppe, eine n-Butylgruppe, eine Isobutylgruppe oder eine sec-Butylgruppe darstellt; Z eine Atomgruppe darstellt, die zum Bilden einer Cycloalkylgruppe zusammen mit dem Kohlenstoffatom notwendig ist; und $R_{12}$ bis $R_{14}$ jeweils unabhängig voneinander einer Alkylgruppe oder eine Cycloalkylgruppe darstellen, vorausgesetzt, dass mindestens eines von $R_{12}$ bis $R_{14}$ eine Cycloalkylgruppe darstellt.

3. Verfahren gemäß Anspruch 1, worin der Fotolackfilm ein Sulfoniumsalz von mindestens einer von einer Fluor-substituierten Alkansulfonsäure, einer Fluor-substituierten Benzolsulfonsäure, einer Fluor-substituierten Imidsäure und einer Fluor-substituierten Methidsäure als Verbindung (A) umfasst.

4. Verfahren gemäß Anspruch 2, worin das Harz (B) ferner eine Wiederholungseinheit enthält, die eine Lactonstruktur aufweist.

5. Verfahren gemäß Anspruch 2, worin das Harz (B) ferner eine Wiederholungseinheit enthält, die eine Hydroxylgruppe oder eine Cyanogruppe aufweist.

6. Verfahren gemäß Anspruch 2, worin das Harz (B) ferner eine Wiederholungseinheit, die eine Lactonstruktur aufweist, und eine Wiederholungseinheit, die eine Hydroxylgruppe aufweist, enthält.

7. Verfahren gemäß Anspruch 1, worin der Fotolackfilm ferner eine basische Verbindung und mindestens eines von einem fluorhaltigen Tensid und einem siliziumhaltigen Tensid umfasst.

8. Verfahren gemäß Anspruch 7, worin die basische Verbindung mindestens eine von einer Verbindung, die eine Imidazolstruktur, eine Diazabicyclostruktur, eine Onium-Hydroxidstruktur, eine Onium-Carboxylatstruktur, eine Trialkylaminstruktur, eine Anilinstruktur oder eine Pyridinstruktur aufweist; einem Alkylaminderivat, das mindestens eines von einer Hydroxylgruppe und einer Etherbindung aufweist; und einem Anilinderivat, das mindestens eines von einer Hydroxylgruppe und einer Etherbindung aufweist, ist.

9. Verfahren gemäß Anspruch 1, worin das hydrophobe Harz (HR) eine Fluoratom-haltige Alkylgruppe, eine Fluoratom-haltige Cycloalkylgruppe oder eine Fluoratom-haltige Arylgruppe aufweist.

10. Verfahren gemäß Anspruch 9, worin die Fluoratom-haltige Alkylgruppe, die Fluoratom-haltige Cycloalkylgruppe oder die Fluoratom-haltige Arylgruppe eine durch irgendeine der Formeln (f1) bis (f3) dargestellte Gruppe ist:

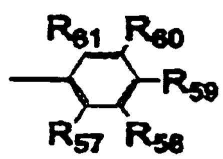
(f1)

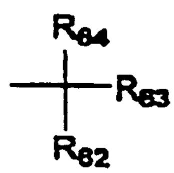
(f2)

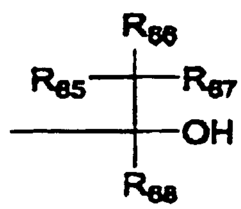
(f3)

worin $R_{57}$ bis $R_{68}$ jeweils unabhängig voneinander ein Wasserstoffatom, ein Fluoratom oder eine Alkylgruppe darstellen, vorausgesetzt, das mindestens eines von $R_{57}$ bis $R_{61}$, mindestens eines von $R_{62}$ bis $R_{64}$ und mindestens eines von $R_{65}$ bis $R_{68}$ ein Fluoratom oder eine Alkylgruppe ist, die mindestens ein Wasserstoffatom, das durch ein Fluoratom substituiert ist, aufweist.

11. Verfahren gemäß Anspruch 1, worin das hydrophobe Harz (HR) eine Alkylsilylstruktur oder eine cyclische Siloxanstruktur aufweist.

12. Verfahren gemäß Anspruch 11, worin die Alkylsilylstruktur oder die cyclische Siloxanstruktur eine durch irgendeine der Formeln (CS-1) bis (CS-3) dargestellte Gruppe ist:

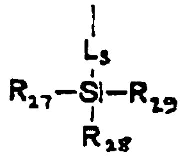

(CS-1)

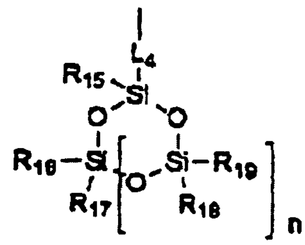

(CS-2)

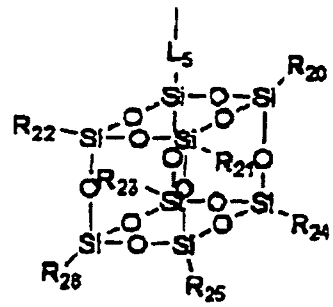

(CS-3)

worin $R_{15}$ bis $R_{29}$ jeweils unabhängig voneinander eine lineare oder verzweigte Alkylgruppe oder eine Cycloalkylgruppe darstellen; $L_3$ bis $L_5$ jeweils unabhängig voneinander eine Einfachbindung oder eine divalente Verknüpfungsgruppe darstellen; und n eine ganze Zahl von 1 bis 5 darstellt.

**13.** Verfahren gemäß Anspruch 1, worin der Fotolackfilm einer Immersionsbelichtung unterzogen ist.

**14.** Verfahren gemäß Anspruch 1, worin der Fotolackfilm einer Doppelbelichtung unterzogen ist.

## Revendications

**1.** Procédé de formation d'un motif de réserve comprenant l'exposition d'un film de réserve positive à des rayons actiniques ou un rayonnement plusieurs fois ;
dans lequel l'angle de contact formé par une gouttelette d'eau sur la surface du film de réserve avant l'exposition est d'au moins 75° lorsqu'il est mesuré à 23°C ; et
dans lequel le film de réserve comprend :

(i) une couche de surface comprenant une résine hydrophobe (HR), la résine hydrophobe comprenant au moins un d'un atome de fluor et d'un atome de silicium, et
(ii) au moins 5 % en masse, rapportés à la teneur totale en matière solide du film de réserve, d'un composé (A) qui est capable de générer un acide par irradiation avec des rayons actiniques ou un rayonnement.

**2.** Procédé selon la revendication 1, dans lequel le film de réserve comprend de plus une résine (B) dont la solubilité dans un développeur alcalin augmente sous l'action d'un acide, la résine ayant une unité répétitive représentée par la formule (pA) suivante :

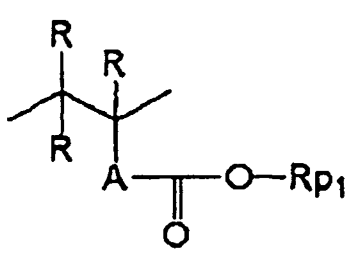

(pA)

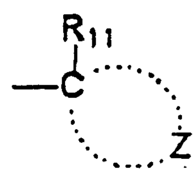

(pI)

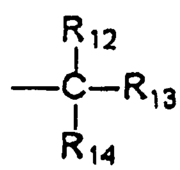

(pII)

où chaque R représente indépendamment un atome d'hydrogène, un atome d'halogène ou un groupe alkyle ; A représente une liaison simple ; $Rp_1$ est un groupe représenté par la formule (pI) ou la formule (pII) ; $R_{11}$ représente un groupe méthyle, un groupe éthyle, un groupe n-propyle, un groupe isopropyle, un groupe n-butyle, un groupe isobutyle ou un groupe sec-butyle ; Z représente un groupe atomique nécessaire pour former un groupe cycloalkyle avec l'atome de carbone ; et $R_{12}$ à $R_{14}$ représentent chacun indépendamment un groupe alkyle ou un groupe cycloalkyle, à condition qu'au moins un de $R_{12}$ à $R_{14}$ représente un groupe cycloalkyle.

**3.** Procédé selon la revendication 1, dans lequel le film de réserve comprend un sel de sulfonium d'au moins un d'un acide alcane-sulfonique fluor-substitué, d'un acide benzènesulfonique fluor-substitué, d'un imide d'acide fluor-substitué et d'un acide de méthide fluor-substitué comme composé (A).

**4.** Procédé selon la revendication 2, dans lequel la résine (B) contient de plus une unité répétitive ayant une structure lactone.

**5.** Procédé selon la revendication 2, dans lequel la résine (B) contient de plus une unité répétitive ayant un groupe hydroxyle ou un groupe cyano.

**6.** Procédé selon la revendication 2, dans lequel la résine (B) contient de plus une unité répétitive ayant une structure lactone et une unité répétitive ayant un groupe hydroxyle.

**7.** Procédé selon la revendication 1, dans lequel le film de réserve comprend de plus un composé basique et au moins un d'un tensioactif contenant du fluor et d'un tensioactif contenant du silicium.

**8.** Procédé selon la revendication 7, dans lequel le composé basique est au moins un d'un composé ayant une structure imidazole, une structure diazabicyclo, une structure hydroxyde d'onium, une structure carboxylate d'onium, une structure trialkylamine, une structure aniline ou une structure pyridine ; d'un dérivé d'alkylamine ayant au moins un d'un groupe hydroxyle et d'une liaison éther ; et d'un dérivé d'aniline ayant au moins un d'un groupe hydroxyle et d'une liaison éther.

**9.** Procédé selon la revendication 1, dans lequel la résine hydrophobe (HR) présente un groupe alkyle contenant un atome de fluor, un groupe cycloalkyle contenant un atome de fluor ou un groupe aryle contenant un atome de fluor.

**10.** Procédé selon la revendication 9, dans lequel le groupe alkyle contenant un atome de fluor, le groupe cycloalkyle contenant un atome de fluor ou le groupe aryle contenant un atome de fluor est un groupe représenté par l'une des formules (f1) à (f3) :

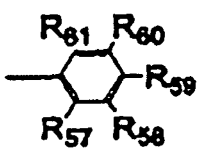
(f1)

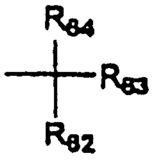
(f2)

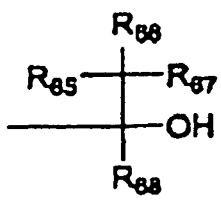
(f3)

où $R_{57}$ à $R_{68}$ représentent chacun indépendamment un atome d'hydrogène, un atome de fluor ou un groupe alkyle, à condition qu'au moins un de $R_{57}$ à $R_{61}$, au moins un de $R_{62}$ à $R_{64}$ et au moins un de $R_{65}$ à $R_{68}$ est un atome de fluor ou un groupe alkyle ayant au moins un atome d'hydrogène substitué par un atome de fluor.

**11.** Procédé selon la revendication 1, dans lequel la résine hydrophobe (HR) présente une structure alkylsilyle ou une structure siloxane cyclique.

**12.** Procédé selon la revendication 11, dans lequel la structure alkylsilyle ou la structure de siloxane cyclique est un groupe représenté par l'une des formules (CS-1) à (CS-3) :

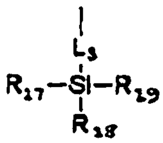

(CS-1)

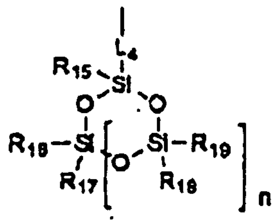

(CS-2)

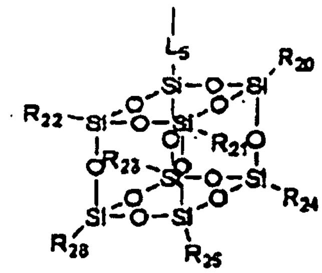

(CS-3)

où $R_{15}$ à $R_{29}$ représentent chacun indépendamment un groupe alkyle linéaire ou ramifié ou un groupe cycloalkyle ; $L_3$ à $L_5$ représentent chacun indépendamment une liaison simple ou un groupe de liaison divalent ; et n représente un nombre entier de 1 à 5.

**13.** Procédé selon la revendication 1, dans lequel le film de réserve est soumis à une exposition par immersion.

**14.** Procédé selon la revendication 1, dans lequel le film de réserve est soumis à une double exposition.

FIG. 1

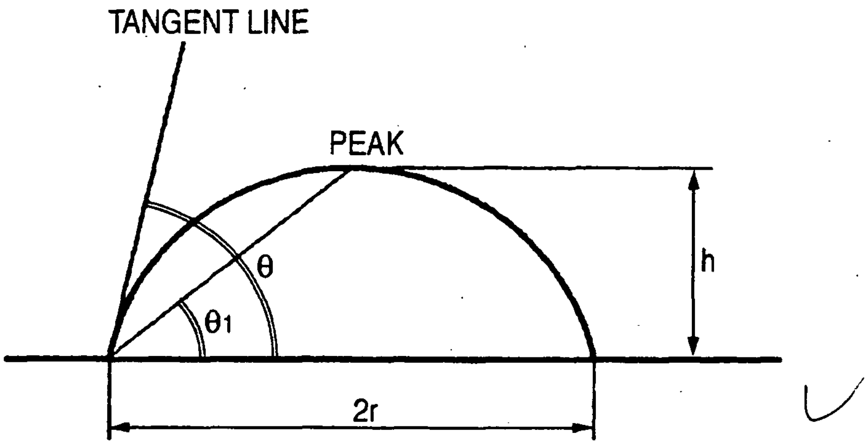
TANGENT LINE
PEAK
θ
θ1
h
2r

FIG. 2

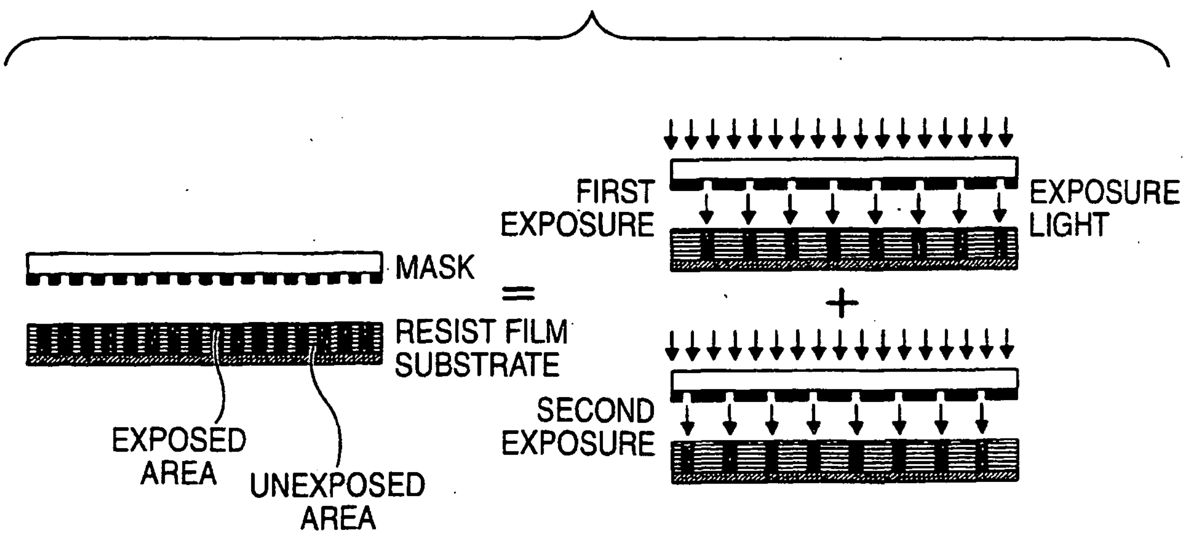
MASK
RESIST FILM
SUBSTRATE
EXPOSED AREA
UNEXPOSED AREA
=
FIRST EXPOSURE
EXPOSURE LIGHT
+
SECOND EXPOSURE

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002075857 A
- WO 2008093856 A
- US 4402571 A
- US 3849137 A
- DE 3914407
- JP 63026653 A
- JP 55164824 A
- JP 62069263 A
- JP 63146038 A
- JP 62153853 A
- JP 63146029 A
- US 3779778 A
- EP 126712 A
- JP 62036663 A
- JP 61226746 A
- JP 61226745 A
- JP 62170950 A
- JP 63034540 A
- JP 7230165 A
- JP 8062834 A
- JP 9054432 A
- JP 9005988 A
- JP 2002 A
- JP 277862 A
- US 5405720 A
- US 5360692 A
- US 5529881 A
- US 5296330 A
- US 5436098 A
- US 5576143 A
- US 5294511 A
- US 5824451 A
- JP 2002090991 A
- JP 4122938 A
- JP 2028531 A
- US 4916210 A
- EP 219294 A


### Non-patent literature cited in the description


- *Digest of Papers, Micro Process,* vol. 94, 4-5
- *Proceeding of SPIE,* 1996, vol. 2724, 355